# EUROPEAN PATENT APPLICATION

(11) **EP 4 529 393 A1**
(43) Date of publication of application: **26.03.2025**
(21) Application number: 24201315.9
(22) Date of filing: 19.09.2024
(51) Int. Cl.: H10K 50/11, H10K 85/30, H10K 101/00, H10K 101/10

(54) **LIGHT-EMITTING DEVICE INCLUDING ORGANOMETALLIC COMPOUND, ELECTRONIC APPARATUS INCLUDING THE LIGHT-EMITTING DEVICE, AND THE ORGANOMETALLIC COMPOUND**

(30) Priority: 19.09.2023 KR 20230124995
(71) Applicant: Samsung Display Co., Ltd., Gyeonggi-do 17113 (KR)
(72) Inventor: Han, Junghoon, 17113 Yongin-si, Gyeonggi-do (KR); Ko, Soobyung, 17113 Yongin-si, Gyeonggi-do (KR); Kim, Sungbum, 17113 Yongin-si, Gyeonggi-do (KR); LEE, Youngki, 17113 Yongin-si, Gyeonggi-do (KR); Lee, Jihyung, 17113 Yongin-si, Gyeonggi-do (KR); Ju, Jinhee, 17113 Yongin-si, Gyeonggi-do (KR)
(74) Representative: Gulde & Partner

(57) **Abstract**

A light-emitting device includes a first electrode, a second electrode facing the first electrode, and an interlayer between the first electrode and the second electrode and including an organometallic compound represented by Formula 1. In addition, there are provided an electronic apparatus including the light-emitting device, and the organometallic compound represented by Formula 1.

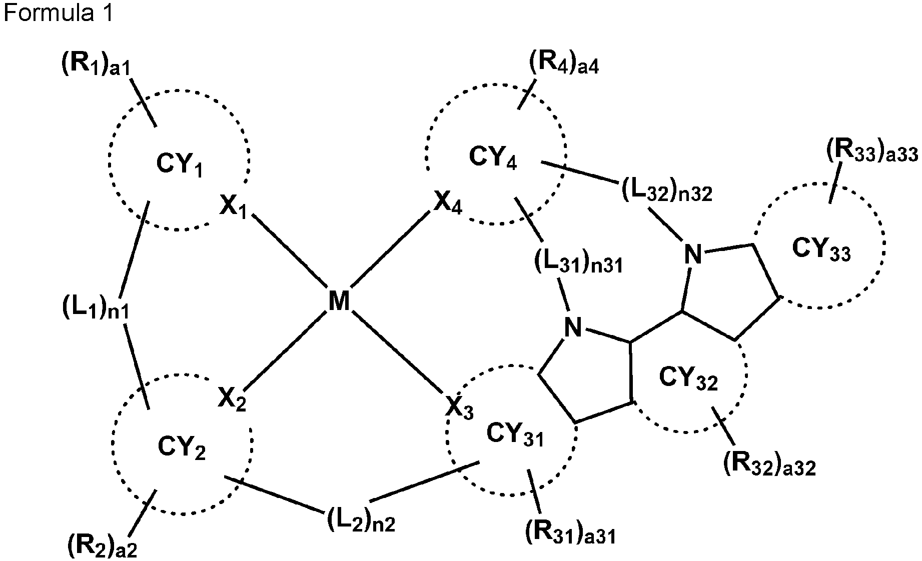

## Description

### BACKGROUND

### 1. Field

One or more embodiments of the present disclosure relate to a light-emitting device including an organometallic compound, an electronic apparatus including the light-emitting device, and the organometallic compound.

### 2. Description of the Related Art

Among light-emitting devices, self-emissive devices (e.g., organic light-emitting devices) have relatively wide viewing angles, relatively high contrast ratios, relatively short response times, and excellent or suitable characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as the holes and the electrons, recombine in the emission layer to produce excitons. These excitons transition and decay from an excited state to a ground state, thereby generating light.

### SUMMARY

The invention is defined by the appended claims. The description that follows is subjected to this limitation. Any disclosure lying outside the scope of said claims is only intended for illustrative as well as comparative purposes. One or more aspects of embodiments of the present disclosure are directed toward a light-emitting device including an organometallic compound, an electronic apparatus including the light-emitting device, and the organometallic compound.

Additional aspects will be set forth in part in the description which follows and, in part, will be apparent from the description, or may be learned by practice of the presented embodiments of the disclosure.

According to one embodiment of the present invention, a light-emitting device includes:
a first electrode;
a second electrode facing the first electrode; and
an interlayer between the first electrode and the second electrode and including an emission layer; and
an organometallic compound is represented by Formula 1: 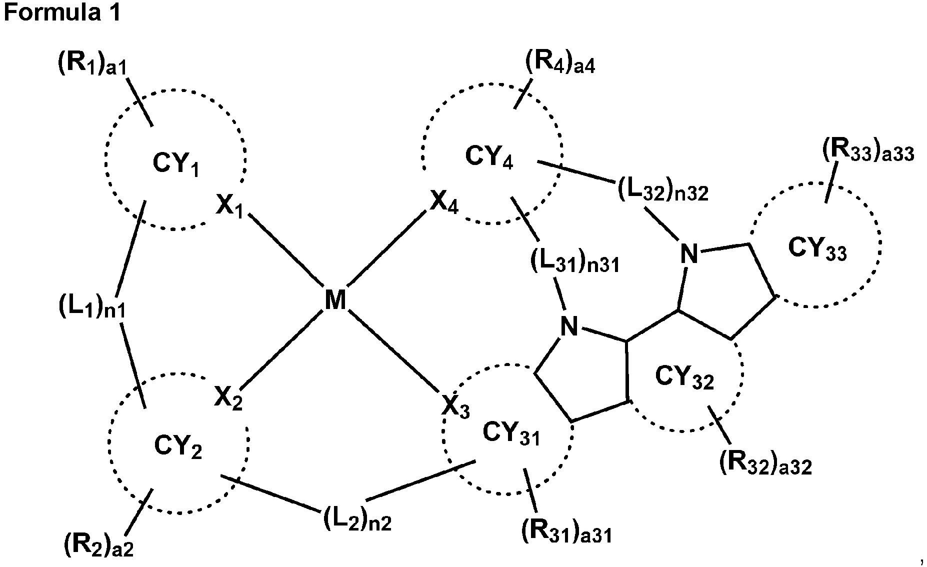 wherein, in Formula 1,
   M may be platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
   X₁ to X₄ may each independently be C or N,
   ring CY₁, ring CY₂, ring CY₃₁ to ring CY₃₃, and ring CY₄ may each independently be a C₅-C₃₀ carbocyclic group or a C₁-C₃₀ heterocyclic group,
   L₁, L₂, L₃₁, and L₃₂ may each independently be a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', *-Ge(R₁ₐ)(R_{1b})-*', a C₅-C₃₀ carbocyclic group unsubstituted or substituted with at least one R₁₀ₐ, or a C₁-C₃₀ heterocyclic group unsubstituted or substituted with at least one R₁₀ₐ, and * and *' each indicate a binding site to a neighboring atom,
   n1, n2, n31, and n32 may each independently be an integer from 1 to 10,
   R₁, R₂, R₃₁ to R₃₃, R₄, R₁ₐ, and R_{1b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
   a1, a2, a31 to a33, and a4 may each independently be an integer from 1 to 20,
   two or more adjacent groups selected from among a1 R₁(s), a2 R₂(s), a31 R₃₁(s), a32 R₃₂(s), a33 R₃₃(s), a4 R₄(s), R₁ₐ, and R_{1b} may optionally be combined with each other to form a C₃-C₆₀ carbocyclic group unsubstituted or substituted with at least one R₁₀ₐ or a C₁-C₆₀ heterocyclic group unsubstituted or substituted with at least one R10a,
   R₁₀ₐ may be:
   hydrogen, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
   a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, - Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
   wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

According to another embodiment of the present invention, an electronic apparatus includes the light-emitting device.

According to a further embodiment of the present invention, electronic equipment includes the light-emitting device.

According to a further embodiment of the present disclosure, there is provided the organometallic compound represented by Formula 1 as defined in claim 6.

### BRIEF DESCRIPTION OF DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic view of a structure of a light-emitting device according to one or more embodiments of the present disclosure;
FIG. 2 is a schematic view of a structure of a light emitting apparatus according to one or more embodiments of the present disclosure;
FIG. 3 is a schematic view of a structure of a light emitting apparatus according to one or more embodiments of the present disclosure; and
FIGs. 4, 5, 6A, 6B, and 6C are each a schematic view of a structure of electronic equipment according to one or more embodiments of the present disclosure.

### DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly, the embodiments of the present disclosure are merely described, by referring to the drawings, to explain aspects of the present description. As utilized herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

According to one or more embodiments of the present disclosure, a light-emitting device includes:
a first electrode;
a second electrode facing the first electrode;
an interlayer between the first electrode and the second electrode and including an emission layer; and
an organometallic compound is represented by Formula 1:

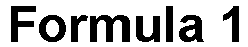

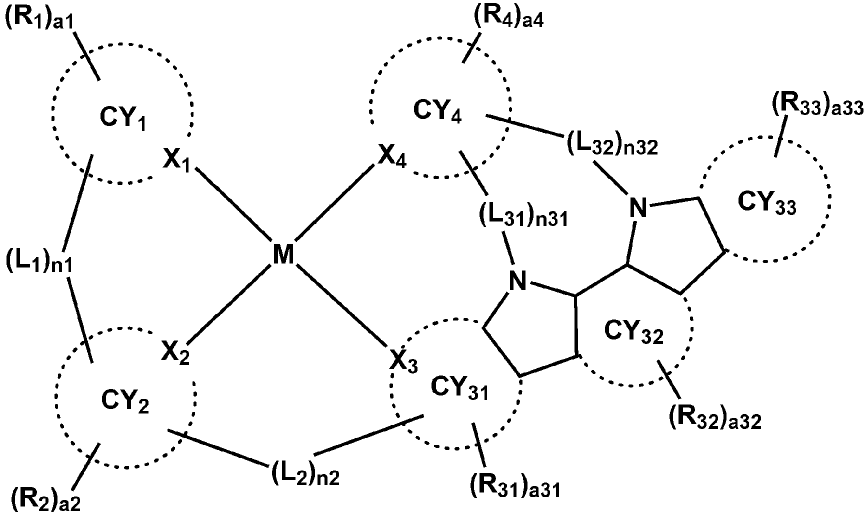

Details on Formula 1 are the same as described herein.

In one or more embodiments,
the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron-blocking layer, or any combination thereof, and
the electron transport region may include a hole-blocking layer, an electron transport layer, an electron injection layer, or any combination thereof.

In one or more embodiments, the interlayer of the light-emitting device may include the organometallic compound represented by Formula 1.

In one or more embodiments, the emission layer of the light-emitting device may include the organometallic compound represented by Formula 1 (e.g., as a first compound).

In one or more embodiments, the emission layer of the light-emitting device may include a dopant and a host, and the organometallic compound represented by Formula 1 may be included in the dopant. For example, in some embodiments, the organometallic compound may act as a dopant. For example, in some embodiments, the emission layer may be to emit blue light. The blue light may have a maximum emission wavelength in a range of, for example, about 430 nm to about 480 nm.

In one or more embodiments, the electron transport region of the light-emitting device may include a hole-blocking layer, and the hole-blocking layer may include a phosphine oxide-containing compound, a silicon-containing compound, or any combination thereof. In one or more embodiments, the hole-blocking layer may directly contact the emission layer.

In one or more embodiments, the light-emitting device may further include a second compound including at least one π electron-deficient nitrogen-containing C₁-C₆₀ heterocyclic group, a third compound including a group represented by Formula 3, a fourth compound capable of emitting delayed fluorescence, or any combination thereof, and

the organometallic compound (e.g., as the first compound), the second compound, the third compound, and the fourth compound in the light-emitting device may be different from each other, 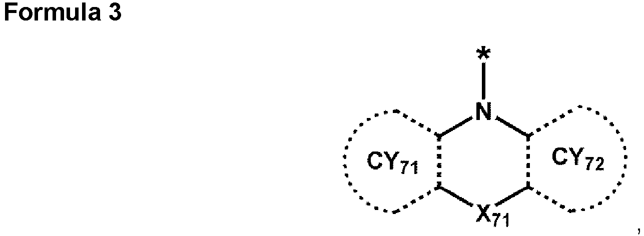 wherein, in Formula 3,
ring CY₇₁ and ring CY₇₂ may each independently be a π electron-rich C₃-C₆₀ cyclic group or a pyridine group,
X₇₁ may be a single bond or a linking group including O, S, N, B, C, Si, or any combination thereof, and
* indicates a binding site to any atom included in the remaining part other than the group represented by Formula 3 in the third compound.

In one or more embodiments, the organometallic compound may include at least one deuterium.

In one or more embodiments, the second compound, the third compound, and the fourth compound may each include at least one deuterium.

In one or more embodiments, the second compound may include at least one silicon.

In one or more embodiments, the third compound may include at least one silicon.

In one or more embodiments, the light-emitting device may further include, in addition to the organometallic compound represented by Formula 1, a second compound and a third compound, wherein at least one selected from among the second compound and the third compound may include at least one deuterium, at least one silicon, or any combination thereof.

According to one or more embodiments, the light-emitting device (for example, the emission layer of the light-emitting device) may include a second compound in addition to the organometallic compound. At least one selected from among the organometallic compound and the second compound may include at least one deuterium. For example, in some embodiments, the light-emitting device (for example, the emission layer of the light-emitting device) may further include a third compound, a fourth compound, or any combination thereof, in addition to the organometallic compound and the second compound.

In one or more embodiments, the light-emitting device (for example, the emission layer of the light-emitting device) may further include a third compound in addition to the organometallic compound. At least one selected from among the organometallic compound and the third compound may include at least one deuterium. For example, in some embodiments, the light-emitting device (for example, the emission layer of the light-emitting device) may further include, in addition to the organometallic compound and the third compound, a second compound, a fourth compound, or any combination thereof.

In one or more embodiments, the light-emitting device (for example, the emission layer of the light-emitting device) may further include a fourth compound in addition to the organometallic compound. At least one selected from among the organometallic compound and the fourth compound may include at least one deuterium. The fourth compound may improve color purity, luminescence efficiency, and lifespan characteristics of the light-emitting device. For example, in some embodiments, the light-emitting device (for example, the emission layer of the light-emitting device) may further include a second compound, a third compound, or any combination thereof, in addition to the organometallic compound and the fourth compound.

In one or more embodiments, the light-emitting device (for example, the emission layer of the light-emitting device) may further include a second compound and a third compound, in addition to the organometallic compound. The second compound and the third compound may form an exciplex. At least one selected from among the organometallic compound, the second compound, and the third compound may include at least one deuterium.

In one or more embodiments, the emission layer of the light-emitting device may include: i) the organometallic compound; and ii) the second compound, the third compound, the fourth compound, or any combination thereof, and the emission layer may be to emit blue light.

In one or more embodiments, the maximum emission wavelength of the blue light may be in a range of about 430 nm to about 480 nm, about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, the second compound may include a pyridine group, a pyrimidine group, a pyrazine group, a pyridazine group, a triazine group, or any combination thereof.

In one or more embodiments, the following compounds may be excluded from the third compound:

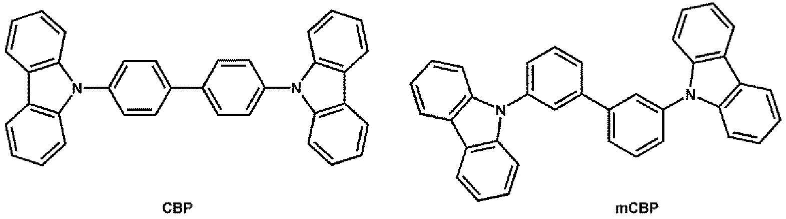

In one or more embodiments, a difference between a triplet energy level (eV) of the fourth compound and a singlet energy level (eV) of the fourth compound may be about 0 eV or higher and about 0.5 eV or lower (or, about 0 eV or higher and about 0.3 eV or lower).

In one or more embodiments, the fourth compound may be a compound including at least one cyclic group including each of boron (B) and nitrogen (N) as ring-forming atoms.

In one or more embodiments, the fourth compound may be a C₈-C₆₀ polycyclic group-containing compound including at least two condensed cyclic groups that share a boron atom (B) (e.g., one being a first ring and the other being a second ring).

In one or more embodiments, the fourth compound may include a condensed ring in which at least one third ring may be condensed with at least one fourth ring, for example, to form the condensed ring including four or more rings,

the third ring of the fourth compound may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and

the fourth ring of the fourth compound may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the third compound may not include (e.g., may exclude) a (e.g., any) compound represented by Formula 3-1 described in the present disclosure.

In one or more embodiments, the second compound may include a compound represented by Formula 2:

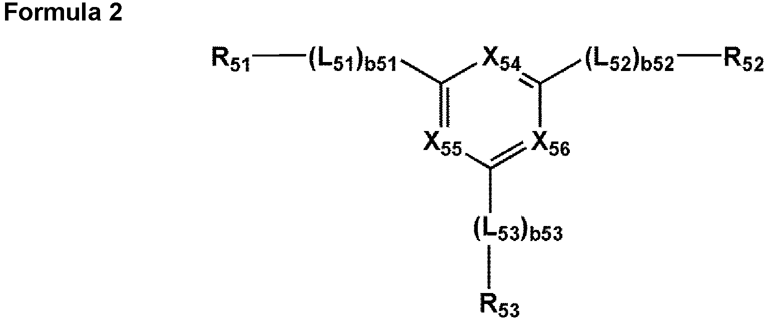

In Formula 2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one selected from among X₅₄ to X₅₆ may be N,
R₅₁ to R₅₆ and R₁₀ₐ may each respectively be the same as described in the present disclosure.

In one or more embodiments, the third compound may include a compound represented by Formula 3-1, a compound represented by Formula 3-2, a compound represented by Formula 3-3, a compound represented by Formula 3-4, a compound represented by Formula 3-5, or any combination thereof: 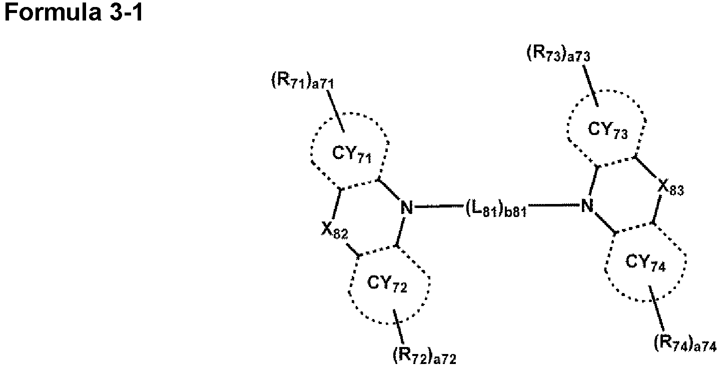 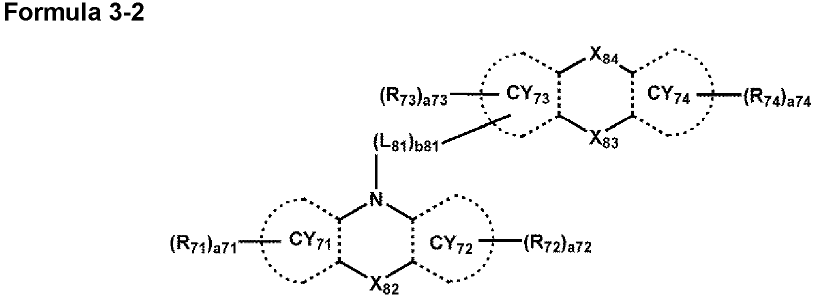 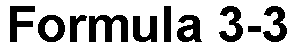 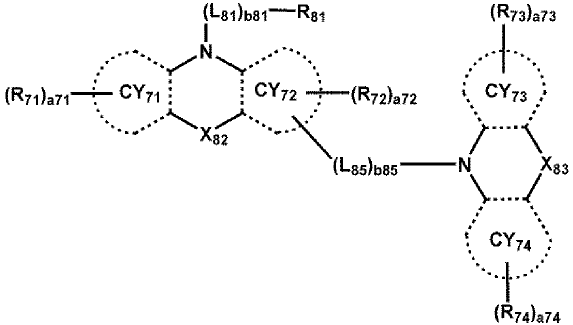 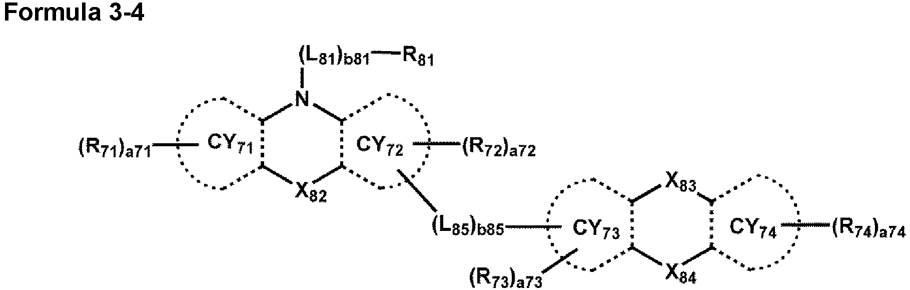 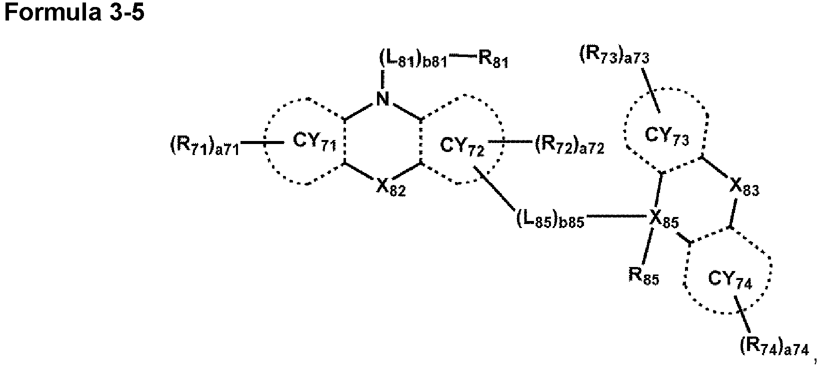 wherein, in Formulae 3-1 to 3-5,
ring CY₇₁ to ring CY₇₄ may each independently be a π electron-rich C₃-C₆₀ cyclic group or a pyridine group,
X₈₂ may be a single bond, O, S, N[(L₈₂)_{b82}-R₈₂], C(R₈₂ₐ)(R_{82b}), or Si(R82a)(R82b),
X₈₃ may be a single bond, O, S, N[(L₈₃)_{b83}-R₈₃], C(R₈₃ₐ)(R_{83b}), or Si(R83a)(R83b),
X₈₄ may be O, S, N[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group that is unsubstituted or substituted with at least one R₁₀ₐ, or a pyridine group that is unsubstituted or substituted with at least one R₁₀ₐ, wherein Q₄ and Q₅ may each be understood by referring to the description of Q₁ provided herein,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each respectively be the same as described in the present disclosure,
a71 to a74 may each independently be an integer from 0 to 20, and
R₁₀ₐ may be the same as described herein.

In one or more embodiments, the fourth compound may be a compound represented by Formula 502, a compound represented by Formula 503, or any combination thereof: 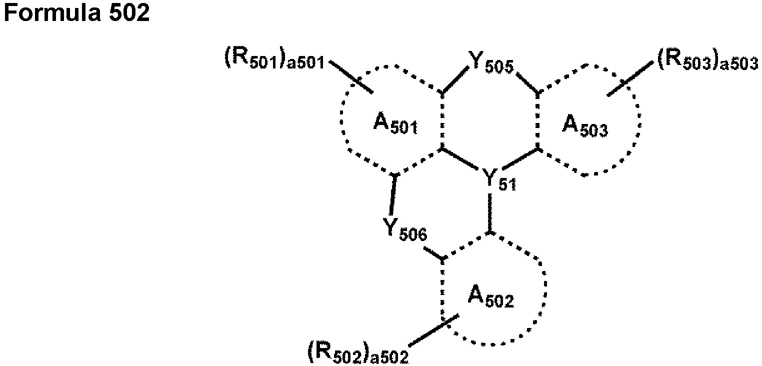 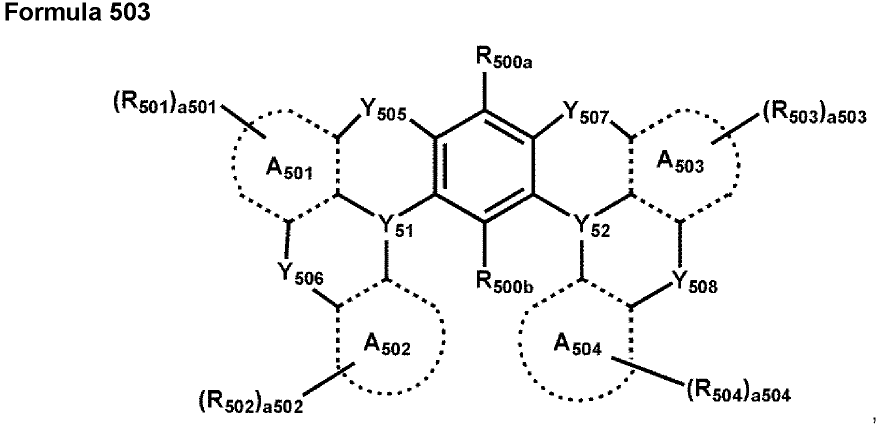 wherein, in Formulae 502 and 503,
ring A₅₀₁ to ring A₅₀₄ may each independently be a C₃-C₆₀ carbocyclic group or a C₁-C₆₀ heterocyclic group,
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each respectively be the same as described in the present disclosure, and
a501 to a504 may each independently be an integer from 0 to 20.

In one or more embodiments, the light-emitting device may satisfy at least one selected from among Conditions 1 to 4: lowest unoccupied molecular orbital (LUMO) energy level (eV) of third compound > LUMO energy level (eV) of organometallic compound LUMO energy level (eV) of organometallic compound > LUMO energy level (eV) of second compound highest occupied molecular orbital (HOMO) energy level (eV) of organometallic compound > HOMO energy level (eV) of third compound HOMO energy level (eV) of the third compound > HOMO energy level (eV) of the second compound

Each of the HOMO energy level and LUMO energy level of each of the organometallic compound, the second compound, and the third compound may be a negative value, and may be measured according to a suitable method.

In one or more embodiments, an absolute value of a difference between the LUMO energy level of the organometallic compound and the LUMO energy level of the second compound may be about 0.1 eV or higher and about 1.0 eV or lower, and/or an absolute value of a difference between the LUMO energy level of the organometallic compound and the LUMO energy level of the third compound may be about 0.1 eV or higher and about 1.0 eV or lower, and an absolute value of a difference between the HOMO energy level of the organometallic compound and the HOMO energy level of the second compound may be about 1.25 eV or lower (for example, about 1.25 eV or lower and about 0.2 eV or higher), and/or an absolute value of a difference between the HOMO energy level of the organometallic compound and the HOMO energy level of the third compound may be about 1.25 eV or lower (for example, about 1.25 eV or lower and about 0.2 eV or higher).

When the relationships between LUMO energy level and HOMO energy level satisfy the conditions as described above, the balance between holes and electrons injected into the emission layer may be made.

The light-emitting device may have a structure of a first embodiment or a second embodiment.

### First embodiment

According to the first embodiment, the organometallic compound may be included in the emission layer in the interlayer of the light-emitting device, wherein the emission layer may further include a host, the organometallic compound may be different from the host, and the emission layer may be to emit phosphorescence or fluorescence emitted from the organometallic compound. For example, according to the first embodiment, the organometallic compound may be a dopant or an emitter. In one or more embodiments, the organometallic compound may be a phosphorescent dopant or a phosphorescent emitter.

Phosphorescence or fluorescence emitted from the organometallic compound may be blue light.

In one or more embodiments, the emission layer may further include an auxiliary dopant. The auxiliary dopant may improve luminescence efficiency of the organometallic compound by effectively transferring energy to the organometallic compound as a dopant or an emitter.

The auxiliary dopant may be different from the organometallic compound and the host.

In one or more embodiments, the auxiliary dopant may be a delayed fluorescence-emitting compound.

In one or more embodiments, the auxiliary dopant may be a compound including at least one cyclic group including boron (B) and nitrogen (N) as ring-forming atoms.

### Second embodiment

According to the second embodiment, the organometallic compound may be included in the emission layer in the interlayer of the light-emitting device, wherein the emission layer may further include a host and a dopant, the organometallic compound, the host, and the dopant may be different from one another, and the emission layer may be to emit phosphorescence or fluorescence (for example, delayed fluorescence) from the dopant.

In one or more embodiments, the organometallic compound in the second embodiment may serve not as a dopant, but as an auxiliary dopant that transfers energy to a dopant (or an emitter).

In one or more embodiments, the organometallic compound in the second embodiment may serve as an emitter and also as an auxiliary dopant that transfers energy to a dopant (or an emitter).

For example, in some embodiments, phosphorescence or fluorescence emitted from the dopant (or the emitter) in the second embodiment may be blue phosphorescence or blue fluorescence (for example, blue delayed fluorescence).

The dopant (or the emitter) in the second embodiment may be a phosphorescent dopant material (for example, the organometallic compound represented by Formula 1, an organometallic compound represented by Formula 401, or any combination thereof) or any fluorescent dopant material (for example, a compound represented by Formula 501, a compound represented by Formula 502, a compound represented by Formula 503, or any combination thereof).

In the first embodiment and the second embodiment, the blue light may be blue light having a maximum emission wavelength in a range of about 390 nm to about 500 nm, about 410 nm to about 490 nm, about 430 nm to about 480 nm, about 440 nm to about 475 nm, or about 455 nm to about 470 nm.

The auxiliary dopant in the first embodiment may include, for example, the fourth compound represented by Formula 502 or Formula 503.

The host in the first embodiment and the second embodiment may be any host material (for example, a compound represented by Formula 301, a compound represented by 301-1, a compound represented by Formula 301-2, or any combination thereof).

In one or more embodiments, the host in the first embodiment and the second embodiment may be the second compound, the third compound, or any combination thereof.

In one or more embodiments, the light-emitting device may further include a capping layer arranged outside (e.g., on) the first electrode and/or outside (e.g., on) the second electrode.

In one or more embodiments, the light-emitting device may further include at least one of a first capping layer located outside (e.g., on) the first electrode or a second capping layer located outside (e.g., on) the second electrode, and the organometallic compound represented by Formula 1 may be included in at least one of the first capping layer or the second capping layer. The first capping layer and/or the second capping layer may each be the same as described herein.

In one or more embodiments, the light-emitting device may further include:
a first capping layer arranged outside (e.g., on) the first electrode and including the organometallic compound represented by Formula 1;
a second capping layer arranged outside (e.g., on) the second electrode and including the organometallic compound represented by Formula 1; or
the first capping layer and the second capping layer.

The expression that an "(interlayer and/or a capping layer) includes at least one organometallic compound represented by Formula 1" as utilized herein may be construed as meaning that the "(interlayer and/or the capping layer) may include one organometallic compound represented by Formula 1 or two or more different organometallic compounds each represented by Formula 1."

In one or more embodiments, the interlayer and/or the capping layer may include Compound 1 only as the organometallic compound. In this regard, Compound 1 may be present in the emission layer of the light-emitting device. In one or more embodiments, the interlayer may include, as the organometallic compound, Compound 1 and Compound 2. In this regard, Compound 1 and Compound 2 may be present in substantially the same layer (for example, both (e.g., simultaneously) Compound 1 and Compound 2 may be present in the emission layer), or may be present in different layers (for example, Compound 1 may be present in the emission layer, and Compound 2 may be present in the electron transport region).

The term "interlayer" as utilized herein refers to a single layer and/or a plurality of layers between the first electrode and the second electrode of the light-emitting device.

According to one or more embodiments of the present disclosure, an electronic apparatus may include the light-emitting device. In one or more embodiments, the electronic apparatus may further include a thin-film transistor. For example, in some embodiments, the electronic apparatus may further include a thin-film transistor including a source electrode and a drain electrode, wherein the first electrode of the light-emitting device may be electrically connected to the source electrode or the drain electrode of the thin-film transistor. In some embodiments, the electronic apparatus may further include a color filter, a color conversion layer, a touch screen layer, a polarizing layer, or any combination thereof. More details of the electronic apparatus may be referred to the descriptions provided herein.

According to one or more embodiments of the present disclosure, an electronic equipment may include the light-emitting device.

For example, the electronic equipment may be at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, or a signboard.

According to one or more embodiments of the present disclosure, provided is an organometallic compound represented by Formula 1. Details on Formula 1 may be the same as described herein.

Methods of synthesizing the organometallic compound may be easily understood to those of ordinary skill in the art by referring to Synthesis Examples and/or Examples described herein.

### Description of Formula 1

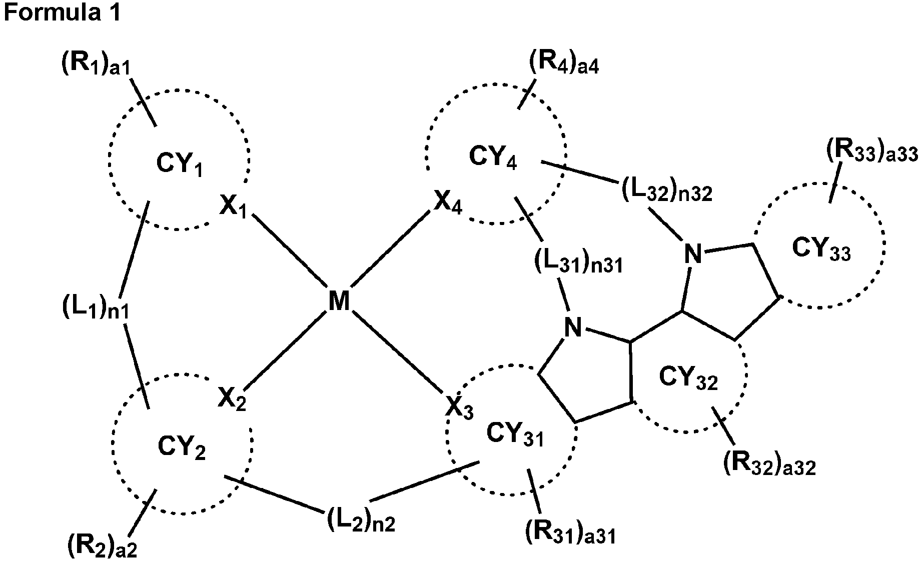

M in Formula 1 is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In one or more embodiments, M may be platinum (Pt), palladium (Pd), or gold (Au).

In one or more embodiments, M may be Pt.

X₁ to X₄ in Formula 1 are each independently C or N.

X₁ in one or more embodiments may be C.

In one or more embodiments, X₁ may be C, and a bond between X₁ and M may be a coordinate bond.

In one or more embodiments, X₁ may be carbon (C) of a carbene moiety.

In one or more embodiments, X₂ and X₃ may each be C, and X₄ may be N.

In one or more embodiments, i) a bond between X₁ and M may be a coordinate bond, and ii) one selected from among a bond between X₂ and M, a bond between X₃ and M, and a bond between X₄ and M may be a coordinate bond, and the other two may each be a covalent bond.

In one or more embodiments, a bond between X₁ and M and a bond between X₄ and M may each be a coordinate bond, and a bond between X₂ and M and a bond between X₃ and M may each be a covalent bond.

In one or more embodiments, X₁, X₂, and X₃ may each be C, X₄ may be N, a bond between X₁ and M and a bond between X₄ and M may each be a coordinate bond, and a bond between X₂ and M and a bond between X₃ and M may each be a covalent bond.

ring CY₁, ring CY₂, ring CY₃₁ to ring CY₃₃, and ring CY₄ in Formula 1 are each independently a C₅-C₃₀ carbocyclic group or a C₁-C₃₀ heterocyclic group.

In one or more embodiments, ring CY₁, ring CY₂, ring CY₃₁ to ring CY₃₃, and ring CY₄ may each independently be:
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodisiline group, a dibenzodihydrosiline group, a dibenzodioxin group, a dibenzoxathiin group, a dibenzoxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group.

In one or more embodiments, ring CY₁ may be a nitrogen-containing C₁-C₆₀ heterocyclic group.

In one or more embodiments, ring CY₁ may be an imidazole group, triazole group, a benzimidazole group, a naphthoimidazole group, or an imidazopyridine group.

In one or more embodiments, X₁ may be C, and ring CY₁ may be an imidazole group, a triazole group, a benzimidazole group, a naphthoimidazole group, or an imidazopyridine group.

In one or more embodiments, X₁ may be carbon (C) of a carbene moiety, and ring CY₁ may be an imidazole group, a triazole group, a benzimidazole group, a naphthoimidazole group, or an imidazopyridine group.

In one or more embodiments, ring CY₂ may be a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group.

In one or more embodiments, ring CY₂ may be a benzene group, a pyridine group, a pyrimidine group, a naphthalene group, a dibenzofuran group, a dibenzothiophene group, a carbazole group, a fluorene group, or a dibenzosilole group.

In one or more embodiments, ring CY₃₁ to ring CY₃₃ may each independently be a benzene group, a pyridine group, a pyrimidine group, a naphthalene group, a dibenzofuran group, a dibenzothiophene group, a carbazole group, a fluorene group, or a dibenzosilole group.

In one or more embodiments, ring CY₄ may be a nitrogen-containing C₁-C₆₀ heterocyclic group.

In one or more embodiments, ring CY₄ may be a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a benzopyrazole group, a benzimidazole group, or a benzothiazole group.

L₁, L₂, L₃₁, and L₃₂ in Formula 1 are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C=C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', *-Ge(R₁ₐ)(R_{1b})-*', a C₅-C₃₀ carbocyclic group unsubstituted or substituted with at least one R₁₀ₐ, or a C₁-C₃₀ heterocyclic group unsubstituted or substituted with at least one R₁₀ₐ, and * and *' each indicate a binding site to a neighboring atom.

R₁₀ₐ may be the same as described herein.

n1, n2, n31, and n32 in Formula 1 represent the number of L₁, the number of L₂, the number of L₃₁, and the number of L₃₂, respectively, and are each independently an integer from 1 to 10. When n1 is 2 or more, two or more of L₁(s) may be the same or different from each other, when n2 is 2 or more, two or more of L₂(s) may be the same or different from each other, when n31 is 2 or more, two or more of L₃₁(s) may be the same as or different from each other, and when n32 is 2 or more, two or more of L₃₂(s) may be the same or different from each other.

R₁ₐ and R_{1b} in Formula 1 are each independently hydrogen, deuterium, -F, - Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

In one or more embodiments, R₁ₐ and R_{1b} may optionally be bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In one or more embodiments, L₁ and L₃₁ may each be a single bond.

In one or more embodiments, L₂ may be *-O-*' or *-S-*', and n2 may be 1.

In one or more embodiments, L₁ and L₃₁ may each be a single bond, L₂ may be *-O-*' or *-S-*', and n2 may be 1.

In one or more embodiments, *-(L₃₂)n₃₂-*' may form a ring having 8 or more ring-forming atoms (e.g., *-(L₃₂)ₙ₃₂-*', *-(L₃₁)ₙ₃₁₋*', ring CY₄, ring CY₃₂, and two nitrogen atoms in Formula 1 may form a ring having 8 or more ring-forming atoms).

In one or more embodiments, L₃₂ may be: a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*';
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazonylene group, a tetrazolylene group, a triazinylene group, a dibenzofuranylene group, or a dibenzothiophenylene group; or
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazonylene group, a tetrazolylene group, a triazinylene group, a dibenzofuranylene group, or a dibenzothiophenylene group, each unsubstituted or substituted with at least one selected from among deuterium, -F, -Cl, - Br, -I, a hydroxyl group, a cyano group, a nitro group, an amino group, an amidino group, a hydrazine group, a hydrazone group, a carboxylic acid group or salt thereof, a sulfonic acid group or salt thereof, a phosphoric acid group or salt thereof, a C₁-C₂₀ alkyl group, a C₁-C₂₀ alkoxy group, a phenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group.

In one or more embodiments, L₃₂ may be a single bond, *-C(R₁ₐ)(R_{1b})-*', *-C(R₁ₐ)=*', *=C(R₁ₐ)-*', *-C(R₁ₐ)=C(R_{1b})-*', or *-Si(R₁ₐ)(R_{1b})-*', or
a phenylene group or a naphthylene group, each unsubstituted or substituted with at least one of deuterium, a C₁-C₂₀ alkyl group, a C₁-C₂₀ alkoxy group, a phenyl group, or a naphthyl group.

In one or more embodiments, n32 may be an integer from 1 to 5.

In one or more embodiments, L₃₂ may be selected from Formulae L(1) to L(13): 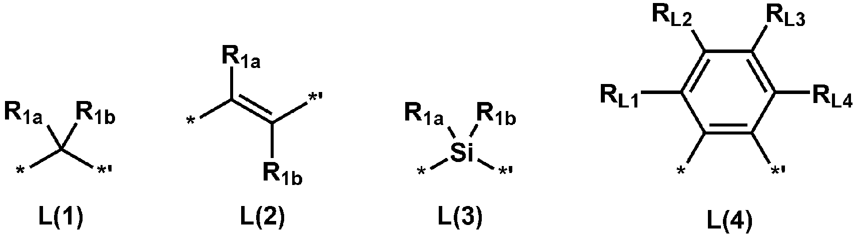 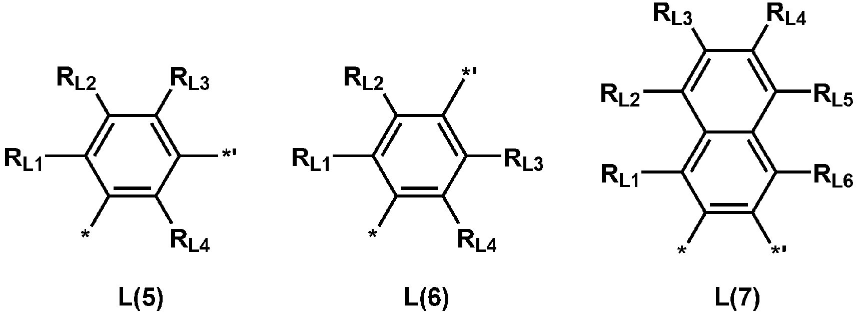 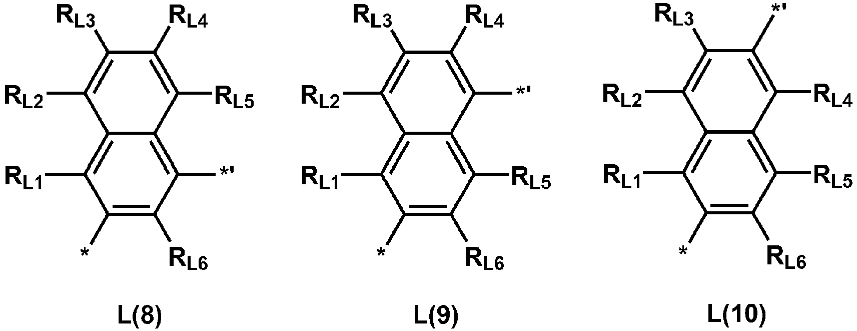 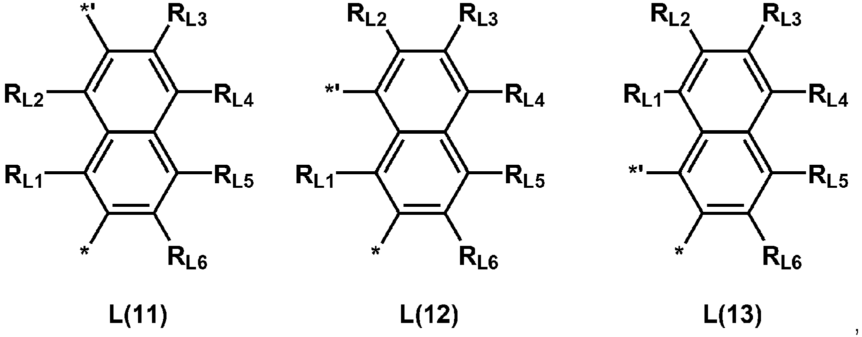 wherein, in Formulae L(1) to L(13),
R₁ₐ and R_{1b} are each the same as described herein,
R_{L1} to R_{L6} may each be the same as described with respect to R₁₀ₐ, and
* and *' each indicate a binding site to a neighboring atom.

In one or more embodiments, R₁ₐ and R_{1b} may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), wherein
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

R₁, R₂, R₃₁ to R₃₃, and R₄ in Formula 1 are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

a1, a2, a31 to a33, and a4 in Formula 1 represent the number of R₁, the number of R₂, the number of R₃₁ to the number of R₃₃, and the number of R₄, respectively, and are each independently an integer from 1 to 20. When a1 is 2 or more, two or more of R1(s) may be the same or different from each other, when a2 is 2 or more, two or more of R2(s) may be the same or different from each other, and when a31 is 2 or more, two or more of R31(s) may be the same or different from each other, when a32 is 2 or more, two or more of R32(s) may be the same or different from each other, when a33 is 2 or more, two or more of R33(s) may be the same or different from each other, and when a4 is 2 or more, two or more of R4(s) may be the same or different from each other.

In one or more embodiments, R₁, R₂, R₃₁ to R₃₃, and R₄ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments, R₁, R₂, R₃₁ to R₃₃, and R₄ may each independently be:
hydrogen, deuterium, -F, a C₁-C₂₀ alkyl group, or a C₁-C₂₀ alkoxy group;
a C₁-C₂₀ alkyl group or a C₁-C₂₀ alkoxy group, each substituted with deuterium, -F, -CD₃, -CD₂H, -CDH₂, -CF₃, -CF₂H, -CFH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a phenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, each unsubstituted or substituted with deuterium, -F, -CD₃, - CD₂H, -CDH₂, -CF₃, -CF₂H, -CFH₂, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, -O(Q₃₁), -S(Q₃₁), -Si(Q₃₁)(Q₃₂)(Q₃₃), -N(Q₃₁)(Q₃₂), or any combination thereof; or
-C(Q₁)(Q₂)(Q₃), -Si(Q₁)(Q₂)(Q₃), -N(Q₁)(Q₂),
wherein Q₁ to Q₃ and Q₃₁ to Q₃₃ may each independently be: hydrogen; deuterium; -F; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a C₁-C₆₀ alkyl group, a C₁-C₆₀ alkoxy group, a phenyl group, a biphenyl group, or any combination thereof.

In one or more embodiments, R₁, R₂, R₃₁ to R₃₃, and R₄ may each independently be:
hydrogen, deuterium, or a C₁-C₂₀ alkyl group;
a C₁-C₂₀ alkyl group, substituted with deuterium, -CD₃, -CD₂H, -CDH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, or a naphthyl group, each unsubstituted or substituted with deuterium, -CD₃, -CD₂H, -CDH₂, a C₁-C₂₀ alkyl group, a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, -Si(Q₃₁)(Q₃₂)(Q₃₃), or any combination thereof, or
-C(Q₁)(Q₂)(Q₃), or-Si(Q₁)(Q₂)(Q₃),
wherein Q₁ to Q₃ and Q₃₁ to Q₃₃ may each independently be: hydrogen; deuterium; a C₁-C₆₀ alkyl group; a C₂-C₆₀ alkenyl group; a C₂-C₆₀ alkynyl group; or a C₃-C₆₀ carbocyclic group unsubstituted or substituted with deuterium, a C₁-C₆₀ alkyl group, a phenyl group, a biphenyl group, or any combination thereof.

In one or more embodiments, two or more adjacent groups selected from among a1 R₁(s), a2 R₂(s), a31 R₃₁(s), a32 R₃₂(s), a33 R₃₃(s), a4 R₄(s), R₁ₐ, and R_{1b} may optionally be combined with each other to form a C₃-C₆₀ carbocyclic group unsubstituted or substituted with at least one R₁₀ₐ or a C₁-C₆₀ heterocyclic group unsubstituted or substituted with at least one R₁₀ₐ

R₁₀ₐ may be the same as described herein.

In one or more embodiments, at least one of R₁(s) may be a group represented by Formula S1: 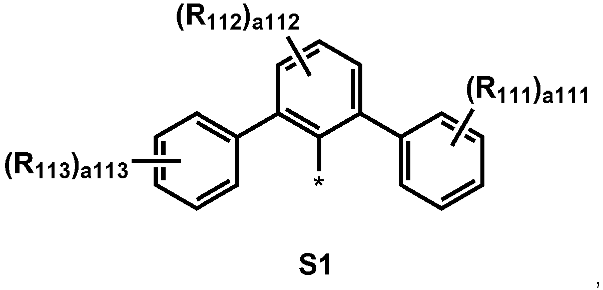 wherein, in Formula S1,
R₁₁₁ to R₁₁₃ may each be the same as described with respect to R₁ in the present disclosure,
a111 may be an integer from 1 to 5,
a112 may be an integer from 1 to 3,
a113 may be an integer from 1 to 5, and
* is the binding site with an adjacent atom.

In one or more embodiments, two or more adjacent groups selected from among a111 R₁₁₁(s), a112 R₁₁₂(s), and a113 R₁₁₃(s) may optionally be bound to form a C₃-C₆₀ carbocyclic group unsubstituted or substituted with at least one R₁₀ₐ or a C₁-C₆₀ heterocyclic group unsubstituted or substituted with at least one R₁₀ₐ.

R₁₀ₐ may be the same as described herein.

In one or more embodiments, a group represented by 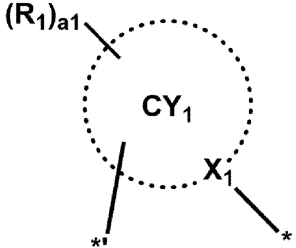 in Formula 1 may be a group represented by one selected from among CY1(1) to CY1(11): 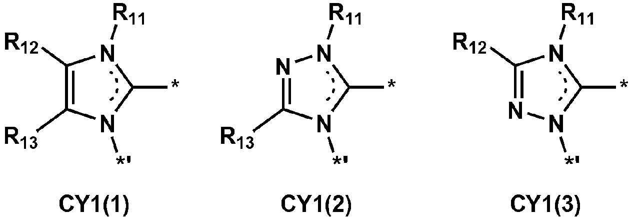 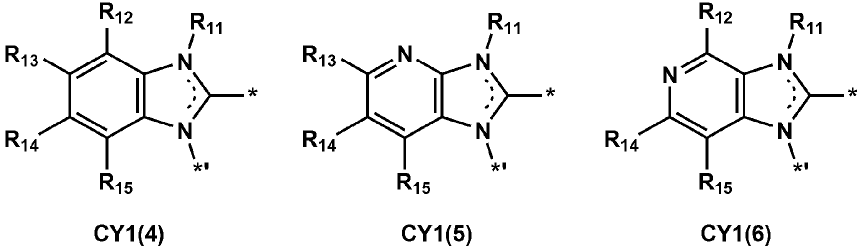 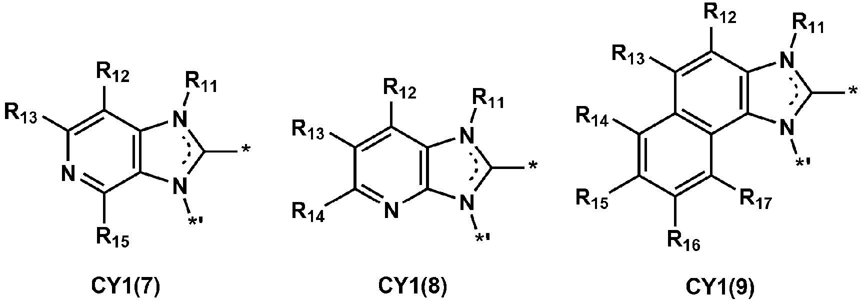 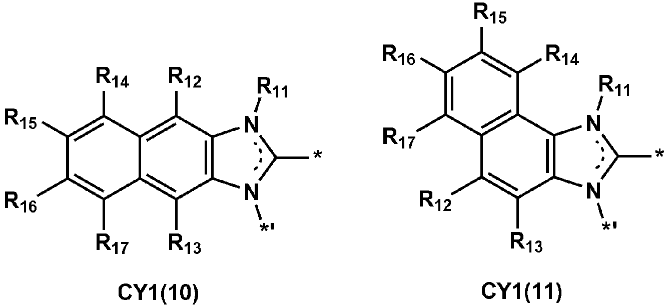 wherein, in Formulae CY1(1) to CY1(11),
R₁₁ to R₁₇ may each be the same as described with respect to R₁,
* indicates a binding site to M in Formula 1, and
*' indicates a binding site to L₁ in Formula 1.

In one or more embodiments, a group represented by 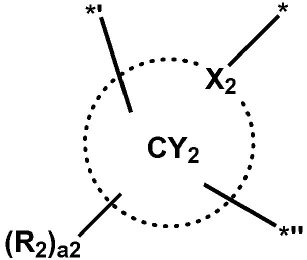 in Formula 1 may be a group represented by one selected from among Formulae CY2(1) to CY2(13) : 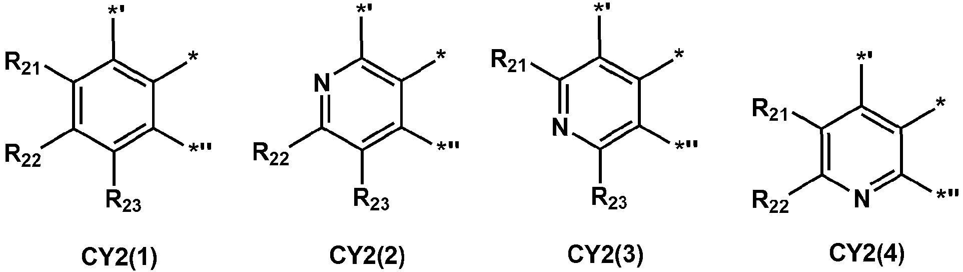 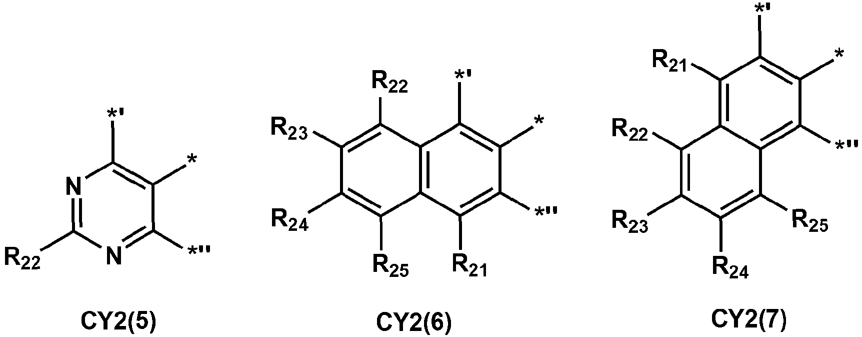 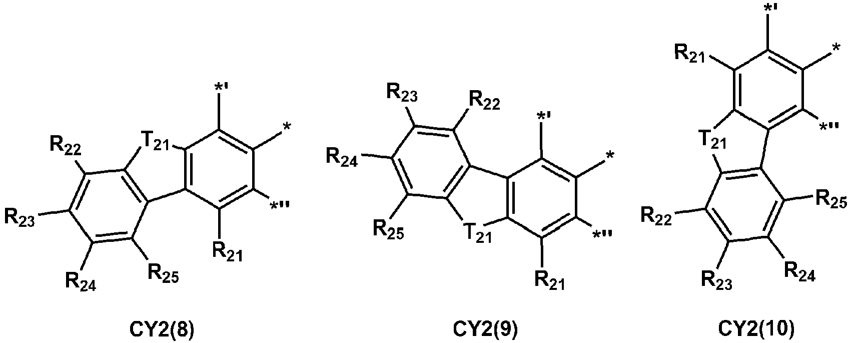 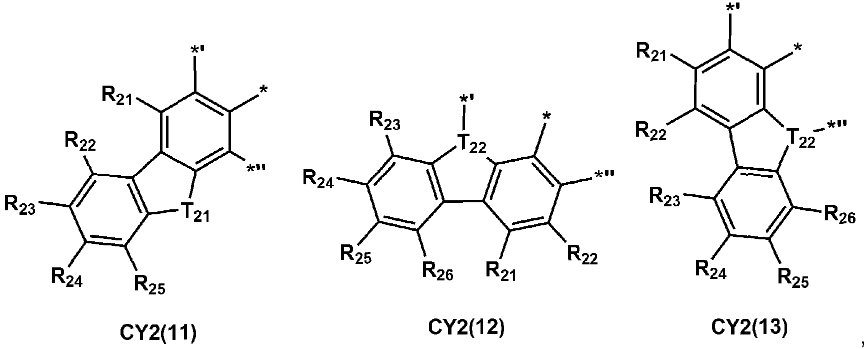 wherein, in Formulae CY2(1) to CY2(13),
T₂₁ may be B(Y₂₁), C(Y₂₁)(Y₂₂), N(Y₂₁), O, S, or Si(Y₂₁)(Y₂₂),
T₂₂ may be C(Y₂₁), N, or Si(Y₂₁),
R₂₁ to R₂₆, Y₂₁, and Y₂₂ may each be the same as described with respect to R2,
* indicates a binding site to M in Formula 1,
*' indicates a binding site to L₁ in Formula 1,
*" indicates a binding site to L₂ in Formula 1.

In one or more embodiments, a group represented by 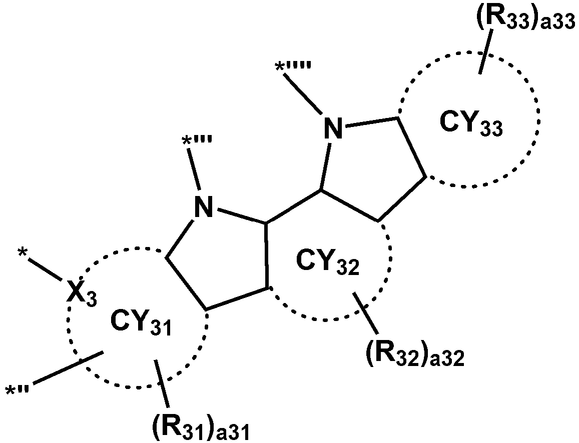 in Formula 1 may be a group represented by one selected from among Formulae CY3(1) to CY3(16): 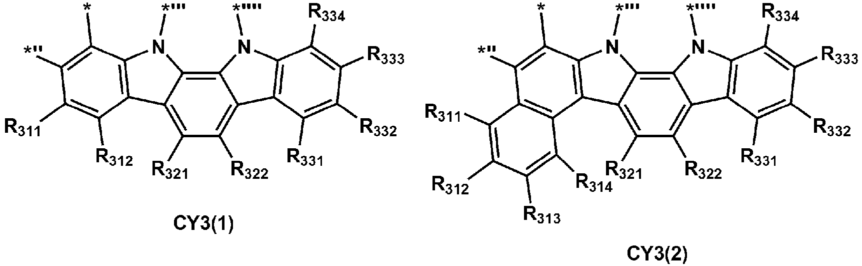 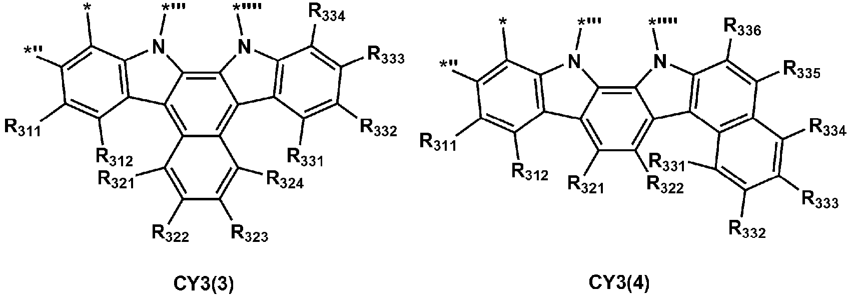 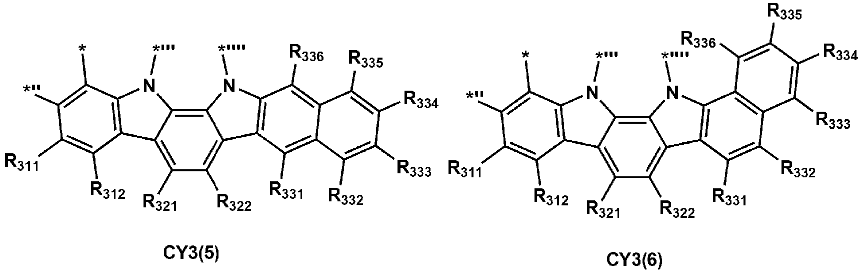 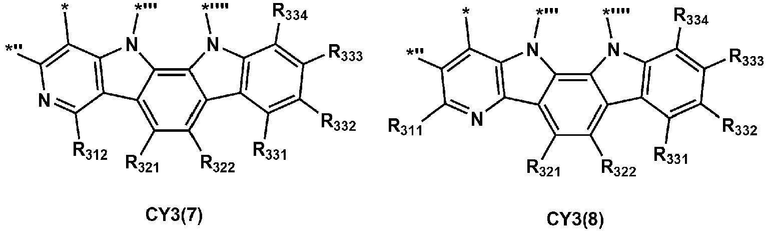 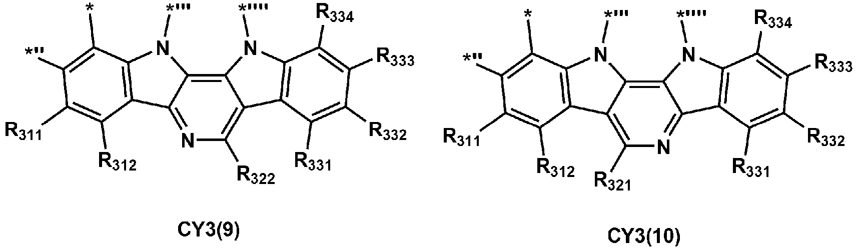 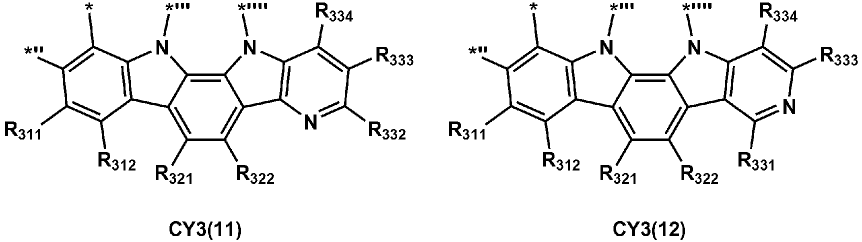 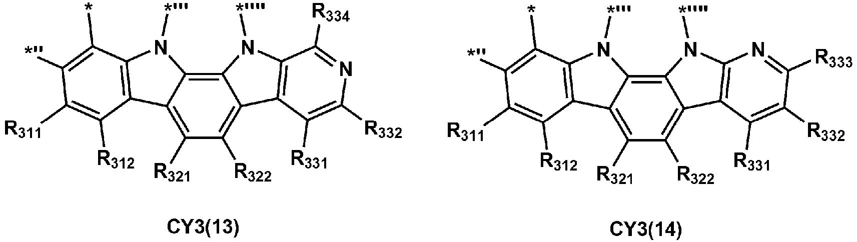 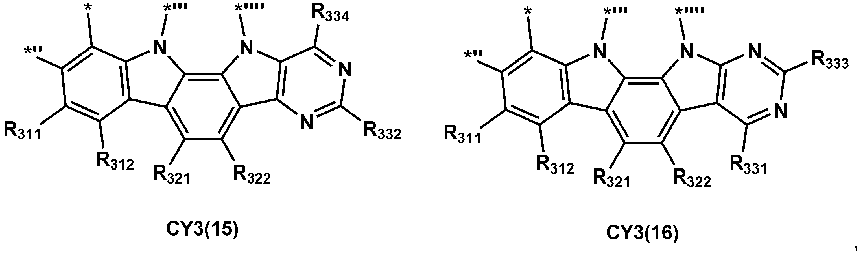 wherein, in Formulae CY3(1) to CY3(16),
R₃₁₁ to R₃₁₄ may each be the same as described with respect to R₃₁,
R₃₂₁ to R₃₂₄ may each be the same as described with respect to R₃₂,
R₃₃₁ to R₃₃₆ may each be the same as described with respect to R₃₃,
* indicates a binding site to M in Formula 1,
*" indicates a binding site to L₂ in Formula 1,
*‴ indicates a binding site to L₃₁ in Formula 1, and
*ʺʺ indicates a binding site to L₃₂ in Formula 1.

In one or more embodiments, a group represented by 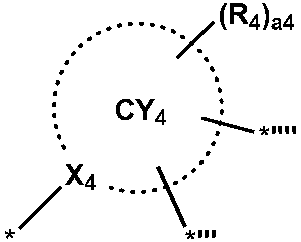 in Formula 1 may be a group represented by one selected from among Formulae CY4(1) to CY4(18): 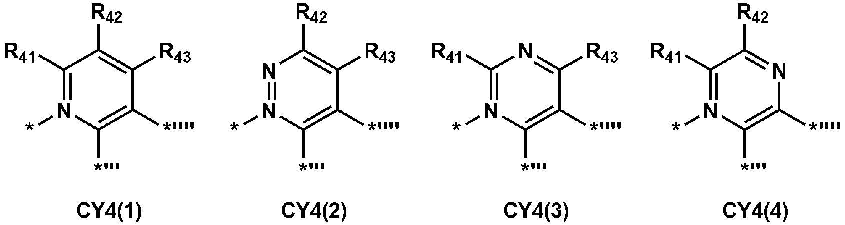 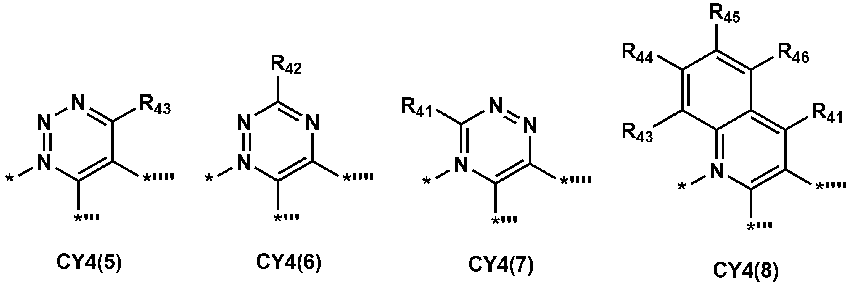 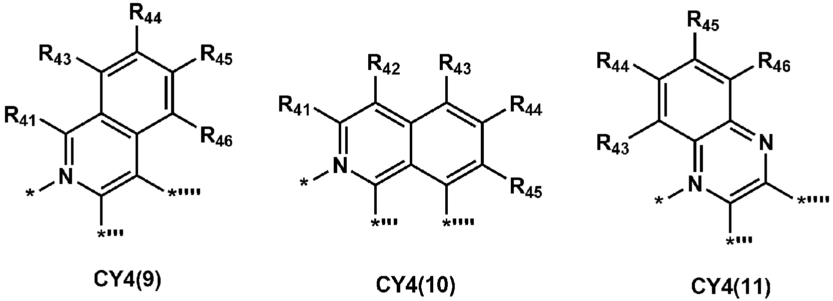 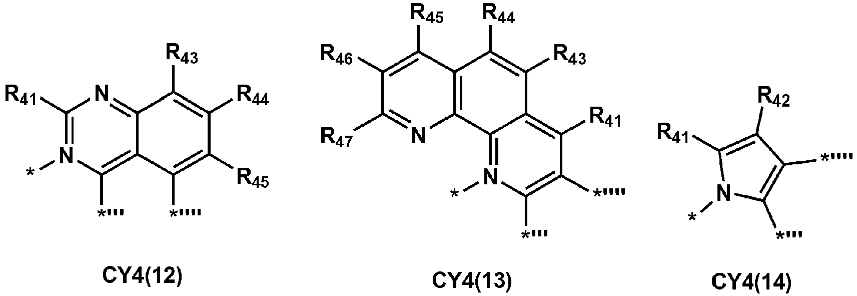 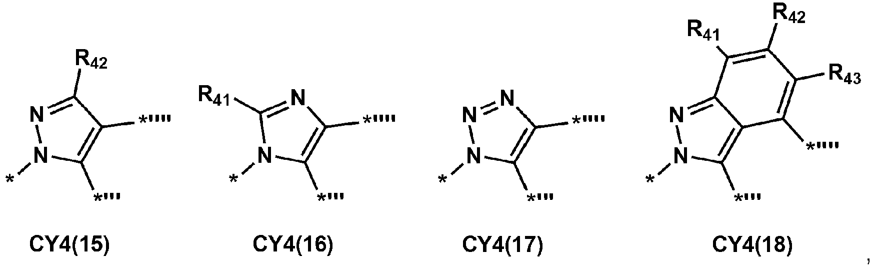 wherein, in Formulae CY4(1) to CY4(18),
R₄₁ to R₄₇ may each be the same as described with respect to R₄,
* indicates a binding site to M in Formula 1,
*‴ indicates a binding site to L₃₁ in Formula 1, and
*ʺʺ indicates a binding site to L₃₂ in Formula 1.

In one or more embodiments, the organometallic compound represented by Formula 1 may be an organometallic compound represented by Formula 1A(1) or Formula 1A(2): 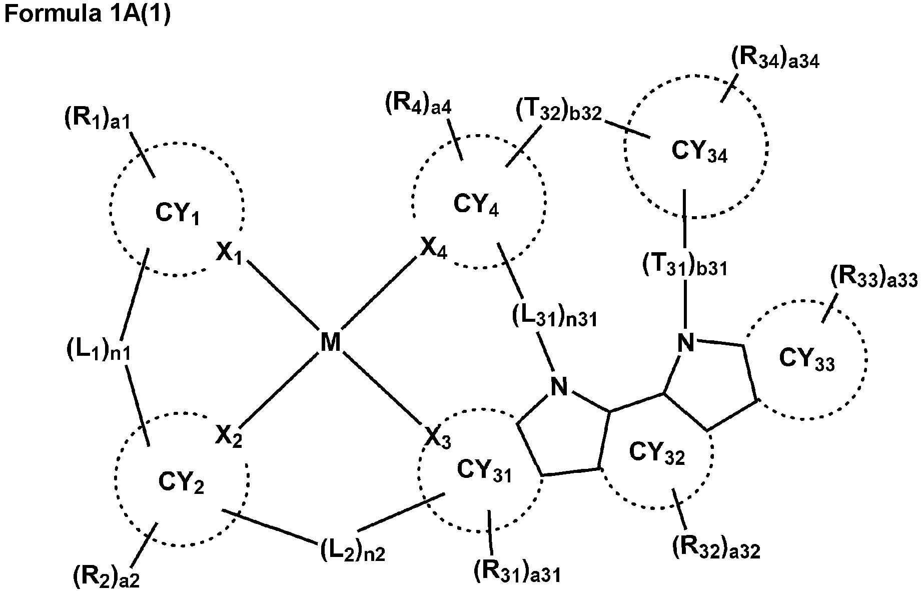 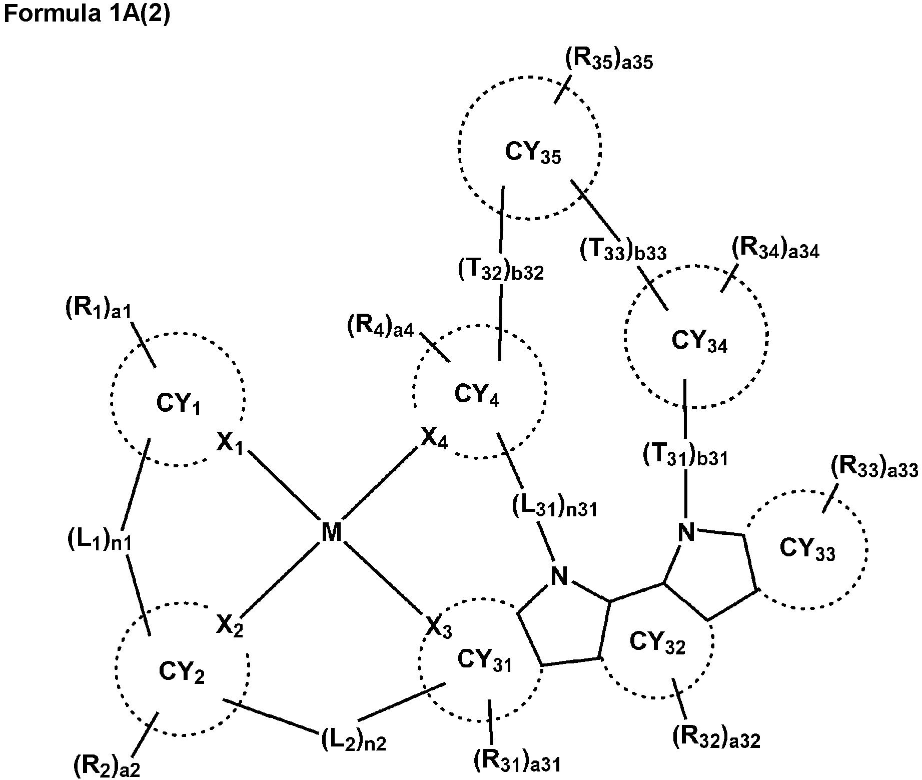 wherein, in Formulae 1A(1) and 1A(2),
M, X₁ to X₄, CY₁, CY₂, CY₃₁ to CY₃₃, CY₄, L₁, L₂, L₃₁, n1, n2, n31, R₁, R₂, R₃₁ to R₃₃, R₄, a1, a2, a31 to a33, and a4 may each independently be the same as described herein,
T₃₁ to T₃₃ may each be the same as described with respect to L₃₂,
b31 to b33 may each independently be an integer from 0 to 3,
ring CY₃₄ and ring CY₃₅ may each independently be a C₅-C₃₀ carbocyclic group or a C₁-C₃₀ heterocyclic group, and
R₃₄ and R₃₅ may each be the same as described with respect to R₁₀ₐ. a34 and a35 may each independently be an integer from 1 to 20.

In one or more embodiments, the organometallic compound represented by Formula 1 may be an organometallic compound represented by Formula 1B(1) or Formula 1B(2): 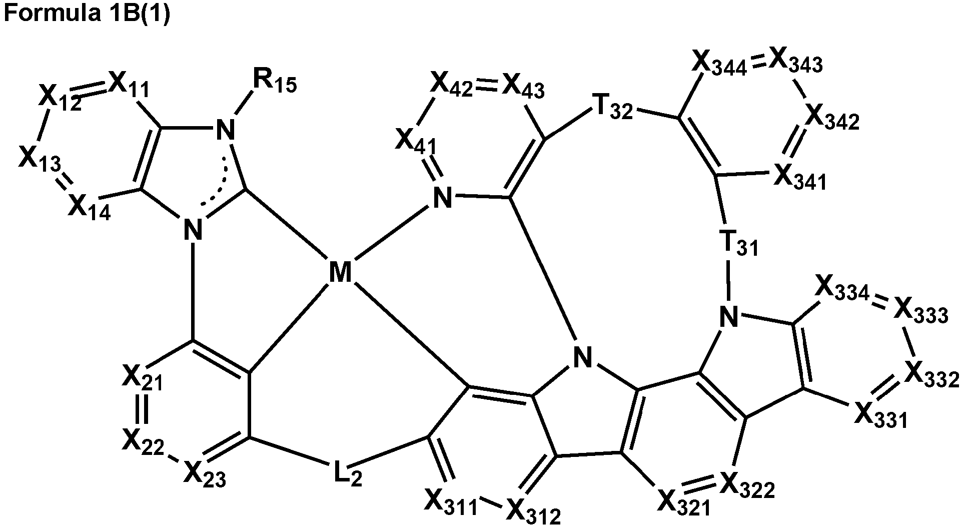 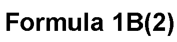 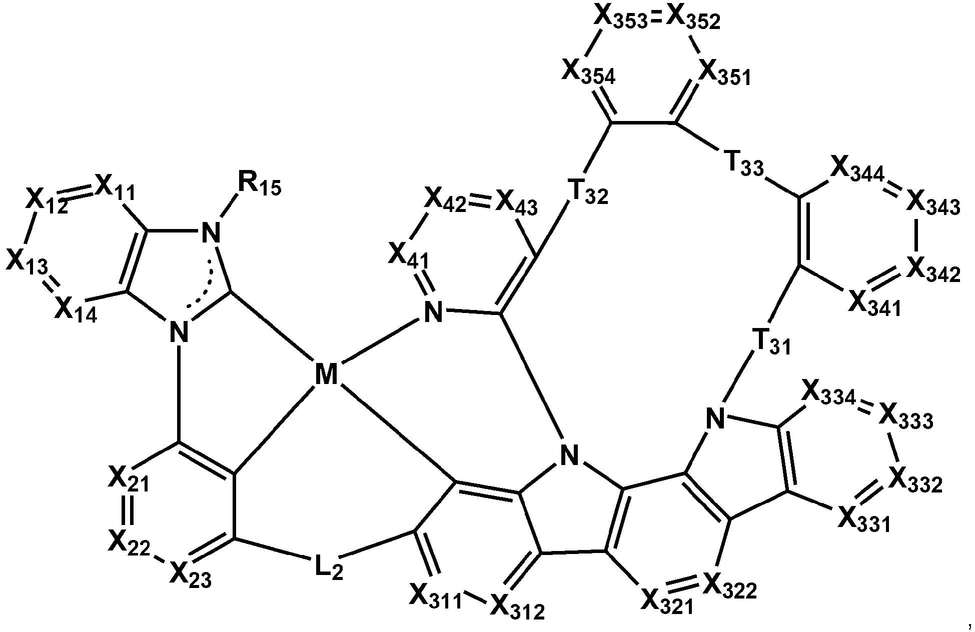 wherein, in Formula 1B(1) and Formula 1B(2),
M and L₂ are each the same as described herein, and
T₃₁ to T₃₃ may each be the same as described with respect to L₃₂,
X₁₁ may be C(R₁₁) or N, X₁₂ may be C(R₁₂) or N, X₁₃ may be C(R₁₃) or N, and X₁₄ may be C(R₁₄) or N,
X₂₁ may be C(R₂₁) or N, X₂₂ may be C(R₂₂) or N, and X₂₃ may be C(R₂₃) or N,
X₃₁₁ may be C(R₃₁₁) or N, X₃₁₂ may be C(R₃₁₂) or N, X₃₂₁ may be C(R₃₂₁) or N, X₃₂₂ may be C(R₃₂₂) or N, X₃₃₁ may be C(R₃₃₁) or N, X₃₃₂ may be C(R₃₃₂) or N, X₃₃₃ may be C(R₃₃₃) or N, X₃₃₄ may be C(R₃₃₄) or N, X₃₄₁ may be C(R₃₄₁) or N, X₃₄₂ may be C(R₃₄₂) or N, X₃₄₃ may be C(R₃₄₃) or N, X₃₄₄ may be C(R₃₄₄) or N, X₃₅₁ may be C(R₃₅₁) or N, X₃₅₂ may be C(R₃₅₂) or N, X₃₅₃ may be C(R₃₅₃) or N, and X₃₅₄ may be C(R₃₅₄) or N,
X₄₁ may be C(R₄₁) or N, X₄₂ may be C(R₄₂) or N, and X₄₃ may be C(R₄₃) or N,
R₁₁ to R₁₅ may each be the same as described with respect to R₁,
R₂₁ to R₂₃ may each be the same as described with respect to R₂,
R₃₁₁ and R₃₁₂ may each be the same as described with respect to R₃₁,
R₃₂₁ and R₃₂₂ may each be the same as described with respect to R₃₂,
R₃₃₁ to R₃₃₄ may each be the same as described with respect to R₃₃,
R₃₄₁ to R₃₄₄, and R₃₅₁ to R₃₅₄ may each be the same as described with respect to R₁₀ₐ,
R₄₁ to R₄₃ may each be the same as described with respect to R₄, and
two or more adjacent groups selected from among R₁₁ to R₁₅, R₂₁ to R₂₃, R₃₁₁, R₃₁₂, R₃₂₁, R₃₂₂, R₃₃₁ to R₃₃₄, R₃₄₁ to R₃₄₄, R₃₅₁ to R₃₅₄, R₄₁ to R₄₃, R₁ₐ, and R_{1b} may optionally be bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

The organometallic compound represented by Formula 1 includes an indolocarbazole-based moiety formed by ring CY₃₁ to ring CY₃₃ within the molecule. Accordingly, intramolecular charge transfer may be facilitated, and thus when the organometallic compound is utilized in a light-emitting device, the driving voltage of the light-emitting device may be decreased. In one or more embodiments, in the organometallic compound represented by Formula 1, an indolocarbazole-based moiety formed by ring CY₃₁ to ring CY₃₃ may form a ring together with ring CY₄ by linker L₃₁ and linker L₃₂, thereby increasing molecular rigidity and decreasing molecular vibration, which increases an energy gap between a molecular emission energy level (for example, T₁ energy level) and a molecular quenching energy level (for example, ³MC energy level) of the organometallic compound; as a result, the photoluminescence quantum yield (PLQY) and molecular stability of the organometallic compound increases. Therefore, by utilizing the organic metal compound represented by Formula 1, an electronic device (for example, an organic light-emitting device) with reduced driving voltage, improved color purity and efficiency, and increased lifespan may be implemented.

### Description of other formulae

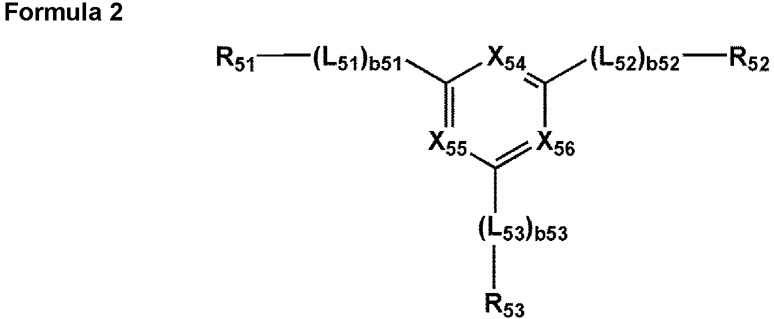

L₅₁ to L₅₃ in Formula 2 may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ.

b51 to b53 in Formula 2 indicate the number of L₅₁ to the number of L₅₃, respectively, and may each be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In some embodiments, b51 to b53 may each independently be 1 or 2.

In one or more embodiments, L₅₁ to L₅₃ in Formula 2 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodisiline group, a dibenzodihydrosiline group, a dibenzodioxane group, a dibenzoxathiene group, a dibenzoxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formula 2, a bond between L₅₁ and R₅₁, a bond between L₅₂ and R₅₂, a bond between L₅₃ and R₅₃, a bond between two L₅₁ (s), a bond between two L₅₂(s), a bond between two L₅₃(s), a bond between L₅₁ and carbon between X₅₄ and X₅₅ in Formula 2, a bond between L₅₂ and carbon between X₅₄ and X₅₆ in Formula 2, and a bond between L₅₃ and carbon between X₅₅ and X₅₆ in Formula 2 may each be a "carbon-carbon single bond."

In Formula 2, X₅₄ may be N or C(R₅₄), X₅₅ may be N or C(R₅₅), X₅₆ may be N or C(R₅₆), and at least one selected from among X₅₄ to X₅₆ may be N. R₅₄ to R₅₆ may each independently be the same as described herein. In one or more embodiments, two or three selected from among X₅₄ to X₅₆ may be N.

R₅₁ to R₅₆ in Formula 2 may each independently be hydrogen, deuterium, -F, - Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

In one or more embodiments, R₅₁ to R₅₆ in Formula 2 may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium -F,-Cl,-Br,-I,-CD₃,-CD₂H,-CDH₂,-CF₃,-CF₂H,-CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O (Q₃₁), -S(Q₃₁), -Si(Q₃₁)(Q₃₂)(Q₃₃), -N(Q₃₁)(Q₃₂), -B(Q₃₁)(Q₃₂),-P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 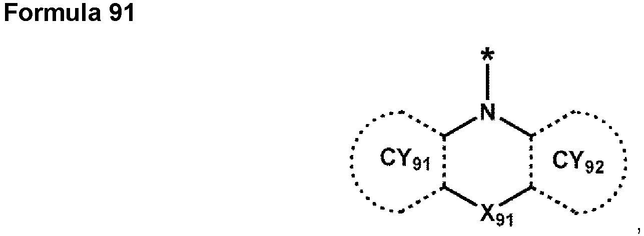 wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
   X₉₁ may be a single bond, O, S, N(R₉₁), B(R₉₁), C(R₉₁ₐ)(R_{91b}), or Si(R91a)(R91b),
   R₉₁, R₉₁ₐ, and R_{91b} may be the same as described with respect to R₈₂, R₈₂ₐ, and R_{82b}, respectively,
   R₁₀ₐ may be the same as described herein, and
   * indicates a binding site to a neighboring atom.

For example, in one or more embodiments, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, a group represented by *-(L₅₁)_{b51}-R₅₁ and a group represented by *-(L₅₂)_{b52}-R₅₂ in Formula 2 may each not be a phenyl group.

In one or more embodiments, a group represented by *-(L₅₁)_{b51}-R₅₁ and a group represented by *-(L₅₂)_{b52}-R₅₂ in Formula 2 may be identical to each other.

In one or more embodiments, a group represented by *-(L₅₁)_{b51}-R₅₁ and a group represented by *-(L₅₂)_{b52}-R₅₂ in Formula 2 may be different from each other.

In one or more embodiments, b51 and b52 in Formula 2 may each be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

In one or more embodiments, R₅₁ and R₅₂ in Formula 2 may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or - Si(Q₁)(Q₂)(Q₃), and
Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments,
a group represented by *-(L₅₁)_{b51}-R₅₁ in Formula 2 may be a group represented by one selected from among Formulae CY51-1 to CY51-26, and/or
a group represented by *-(L₅₂)_{b52}-R₅₂ in Formula 2 may be a group represented by one selected from among Formulae CY52-1 to CY52-26, and/or
a group represented by *-(L₅₃)_{b53}-R₅₃ in Formula 2 may be a group represented by one selected from among Formulae CY53-1 to CY53-27, - C(Q₁)(Q₂)(Q₃), or -Si(Q₁)(Q₂)(Q₃): 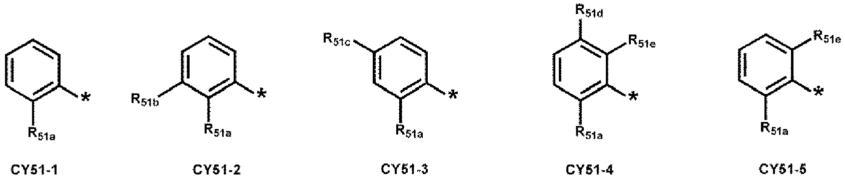 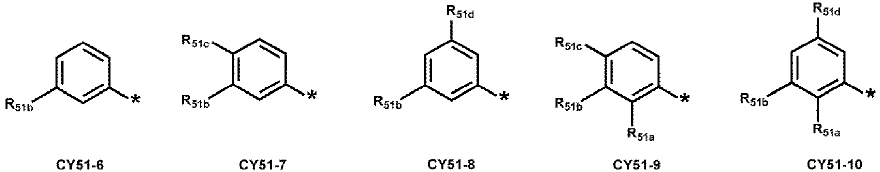 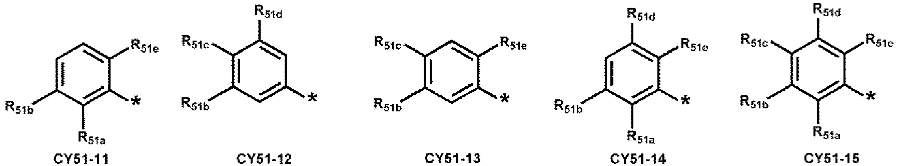 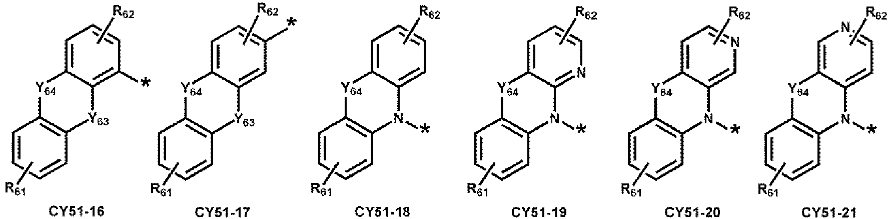 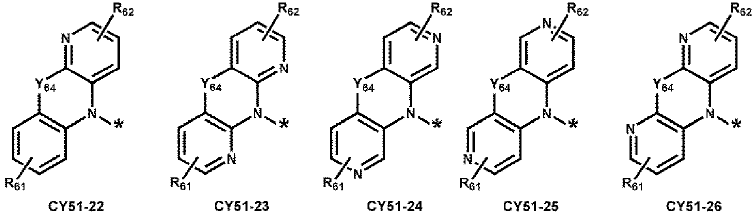 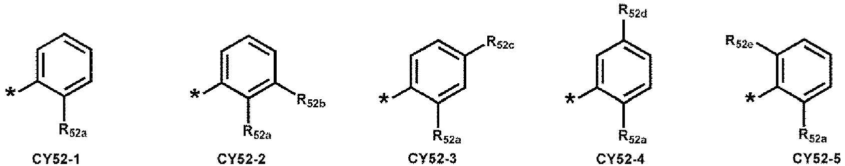 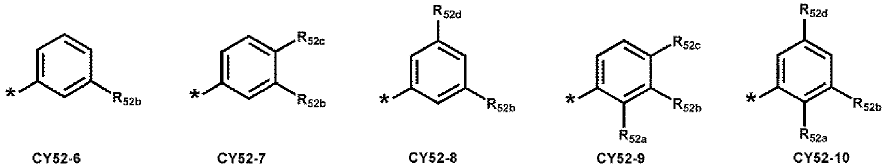 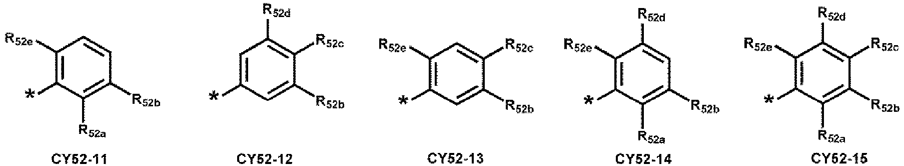 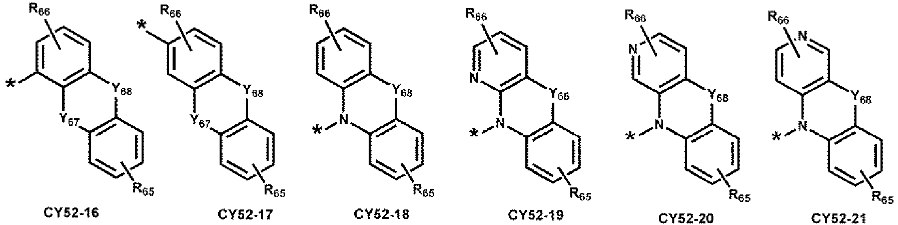 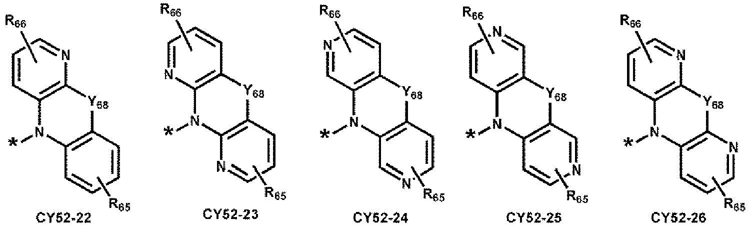 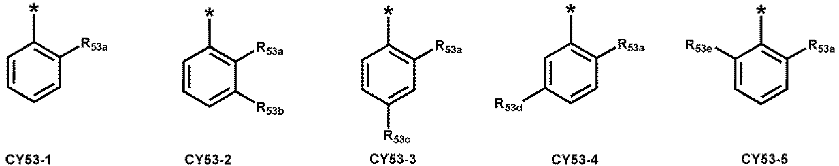 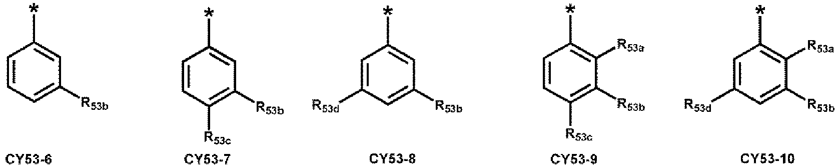 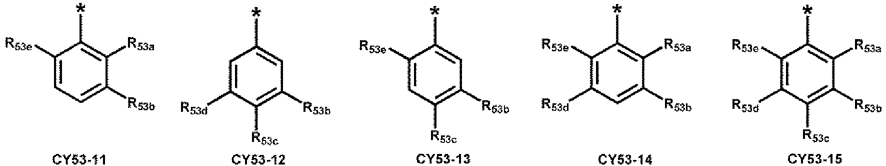 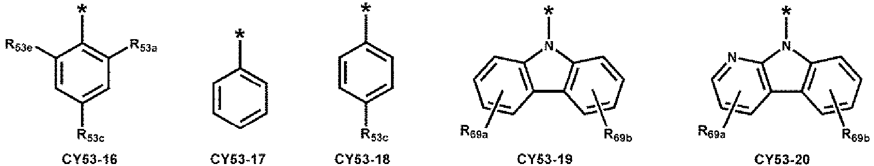 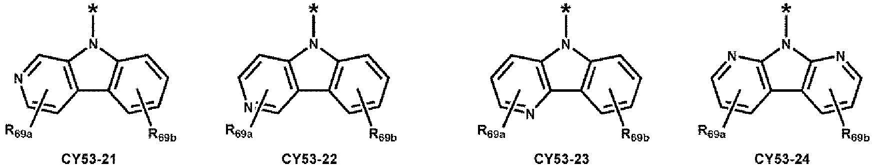 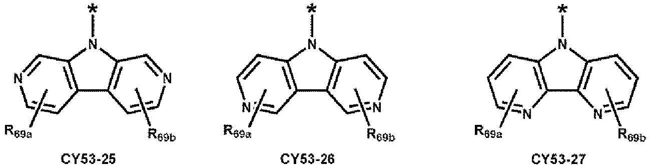
wherein, in Formulae CY51-1 to CY51-26, CY52-1 to CY52-26, and CY53-1 to CY53-27,
Y₆₃ may be a single bond, O, S, N(R₆₃), B(R₆₃), C(R₆₃ₐ)(R_{63b}), or Si(R63a)(R63b),
Y₆₄ may be a single bond, O, S, N(R₆₄), B(R₆₄), C(R₆₄ₐ)(R_{64b}), or Si(R64a)(R64b),
Y₆₇ may be a single bond, O, S, N(R₆₇), B(R₆₇), C(R₆₇ₐ)(R_{67b}), or Si(R67a)(R67b),
Y₆₈ may be a single bond, O, S, N(R₆₈), B(R₆₈), C(R₆₈ₐ)(R_{68b}), or Si(R₆₈ₐ)(R_{68b}),
each of Y₆₃ and Y₆₄ in Formulae CY51-16 and CY51-17 may not be a single bond at the same time,
each of Y₆₇ and Y₆₈ in Formulae CY52-16 and CY52-17 may not be a single bond at the same time,
R₅₁ₐ to R₅₁ₑ, R₆₁ to R₆₄, R₆₃ₐ, R_{63b}, R₆₄ₐ, and R_{64b} may each be understood by referring to the description of R₅₁, and R₅₁ₐ to R₅₁ₑ may not each be hydrogen,
R₅₂ₐ to R₅₂ₑ, R₆₅ to R₆₈, R₆₇ₐ, R_{67b}, R₆₈ₐ, and R_{68b} may each be understood by referring to the description of R₅₂, and R₅₂ₐ to R₅₂ₑ may not each be hydrogen,
R₅₃ₐ to R₅₃ₑ, R₆₉ₐ, and R_{69b} may each be understood by referring to the description of R₅₃, and R₅₃ₐ to R₅₃ₑ may not each be hydrogen, and
* indicates a binding site to a neighboring atom.

For example, in one or more embodiments,
in Formulae CY51-1 to CY51-26 and Formulae CY52-1 to 52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C(Q₁)(Q₂)(Q₃) or -Si(Q₁)(Q₂)(Q₃),
wherein Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof,
in Formulae CY51-16 and CY51-17, i) Y₆₃ may be O or S and Y₆₄ may be Si(R₆₄ₐ)(R_{64b}), or ii) Y₆₃ may be Si(R₆₃ₐ)(R_{63b}) and Y₆₄ may be O or S, and
in Formulae CY52-16 and CY52-17, i) Y₆₇ may be O or S, and Y₆₈ may be Si(R₆₈ₐ)(R_{68b}), or ii) Y₆₇ may be Si(R₆₇ₐ)(R_{67b}), and Y₆₈ may be O or S. 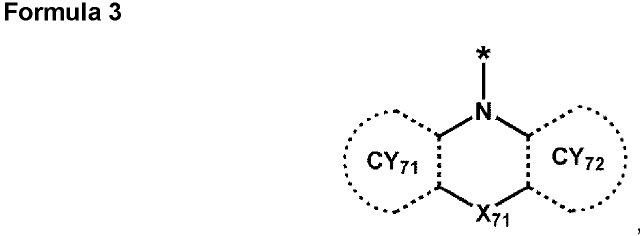
wherein ring CY₇₁ and ring CY₇₂ in Formula 3 may each independently be a π electron-rich C₃-C₆₀ cyclic group or a pyridine group.
X₇₁ in Formula 3 may be a single bond or a linking group including O, S, N, B, C, Si, or any combination thereof.
* in Formula 3 indicates a binding site to any atom included in the remaining part other than the group represented by Formula 3 in the third compound. 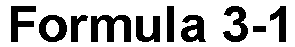 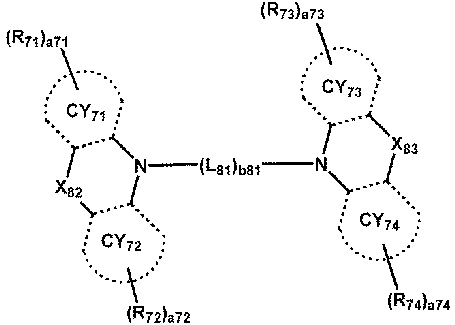 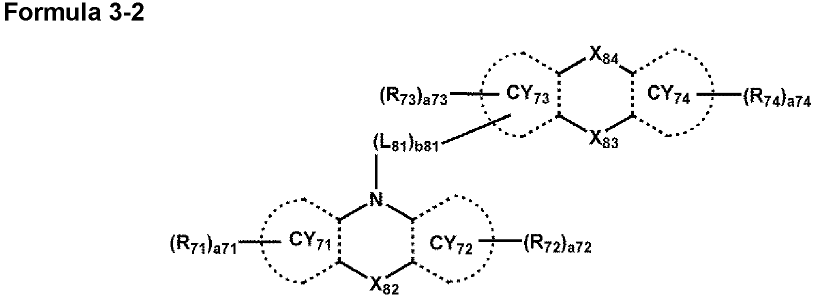 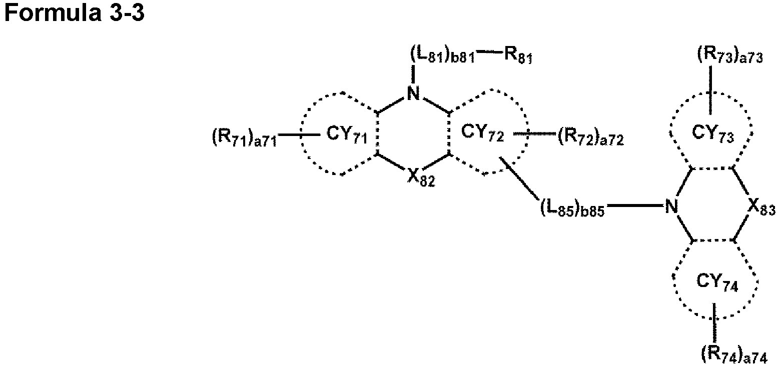 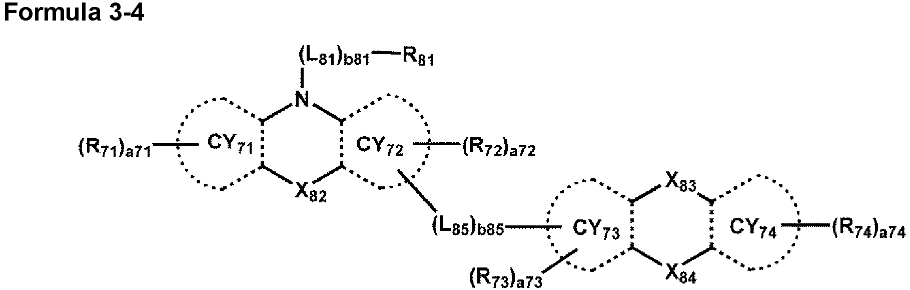 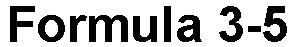 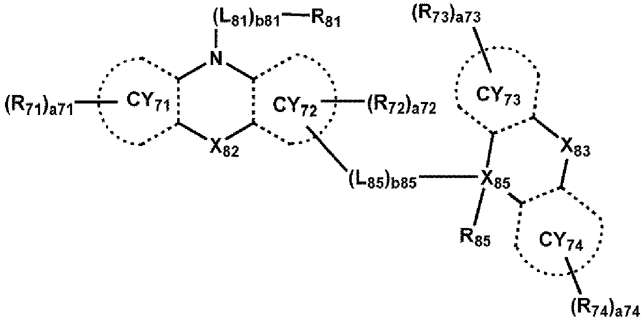
Ring CY71 to ring CY74 in Formulae 3-1 to 3-5 may each independently be a π electron-rich C₃-C₆₀ cyclic group or a pyridine group.
X₈₂ in Formulae 3-1 to 3-5 may be a single bond, O, S, N[(L₈₂)_{b82}-R₈₂], C(R₈₂ₐ)(R_{82b}), or Si(R₈₂ₐ)(R_{82b}).
X₈₃ in Formulae 3-1 to 3-5 may be a single bond, O, S, N[(L₈₃)_{b83}-R₈₃], C(R83a)(R83b), or Si(R₈₃ₐ)(R_{83b}).
X₈₄ in Formulae 3-1 to 3-5 may be O, S, N[(L₈₄)_{b84}-R₈₄], C(R₈₄ₐ)(R_{84b}), or Si(R84a)(R84b).
X₈₅ in Formulae 3-1 to 3-5 may be C or Si.
L₈₁ to L₈₅ in Formulae 3-1 to 3-5 may each independently be a single bond, *-C(Q₄)(Q₅)-*', *-Si(Q₄)(Q₅)-*', a π electron-rich C₃-C₆₀ cyclic group that is unsubstituted or substituted with at least one R₁₀ₐ, or a pyridine group that is unsubstituted or substituted with at least one R₁₀ₐ.
Q₄ and Q₅ may each be the same as described with respect to Q₁.
b81 to b85 in Formulae 3-1 to 3-5 may each independently be an integer from 1 to 5.
R₇₁ to R₇₄, R₈₁ to R₈₅, R₈₂ₐ, R_{82b}, R₈₃ₐ, R_{83b}, R₈₄ₐ, and R_{84b} may each be the same as described herein.
a71 to a74 in Formulae 3-1 to 3-5 represents the number of R₇₁ to the number of R₇₄, respectively, and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. In some embodiments, a71 to a74 may each independently be an integer from 0 to 8.
R₁₀ₐ may be the same as described herein.

In one or more embodiments, in Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), - B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 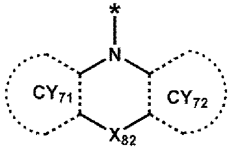 in Formulae 3-1 and 3-2 may be a group represented by one selected from among Formulae CY71-1(1) to CY71-1(8), and/or
a group represented by 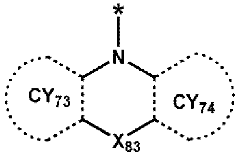 in Formulae 3-1 and 3-3 may be a group represented by one selected from among Formulae CY71-2(1) to CY71-2(8), and/or
a group represented by 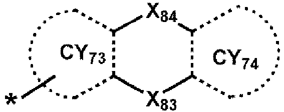 in Formulae 3-2 and 3-4 may be a group represented by one selected from among Formulae CY71-3(1) to CY71-3(32), and/or
a group represented by 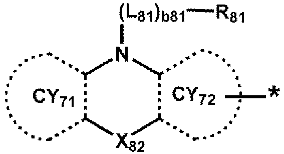 in Formulae 3-3 to 3-5 may be a group represented by one selected from among Formulae CY71-4(1) to CY71-4(32), and/or
a group represented by 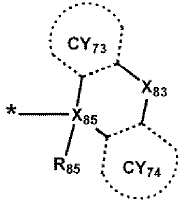 in Formula 3-5 may be a group represented by one selected from among Formulae CY71-5(1) to CY71-5(8): 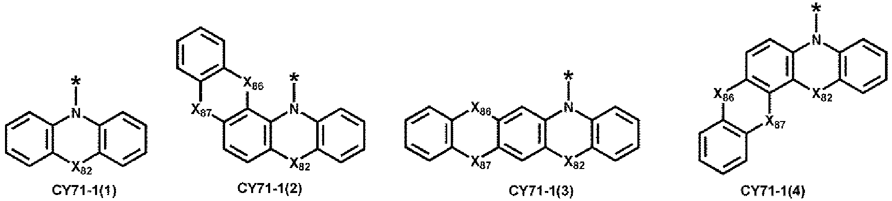 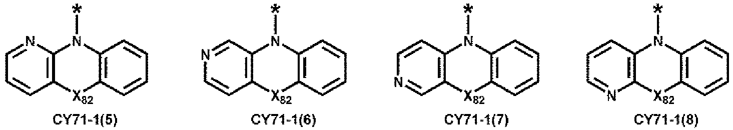 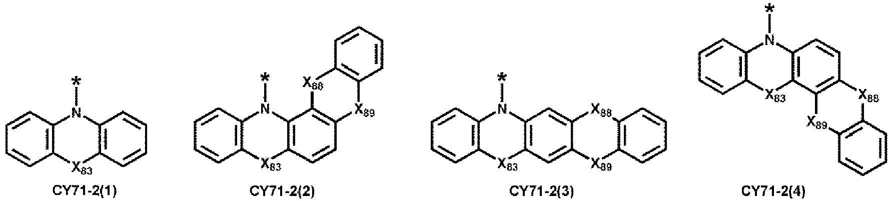 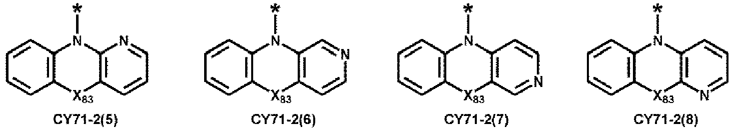 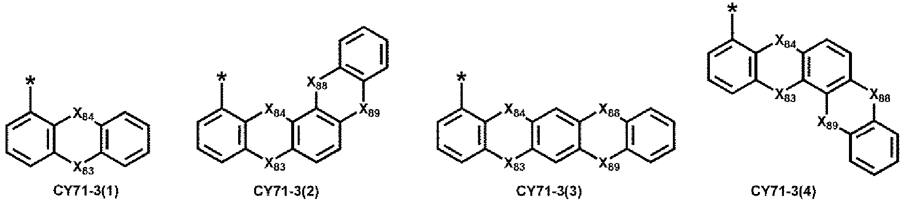 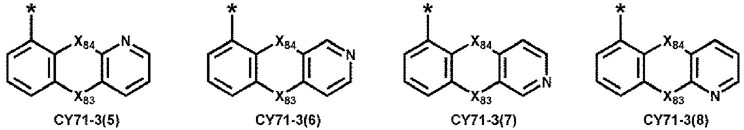 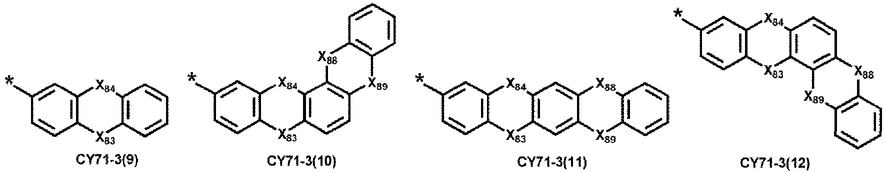 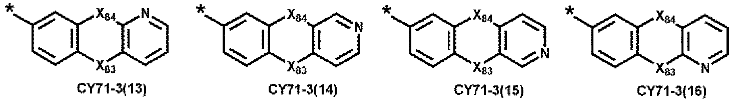 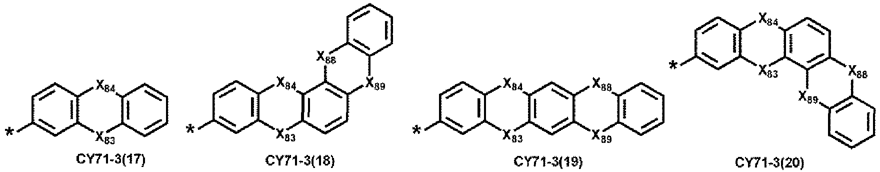 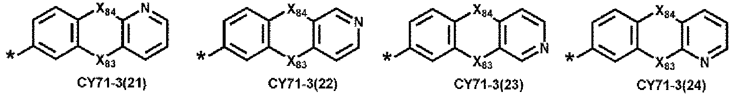 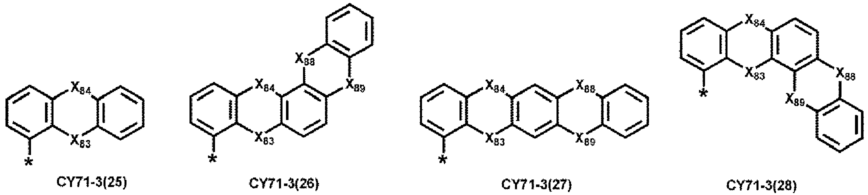 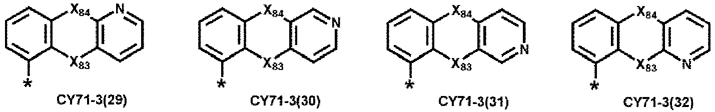 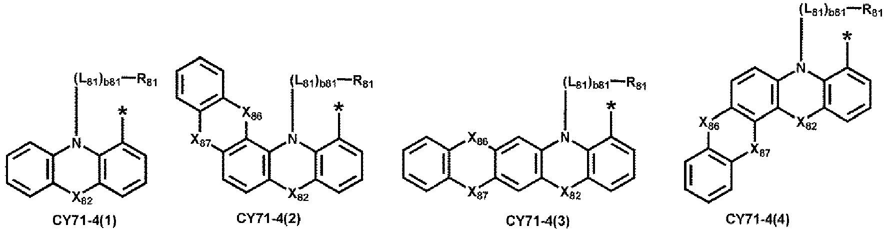 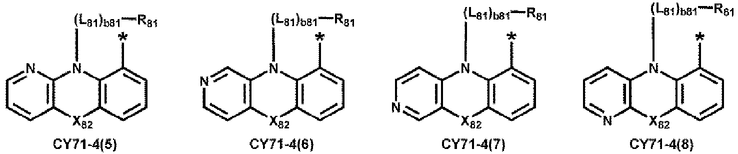 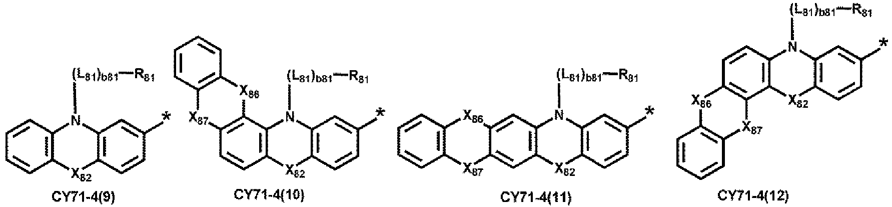 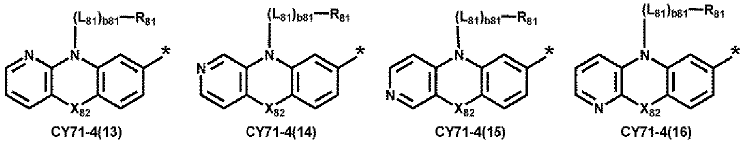 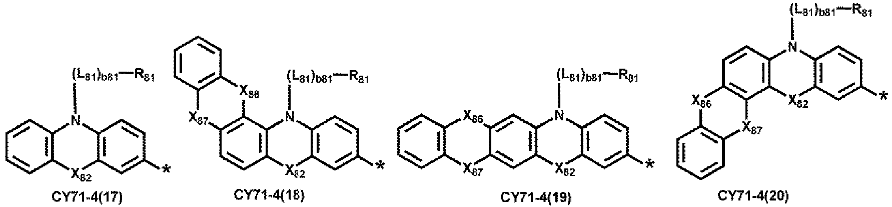 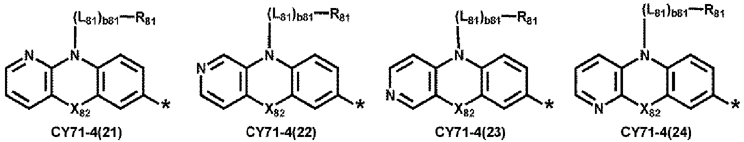 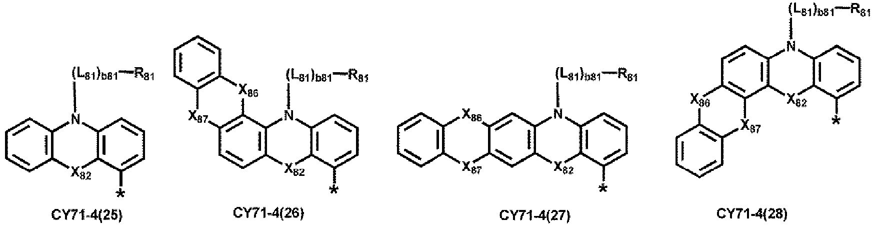 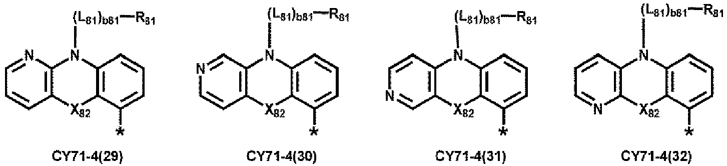 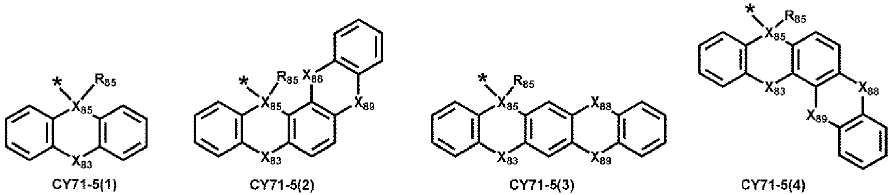 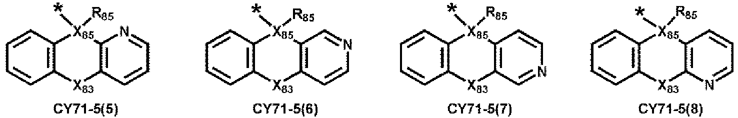
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R86a)(R86b),
X₈₇ may be a single bond, O, S, N(R₈₇), B(R₈₇), C(R₈₇ₐ)(R_{87b}), or Si(R87a)(R87b),
in Formulae CY71-1(1) to CY71-1(8) and CY71-4(1) to CY71-4(32), each of X₈₆ and X₈₇ may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
each of X₈₈ and X₈₉ in Formulae CY71-2(1) to CY71-2(8), CY71-3(1) to CY71-3(32), and CY71-5(1) to CY71-5(8) may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described with respect to R₈₁. 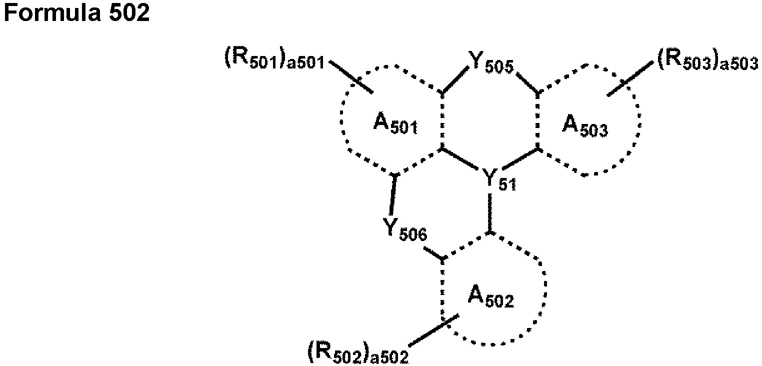 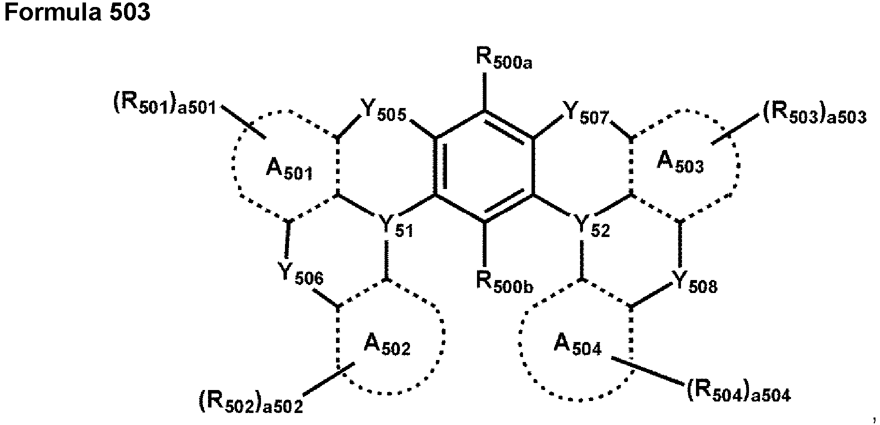
ring A₅₀₁ to ring A₅₀₄ in Formulae 502 and 503 may each independently be a C₃-C₆₀ carbocyclic group or a C₁-C₆₀ heterocyclic group.

Y₅₀₅ in Formulae 502 and 503 may be O, S, N(R₅₀₅), B(R₅₀₅), C(R₅₀₅ₐ)(R_{505b}), or Si(R₅₀₅ₐ)(R_{505b}).

Y₅₀₆ in Formulae 502 and 503 may be O, S, N(R₆₀₆), B(R₅₀₆), C(R₆₀₆ₐ)(R_{606b}), or Si(R₅₀₆ₐ)(R_{506b}).

Y₅₀₇ in Formula 503 may be O, S, N(R₅₀₇), B(R₅₀₇), C(R₅₀₇ₐ)(R_{507b}), or Si(R507a)(R507b).

Y₅₀₈ in Formula 503 may be O, S, N(R₅₀₈), B(R₅₀₈), C(R₅₀₈ₐ)(R_{508b}), or Si(R508a)(R508b).

Y₅₁ and Y₅₂ in Formulae 502 and 503 may each independently be B, P(=O), or S(=O).

R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 502 and 503 may be the same as described herein.

a501 to a504 in Formulae 502 and 503 each indicate the number of R₅₀₁ to the number of R₅₀₄, respectively, and may each independently be an integer from 0 to 20. When a501 may be 2 or more, two or more of R₅₀₁(s) may be the same or different from each other, when a502 may be 2 or more, two or more of R₅₀₂(s) may be the same or different from each other, when a503 may be 2 or more, two or more of R₅₀₃(s) may be the same or different from each other, and when a504 may be 2 or more, two or more of R₅₀₄(s) may be the same or different from each other. In some embodiments, a501 to a504 may each independently be an integer from 0 to 8.

R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in the present disclosure may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

In one or more embodiments, i) R₅₁ to R₅₆, R₇₁ to R₇₄, R₈₁ to R₈₅, R₈₂ₐ, R_{82b}, R₈₃ₐ, R_{83b}, R₈₄ₐ, and R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503, and ii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium -F,-Cl,-Br,-I,-CD₃,-CD₂H,-CDH₂,-CF₃,-CF₂H,-CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O (Q₃₁), -S(Q₃₁), -Si(Q₃₁)(Q₃₂)(Q₃₃), -N(Q₃₁)(Q₃₂), -B(Q₃₁)(Q₃₂),-P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) R₁, R₂, R₃₁ to R₃₃, and R₄ in Formula 1, ii) R₅₁ to R₅₆, R₇₁ to R₇₄, R₈₁ to R₈₅, R₈₂ₐ, R_{82b}, R₈₃ₐ, R_{83b}, R₈₄ₐ, and R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503, and iii) R₁₀ₐ may each independently be:
hydrogen, deuterium, -F, a cyano group, a nitro group, -CH₃, -CD₃, -CD₂H, - CDH₂, -CF₃, -CF₂H, -CFH₂;
a group represented by one selected from among Formulae 9-1 to 9-19; and
a group represented by one selected from among Formulae 10-1 to 10-246, - C(Q₁)(Q₂)(Q₃), -Si(Q₁)(Q₂)(Q₃), or -P(=O)(Q₁)( Q₂) (Q₁ to Q₃ may each independently be the same as described herein):

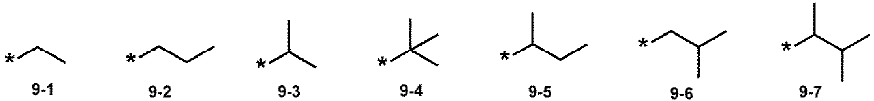

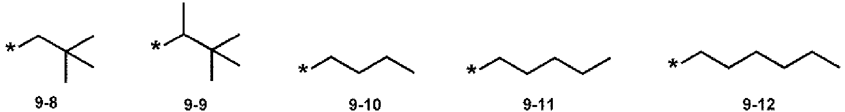

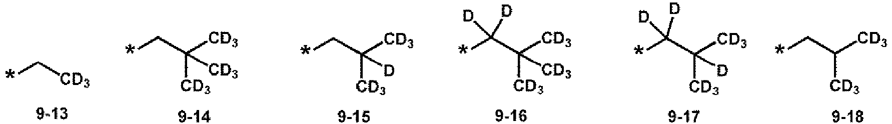

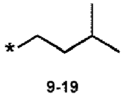

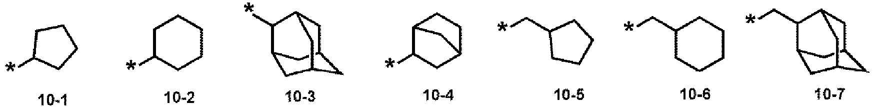

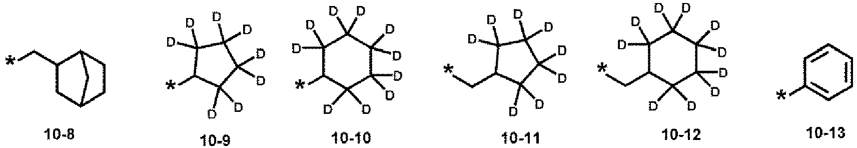

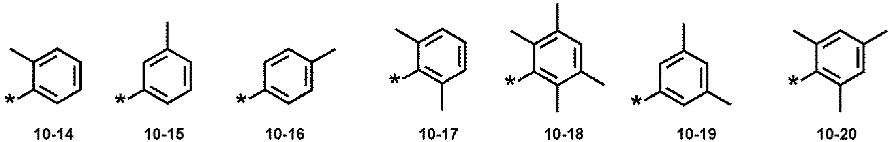

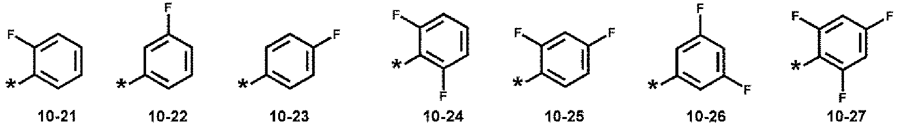

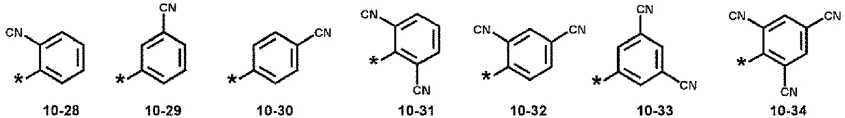

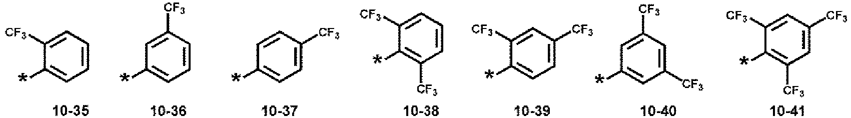

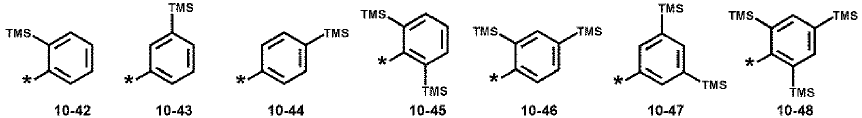

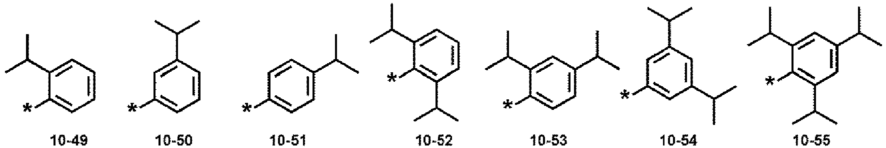

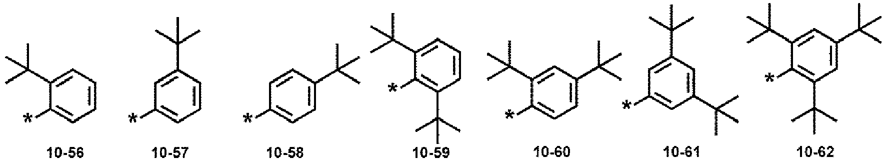

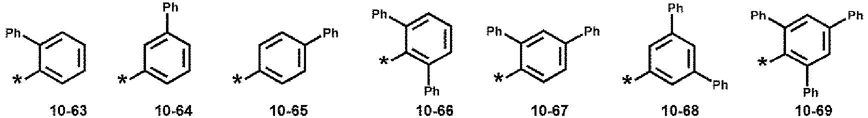

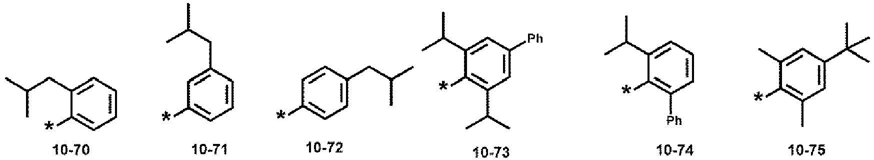

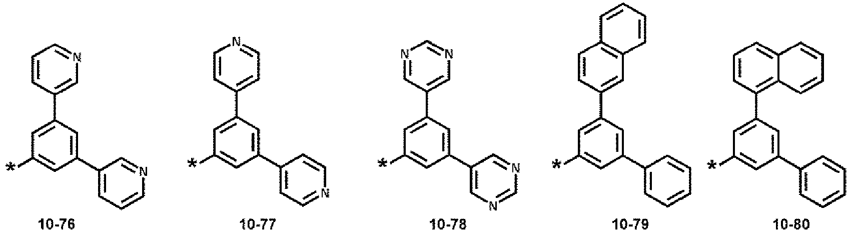

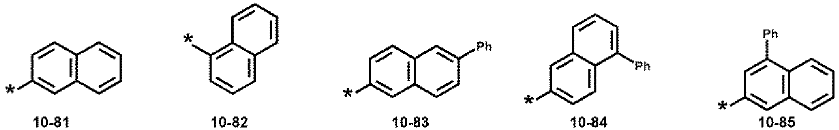

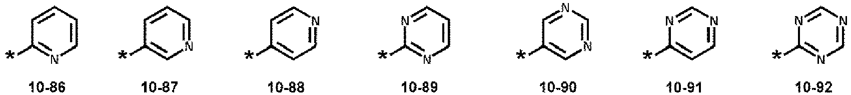

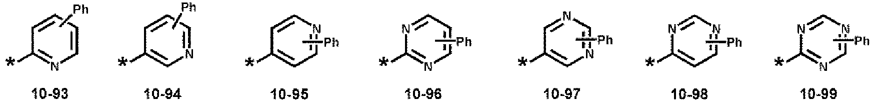

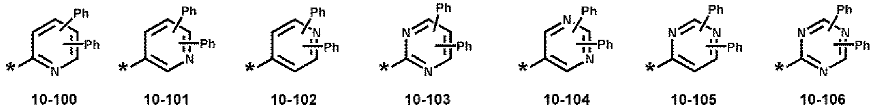

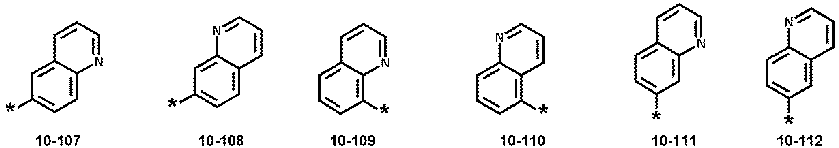

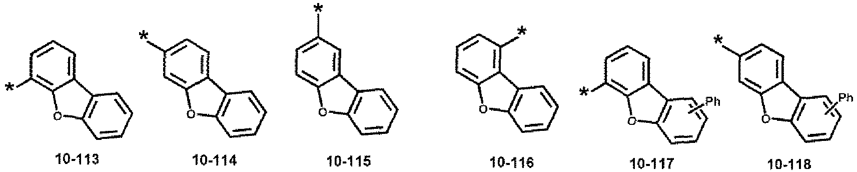

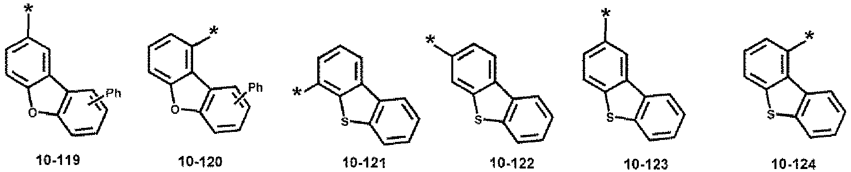

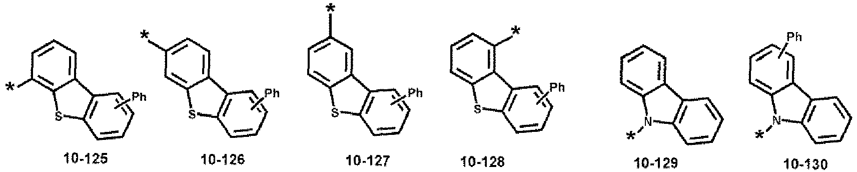

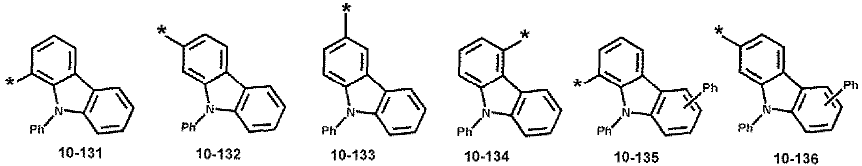

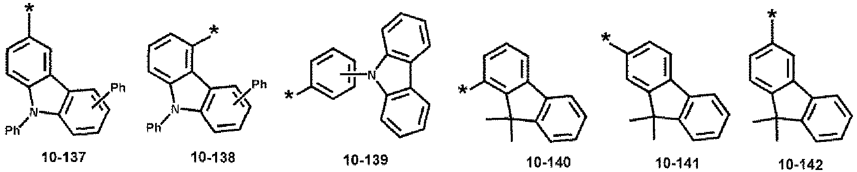

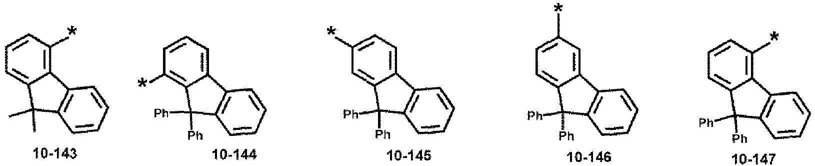

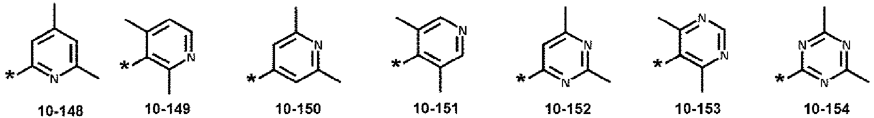

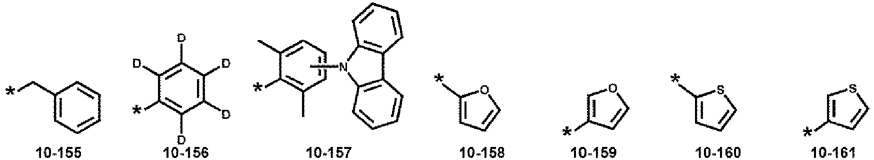

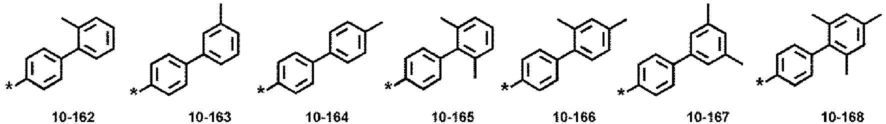

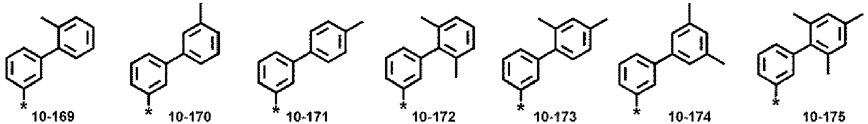

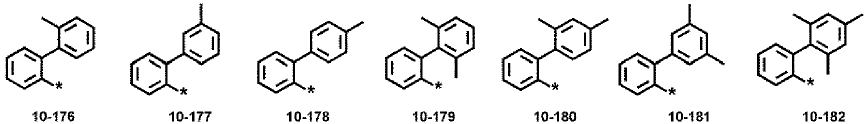

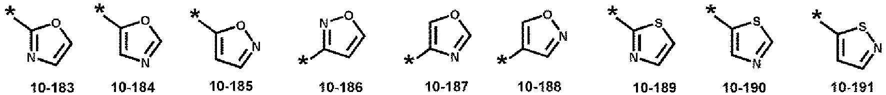

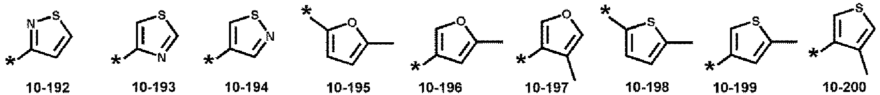

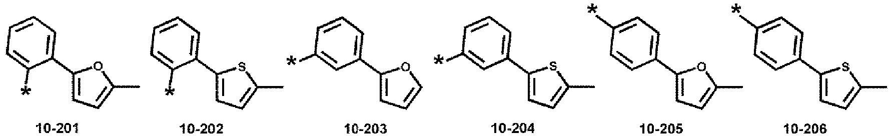

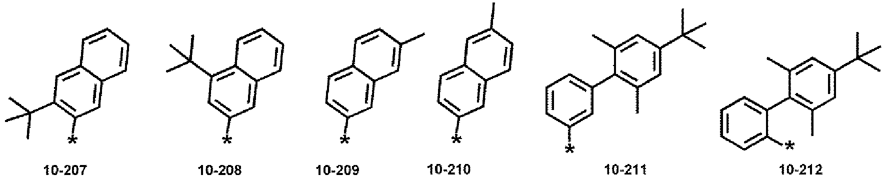

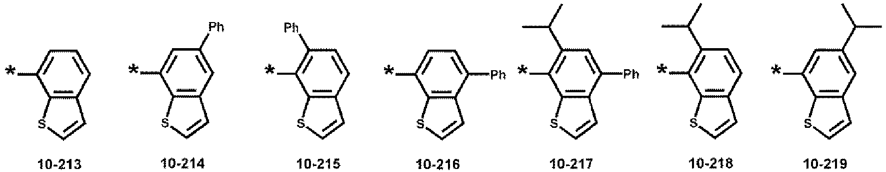

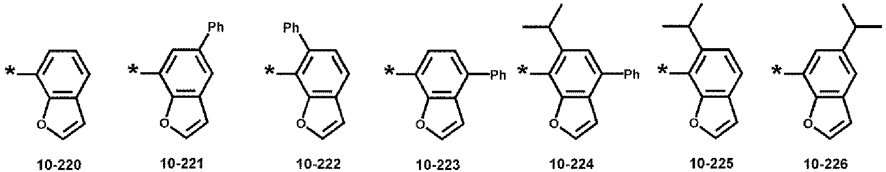

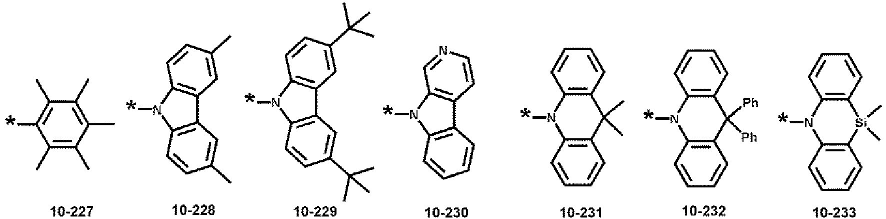

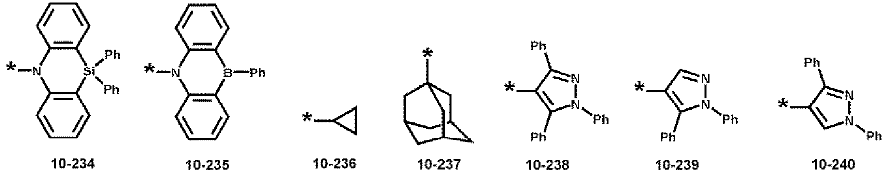

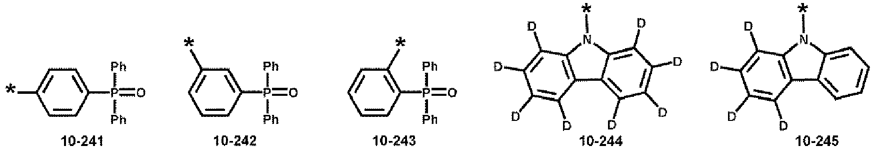

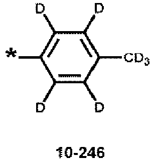

In Formulae 9-1 to 9-19 and 10-1 to 10-246, * indicates a binding site to a neighboring atom, "Ph" represents a phenyl group, "D" represents deuterium, and "TMS" represents a trimethylsilyl group.

### Examples of compounds

In one or more embodiments, the organometallic compound represented by Formula 1 may be one selected from among Compounds 1 to 120:

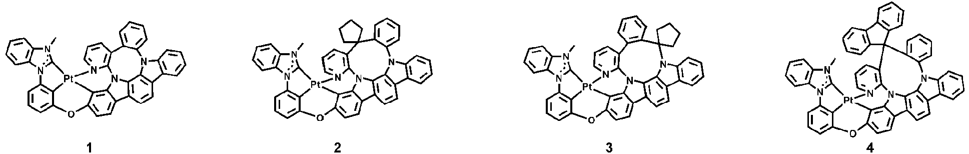

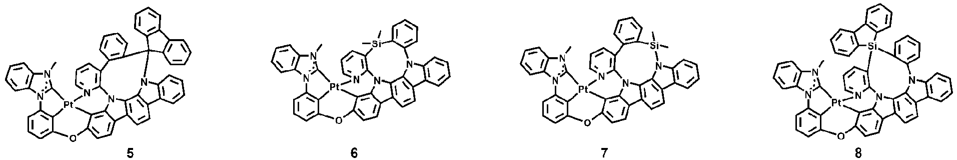

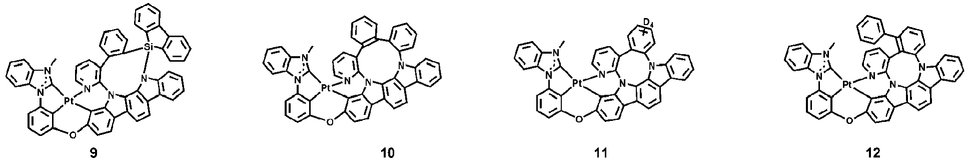

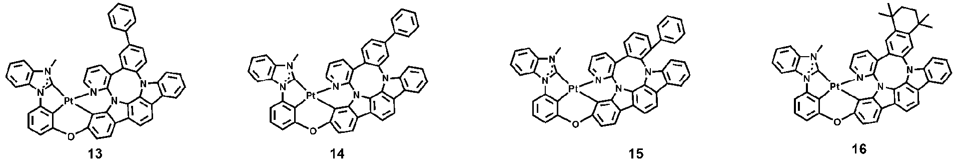

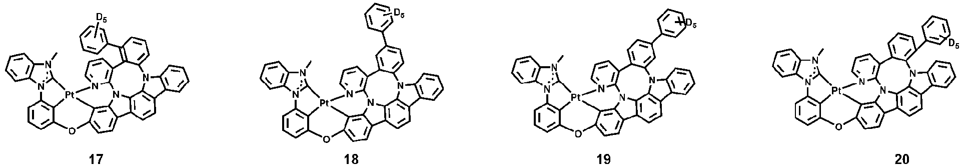

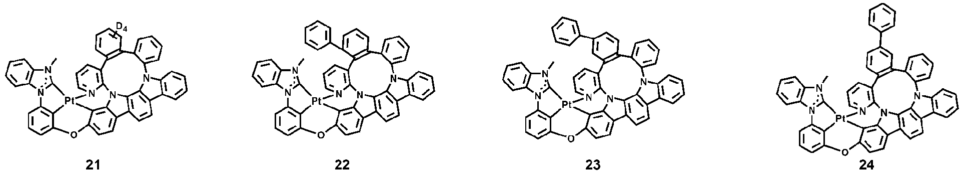

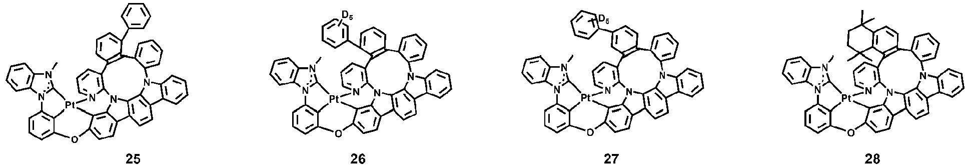

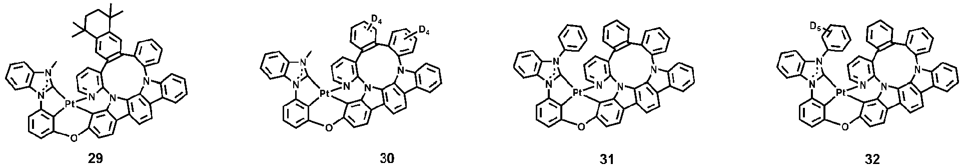

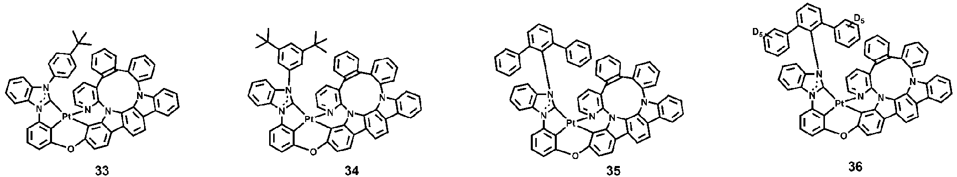

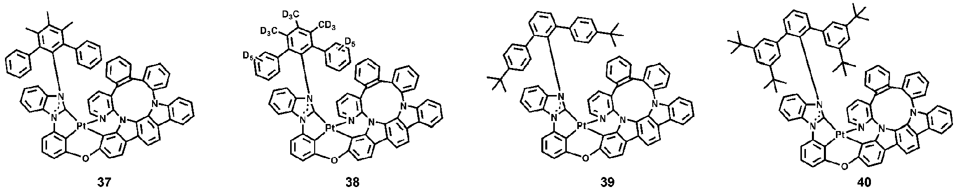

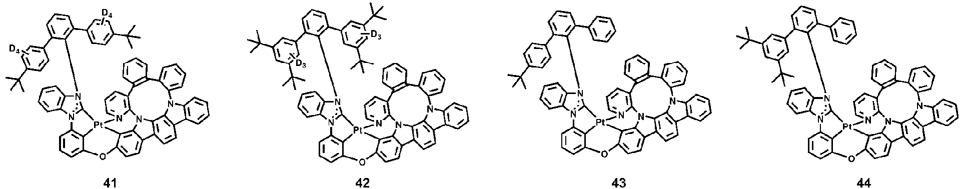

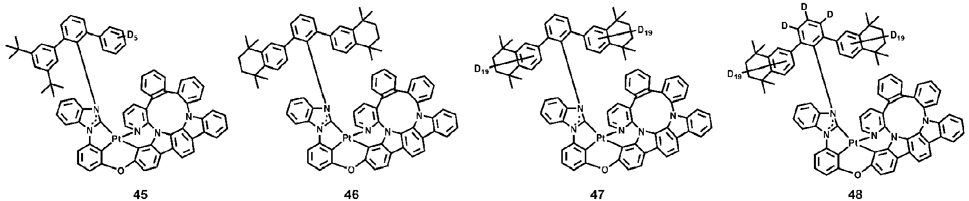

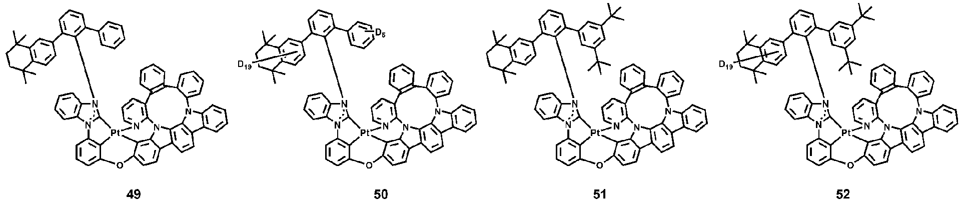

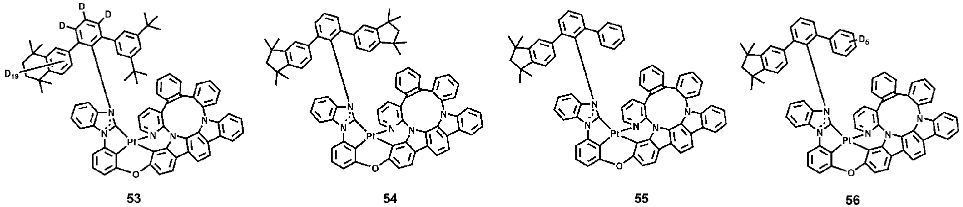

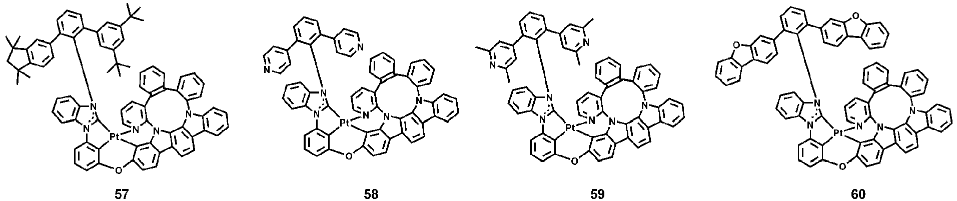

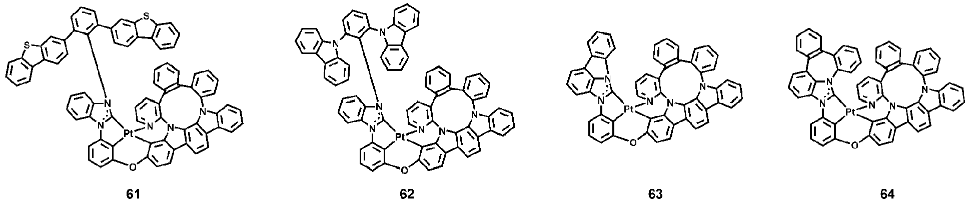

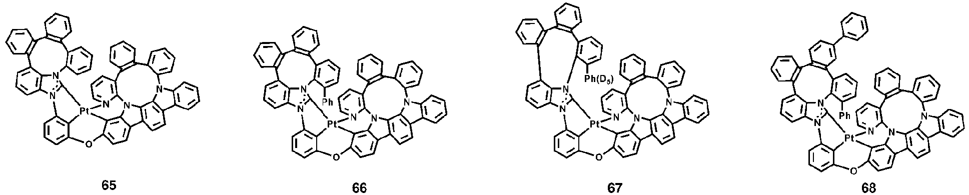

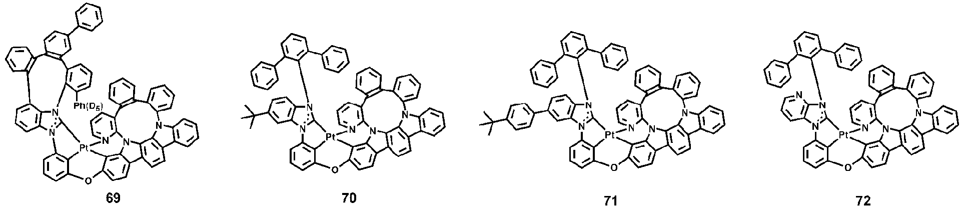

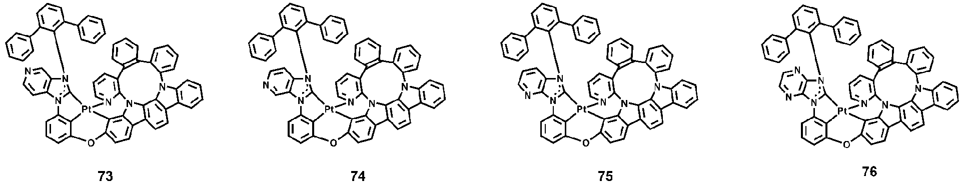

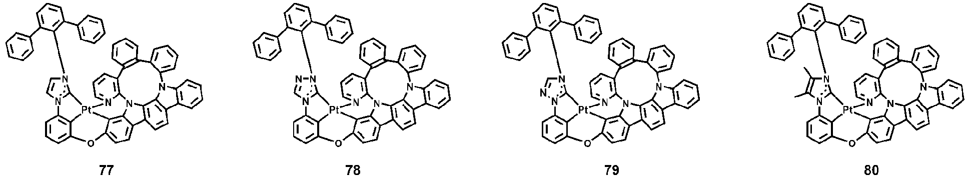

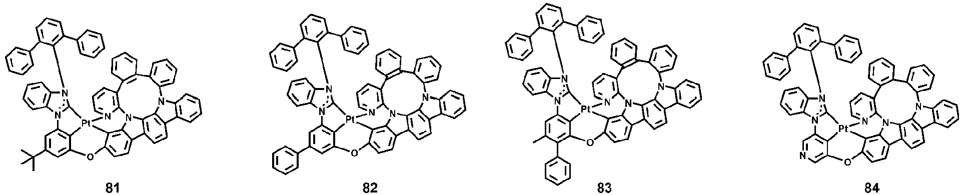

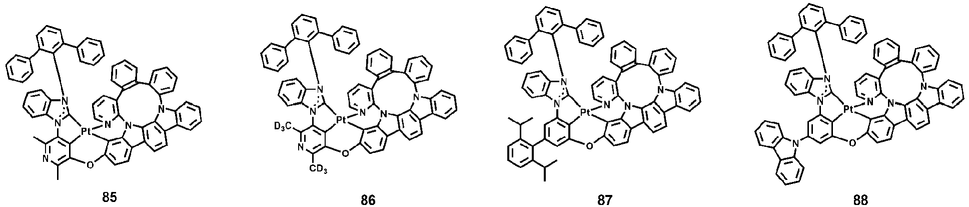

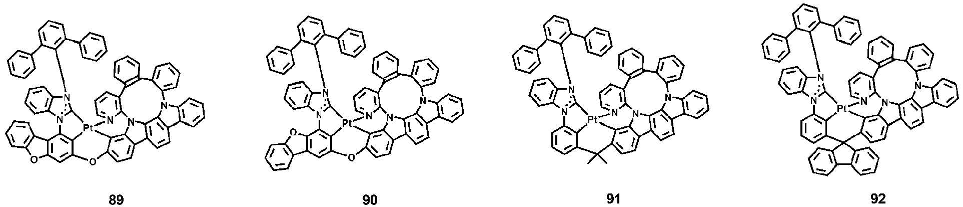

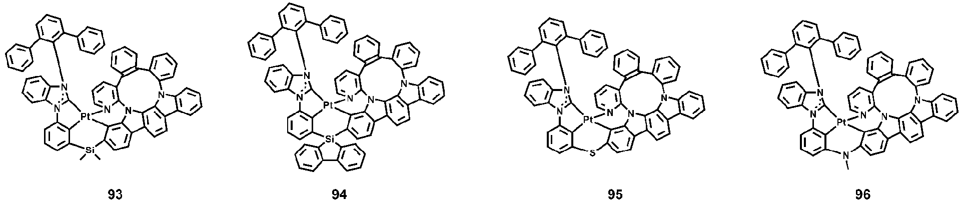

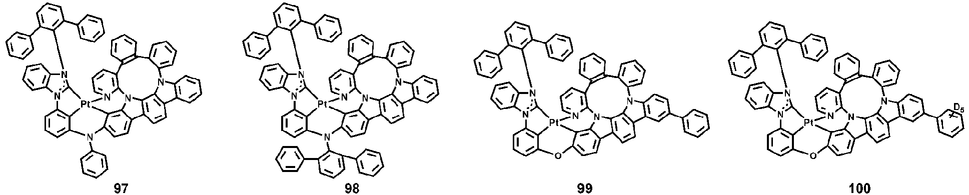

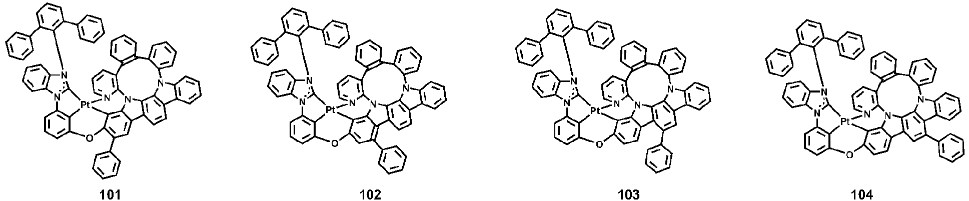

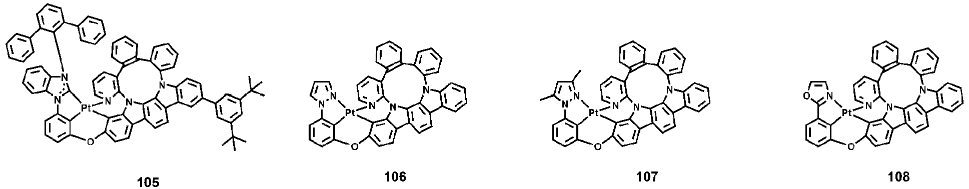

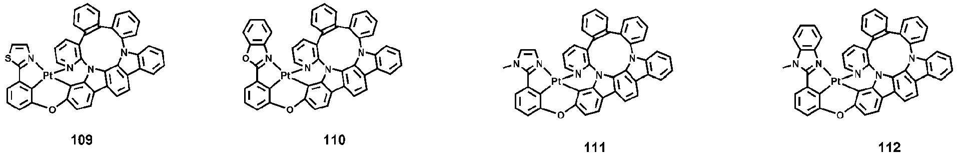

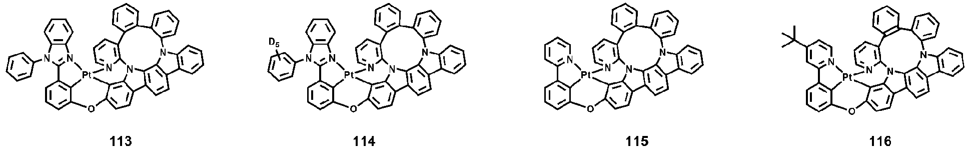

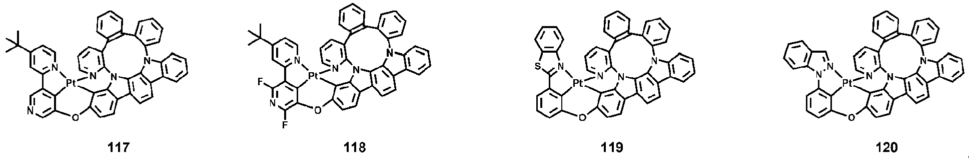

For example, in one or more embodiments, the second compound may be at least one selected from among Compounds ETH1 to ETH32:

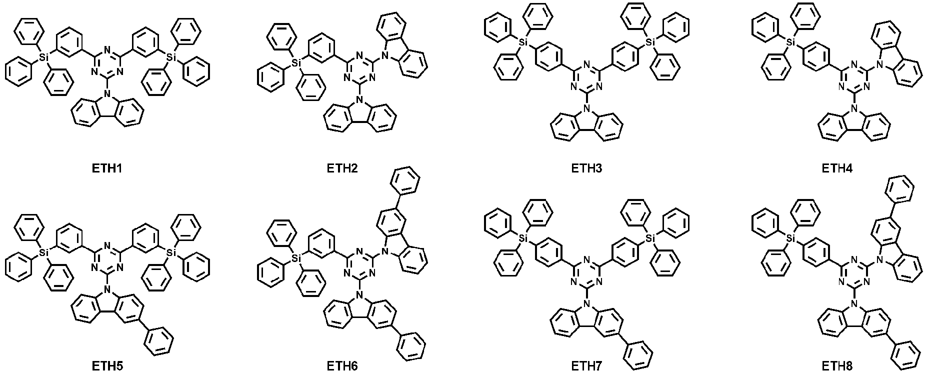

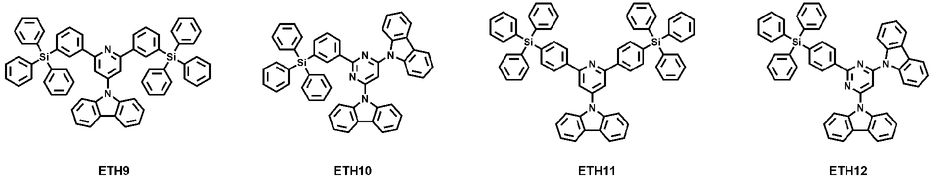

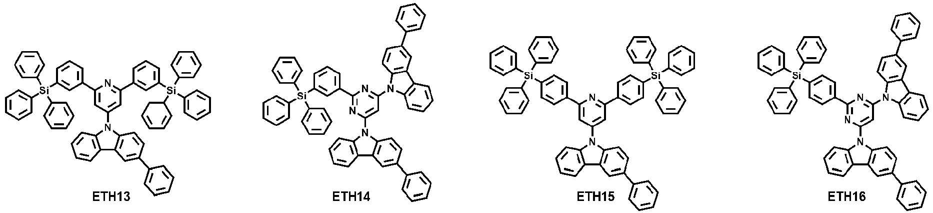

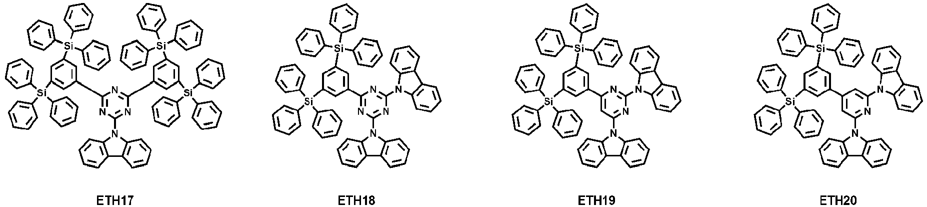

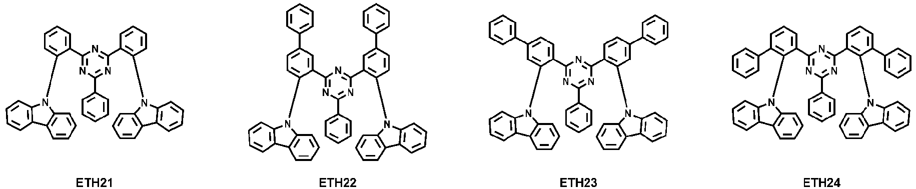

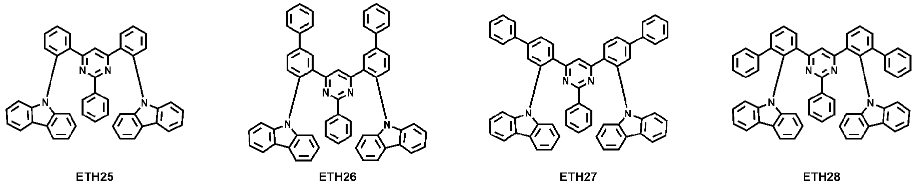

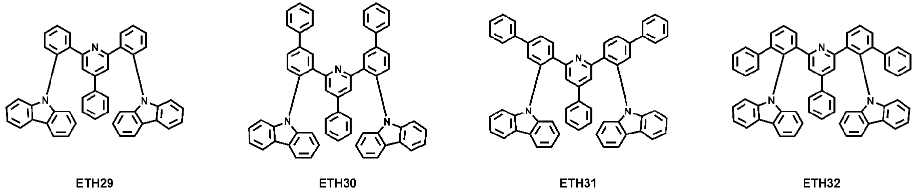

For example, in one or more embodiments, the third compound may be at least one selected from among Compounds HTH1 to HTH40:

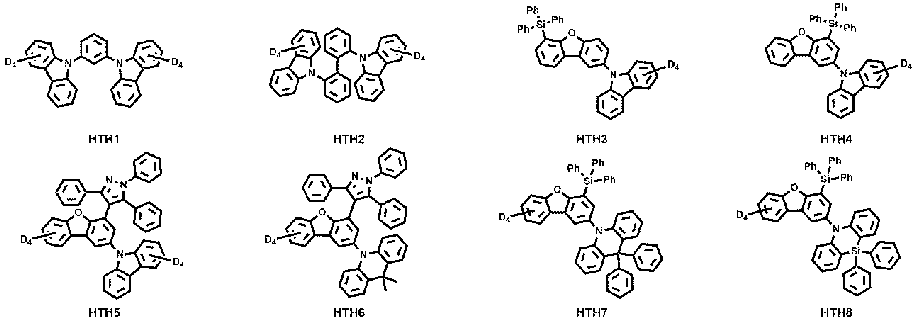

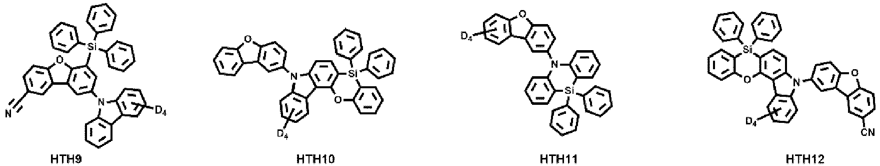

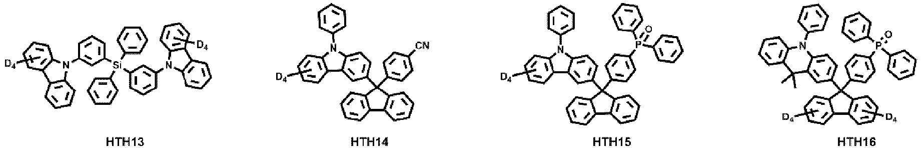

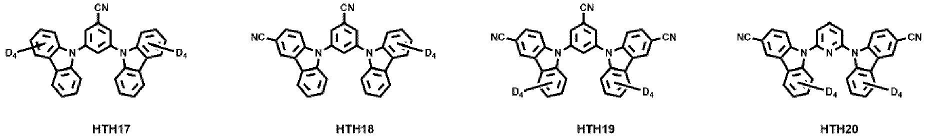

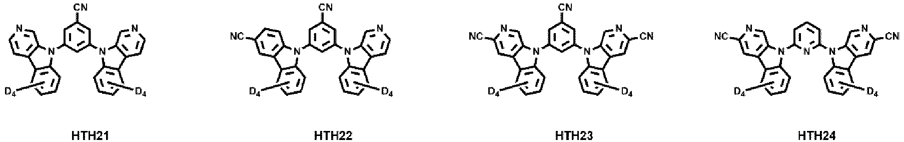

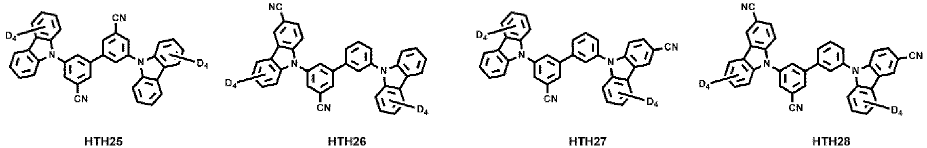

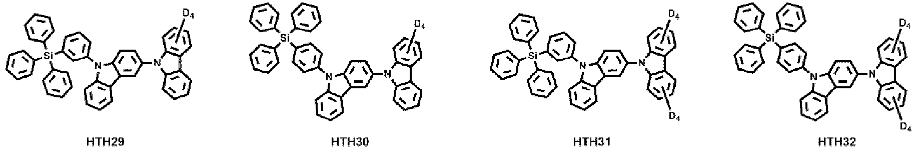

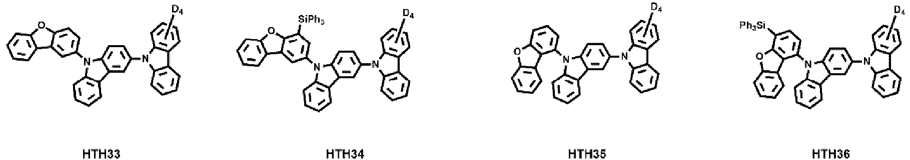

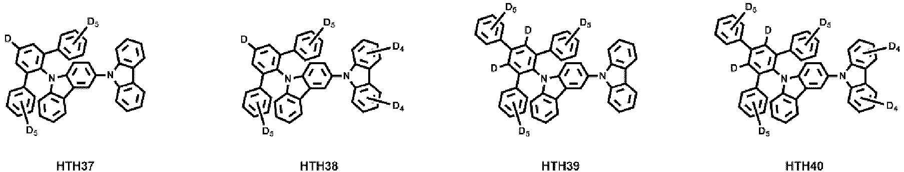

For example, in one or more embodiments, the fourth compound may be at least one selected from among Compounds DFD1 to DFD29:

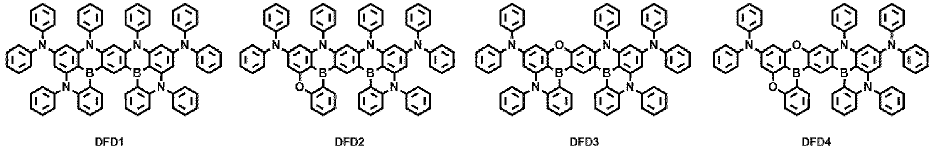

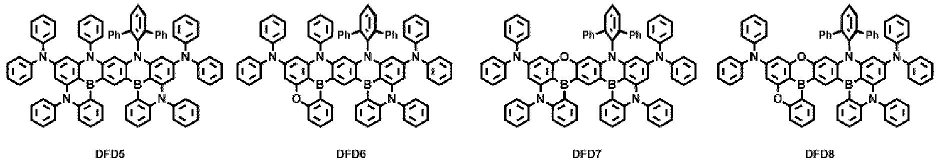

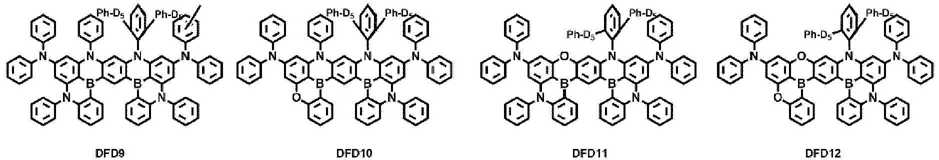

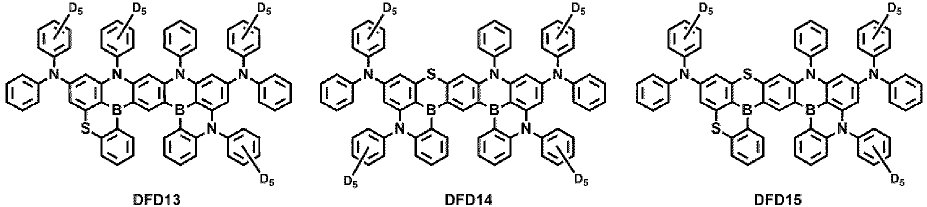

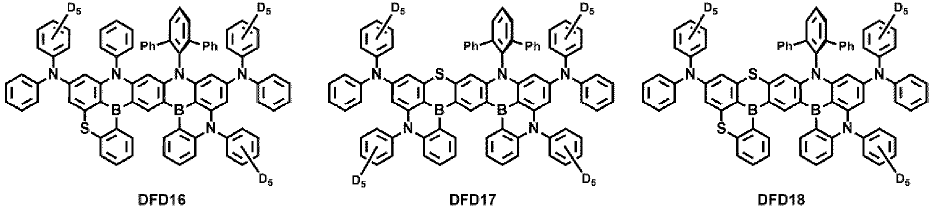

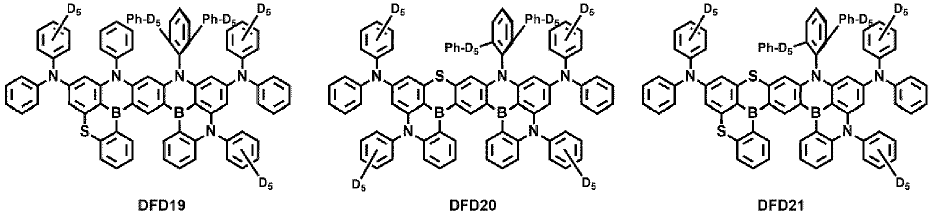

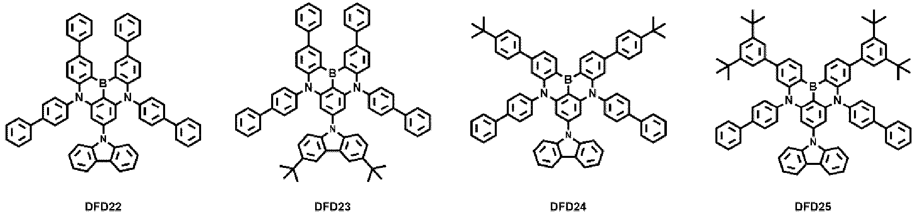

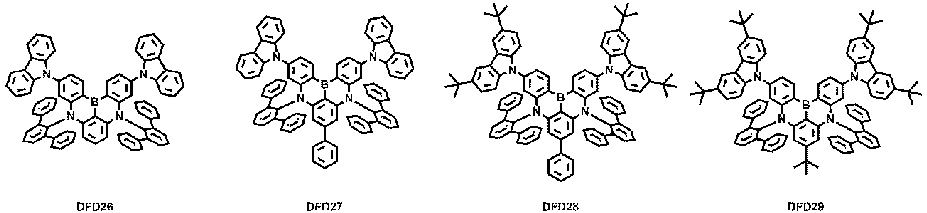

In the compounds described above, Ph represents a phenyl group, D₅ represents substitution with five deuterium, and D₄ represents substitution with four deuterium. For example, a group represented by 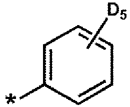 may be identical to a group represented by

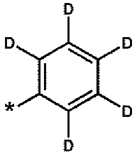

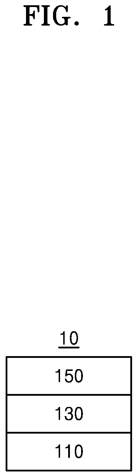

### Description of FIG. 1

FIG. 1 is a schematic cross-sectional view of a light-emitting device 10 according to one or more embodiments of the present disclosure. The light-emitting device 10 may include a first electrode 110, an interlayer 130, and a second electrode 150.

Hereinafter, the structure of the light-emitting device 10 according to one or more embodiments and a method of manufacturing the light-emitting device 10 will be described in more detail with reference to FIG. 1.

### First electrode 110

In FIG. 1, in one or more embodiments, a substrate may be additionally provided and arranged under the first electrode 110 and/or on the second electrode 150. In one or more embodiments, as the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In one or more embodiments, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure including (e.g., consisting of) a single layer or a multi-layer structure including multiple layers. For example, in some embodiments, the first electrode 110 may have a three-layer structure of ITO/Ag/ITO.

### Interlayer 130

The interlayer 130 may be arranged on the first electrode 110. The interlayer 130 may include the emission layer.

In one or more embodiments, the interlayer 130 may further include a hole transport region arranged between the first electrode 110 and the emission layer, and an electron transport region arranged between the emission layer and the second electrode 150.

In one or more embodiments, the interlayer 130 may further include, in addition to one or more suitable organic materials, a metal-containing compound such as an organometallic compound, for example, the organometallic compound represented by Formula, an inorganic material such as quantum dots, and/or the like.

In one or more embodiments, the interlayer 130 may include, i) two or more emitting units sequentially stacked between the first electrode 110 and the second electrode 150, and ii) a charge generation layer between the two or more emitting units. When the interlayer 130 includes the two or more emitting units and the charge generation layer, the light-emitting device 10 may be a tandem light-emitting device.

### Hole transport region in interlayer 130

The hole transport region may have: i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The hole transport region may include a hole injection layer, a hole transport layer, an emission auxiliary layer, an electron-blocking layer, or any combination thereof.

For example, in some embodiments, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers of each structure are stacked sequentially from the first electrode 110 in the stated order.

In one or more embodiments, the hole transport region may include a compound represented by Formula 201, a compound represented by Formula 202, or any combination thereof:

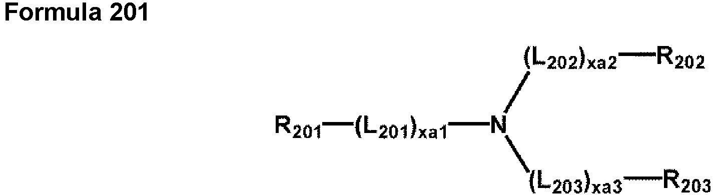

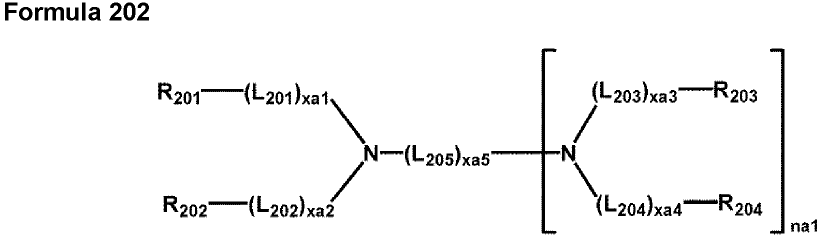

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-Cs alkylene group unsubstituted or substituted with at least one R₁₀ₐ, or a C₂-C₆ alkenylene group unsubstituted or substituted with at least one R₁₀ₐ, to form a C₈-C₆₀ polycyclic group (for example, a carbazole group and/or the like) unsubstituted or substituted with at least one R₁₀ₐ (for example, see Compound HT16),
R₂₀₃ and R₂₀₄ may optionally be linked to each other via a single bond, a C₁-Cs alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, in some embodiments, each of Formulae 201 and 202 may include at least one selected from groups represented by Formulae CY201 to CY217:

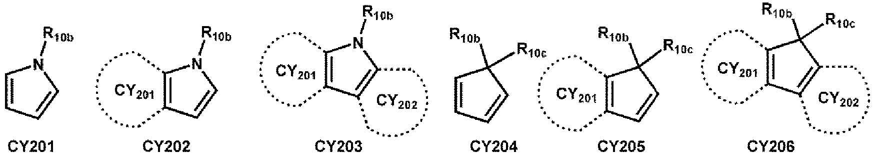

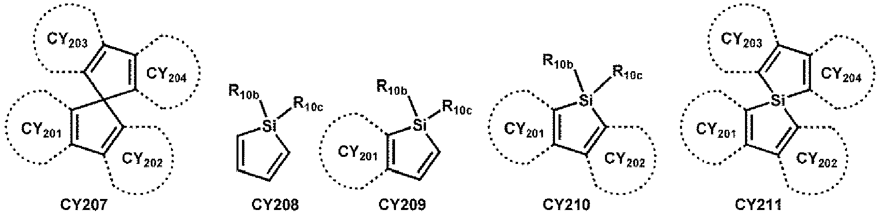

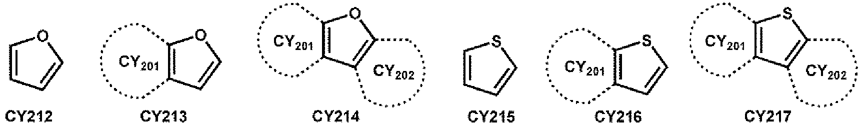

In Formulae CY201 to CY217, R_{10b} and R_{10c} may each be the same as described with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from the groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be one selected from the groups represented by Formulae CY201 to CY203, xa2 may be 0, and R₂₀₂ may be one selected from the groups represented by Formulae CY204 to CY207.

In one or more embodiments, each of Formulae 201 and 202 may not include (e.g., may exclude) any of the groups represented by Formulae CY201 to CY203.

In an embodiment, each of Formulae 201 and 202 may not include (e.g., may exclude) any of the groups represented by Formulae CY201 to CY203, and may include at least one selected from the groups represented by Formulae CY204 to CY217.

In an embodiment, each of Formulae 201 and 202 may not include (e.g., may exclude) any of the groups represented by Formulae CY201 to CY217. In present disclosure, "not include a or any 'component'" "exclude a or any 'component'", "'component'-free", and/or the like refers to that the "component" not being added, selected or utilized as a component in the composition/formula/structure, but, in some embodiments, the "component" of less than a suitable amount may still be included due to other impurities and/or external factors.

For example, in one or more embodiments, the hole transport region may include: at least one selected from among Compounds HT1 to HT46; 4,4',4"-[tris(3-methylphenyl)phenylamino] triphenylamine (m-MTDATA); 4,4',4"-tris(N,N-diphenylamino)triphenylamine (TDATA); 4,4',4"-tris[N-(2-naphthyl)-N-phenylamino]-triphenylamine (2-TNATA); N,N'-di(naphthalen-1-yl)-N,N'-diphenyl-benzidine (NPB(NPD)); β-NPB; N,N'-bis(3-methylphenyl)-N,N'-diphenyl-[1,1'-biphenyl]-4,4'-diamine (TPD); spiro-TPD; spiro-NPB; methylated NPB; 4,4'-cyclohexylidene bis[N,N-bis(4-methylphenyl)benzenamine] (TAPC); 4,4'-bis[N,N'-(3-tolyl)amino]-3,3'-dimethylbiphenyl (HMTPD); 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); or any combination thereof:

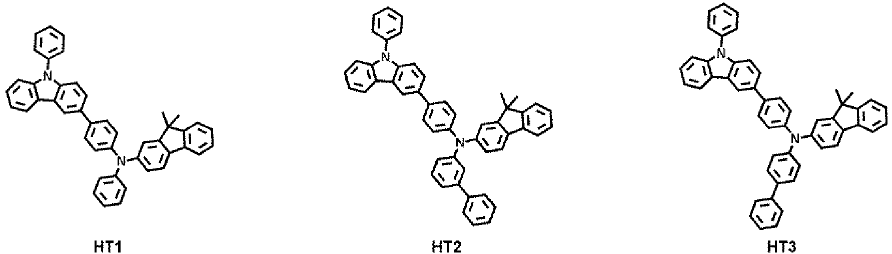

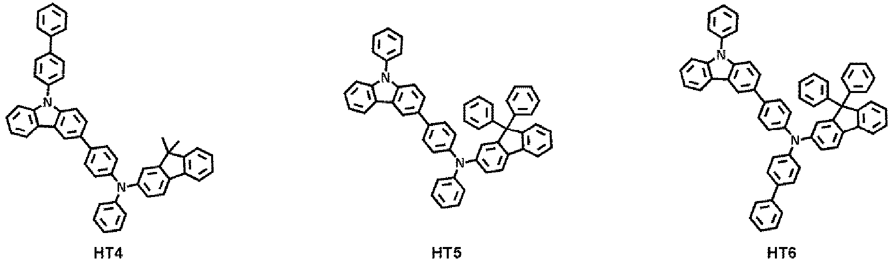

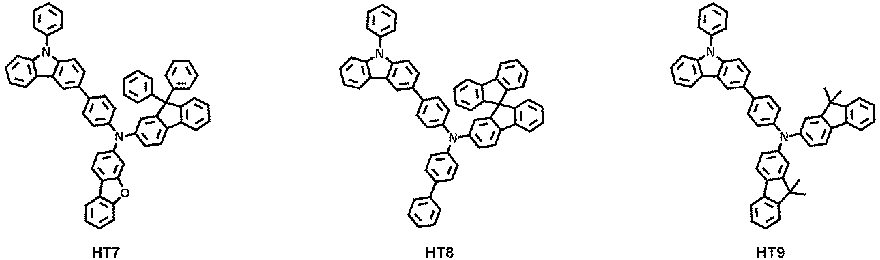

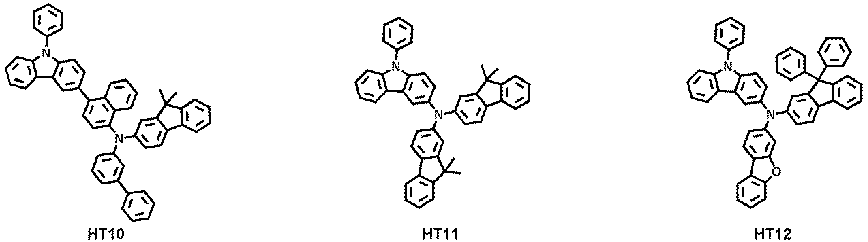

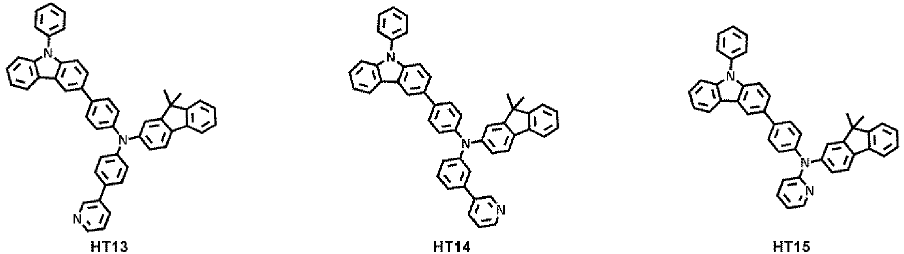

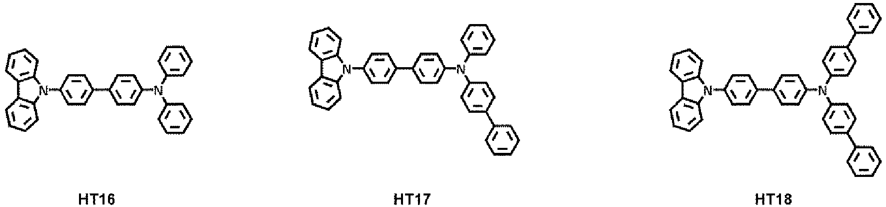

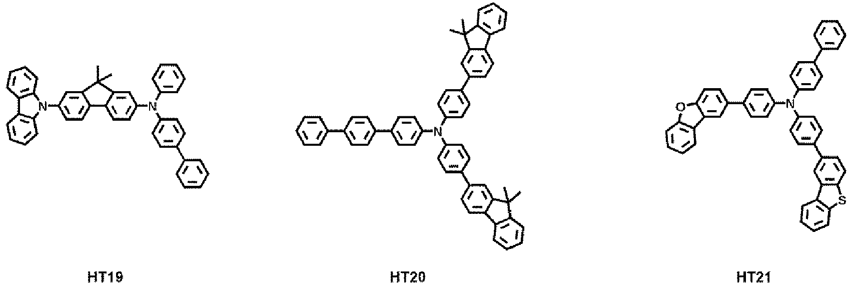

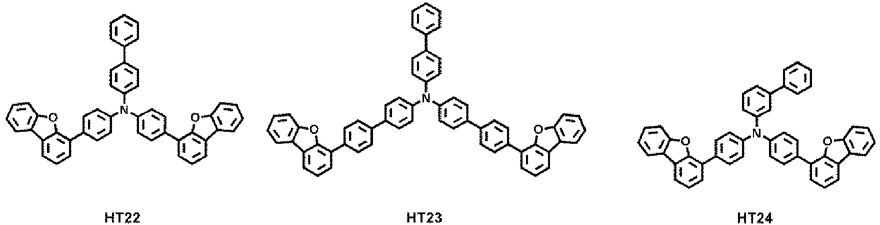

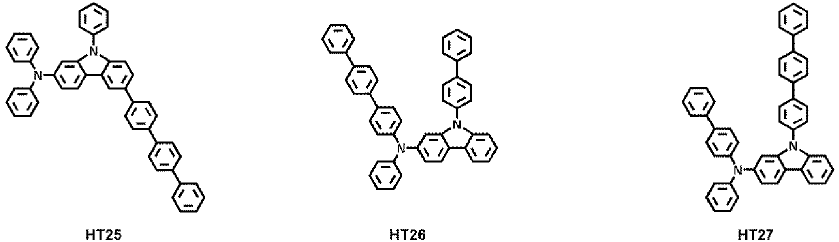

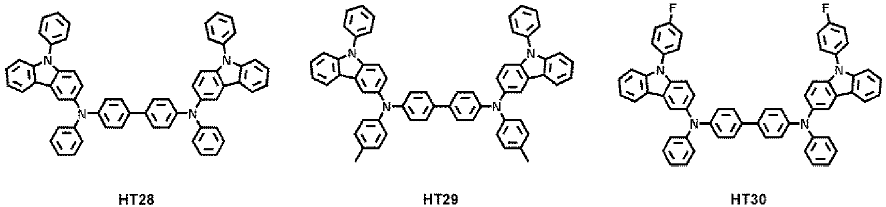

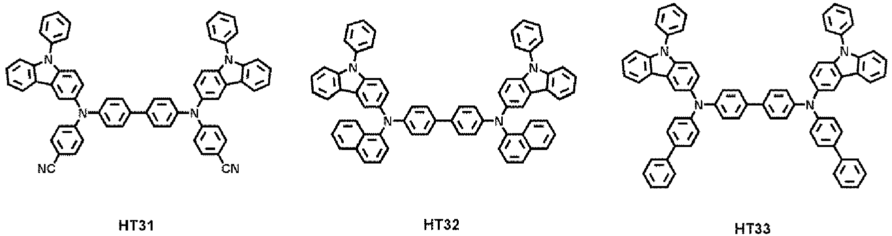

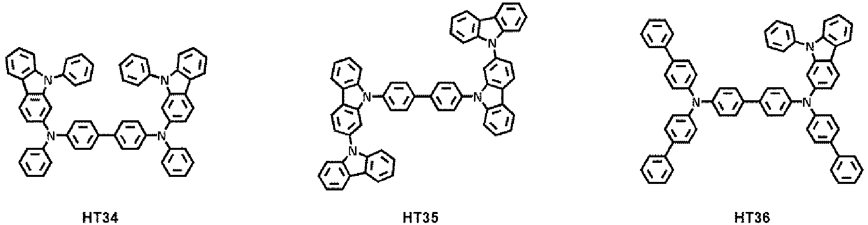

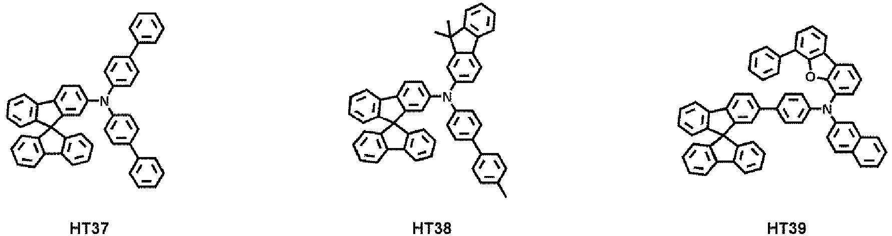

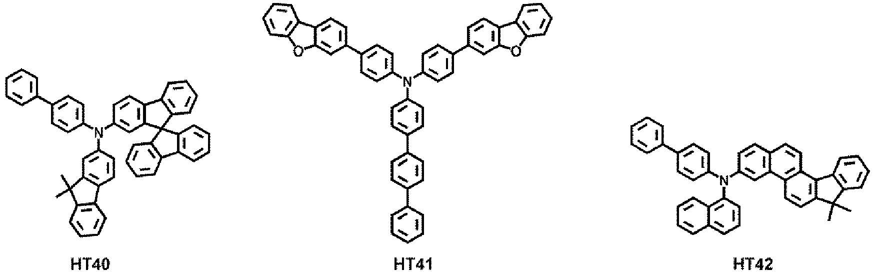

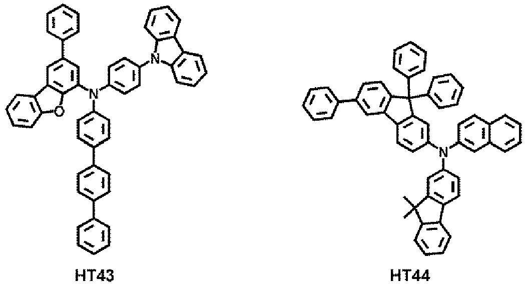

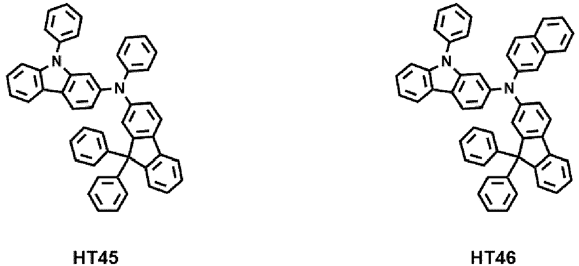

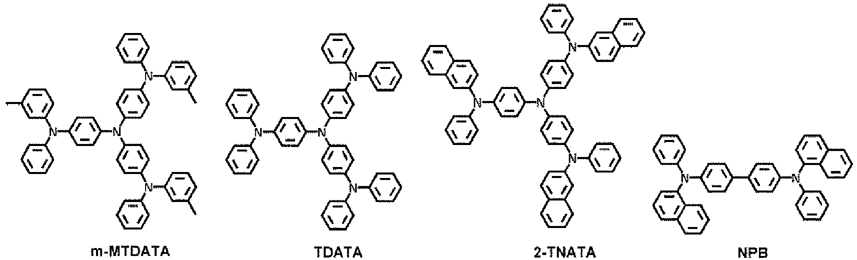

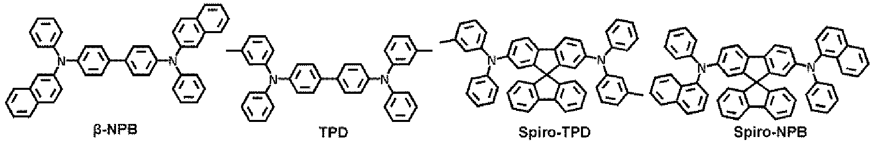

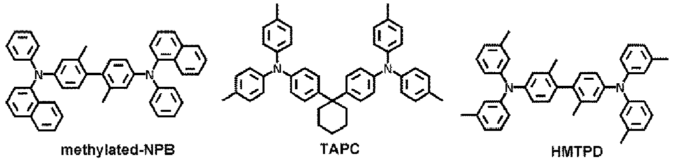

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron-blocking layer may block or reduce the leakage of electrons from the emission layer to the hole transport region. Materials that may be included in the hole transport region may be included in the emission auxiliary layer and the electron-blocking layer.

### p-dopant

In one or more embodiments, the hole transport region may further include, in addition to one or more of these aforementioned materials, a charge-generation material for the improvement of conductive properties. The charge-generation material may be substantially uniformly or non-uniformly dispersed in the hole transport region (for example, in the form of a single layer including (e.g., consisting of) a charge-generation material).

The charge-generation material may be, for example, a p-dopant.

For example, in one or more embodiments, the p-dopant may have a LUMO energy level of less than or equal to -3.5 eV.

In one or more embodiments, the p-dopant may include a quinone derivative, a cyano group-containing compound, a compound including element EL1 and element EL2, or any combination thereof.

Non-limiting examples of the quinone derivative are tetracyanoquinodimethane (TCNQ), 2,3,5,6-tetrafluoro-7,7,8,8-tetracyanoquinodimethane (F4-TCNQ), and/or the like.

Non-limiting examples of the cyano group-containing compound are dipyrazino[2,3-f: 2',3'-h] quinoxaline-2,3,6,7,10,11-hexacarbonitrile (HAT-CN), a compound represented by Formula 221, and/or the like:

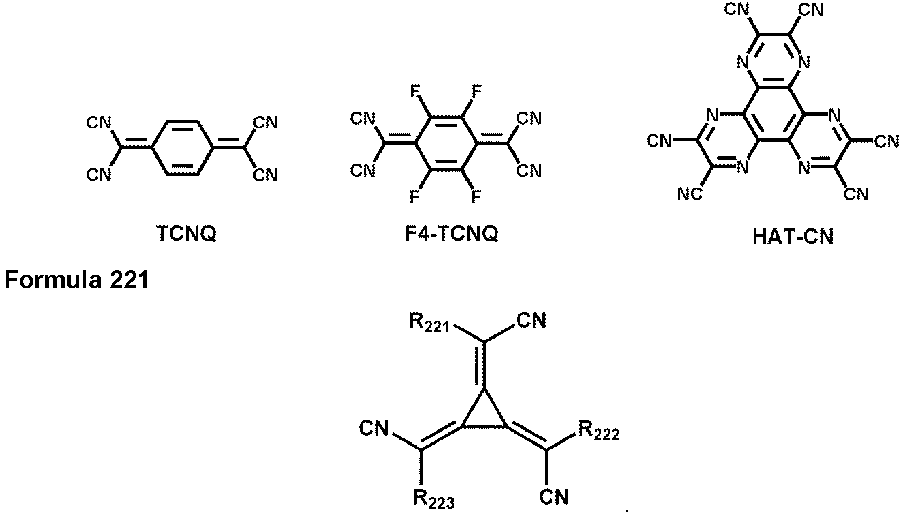

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound including element EL1 and element EL2, element EL1 may be a metal, a metalloid, or any combination thereof, and element EL2 may be a non-metal, a metalloid, or any combination thereof.

Non-limiting examples of the metal are an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Non-limiting examples of the metalloid are silicon (Si), antimony (Sb), tellurium (Te), and/or the like.

Non-limiting examples of the non-metal are oxygen (O), a halogen (for example, F, Cl, Br, I, etc.), and/or the like.

Non-limiting examples of the compound including element EL1 and element EL2 are metal oxides, metal halides (for example, metal fluorides, metal chlorides, metal bromides, metal iodides, etc.), metalloid halides (for example, metalloid fluorides, metalloid chlorides, metalloid bromides, metalloid iodides, etc.), metal tellurides, or one or more combinations thereof.

Non-limiting examples of the metal oxide are tungsten oxides (for example, WO, W₂O₃, WO₂, WO₃, W₂O₅, etc.), vanadium oxides (for example, VO, V₂O₃, VO₂, V₂O₅, etc.), molybdenum oxides (MoO, Mo₂O₃, MoO₂, MoOs, Mo₂O₅, etc.), rhenium oxides (for example, ReOs, etc.), and/or the like.

Non-limiting examples of the metal halide are alkali metal halides, alkaline earth metal halides, transition metal halides, post-transition metal halides, lanthanide metal halides, and/or the like.

Non-limiting examples of the alkali metal halide are LiF, NaF, KF, RbF, CsF, LiCl, NaCl, KCl, RbCl, CsCl, LiBr, NaBr, KBr, RbBr, CsBr, Lil, Nal, KI, Rbl, Csl, and/or the like.

Non-limiting examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Non-limiting examples of the transition metal halide are titanium halides (for example, TiF₄, TiCl₄, TiBr₄, TiI₄, etc.), zirconium halides (for example, ZrF₄, ZrCl₄, ZrBr₄, ZrI₄, etc.), hafnium halides (for example, HfF₄, HfCl₄, HfBr₄, HfI₄, etc.), vanadium halides (for example, VF₃, VCl₃, VBr₃, VI₃, etc.), niobium halides (for example, NbF₃, NbCl₃, NbBr₃, NbI₃, etc.), tantalum halides (for example, TaF₃, TaCl₃, TaBr₃, TaI₃, etc.), chromium halides (for example, CrF₃, CrCl₃, CrBr₃, CrI₃, etc.), molybdenum halides (for example, MoF₃, MoCl₃, MoBr₃, MoI₃, etc.), tungsten halides (for example, WF₃, WCl₃, WBr₃, WI₃, etc.), manganese halides (for example, MnF₂, MnCl₂, MnBr₂, MnI₂, etc.), technetium halides (for example, TcF₂, TcCl₂, TcBr₂, TcI₂, etc.), rhenium halides (for example, ReF₂, ReCl₂, ReBr₂, ReI₂, etc.), ferrous halides (for example, FeF₂, FeCl₂, FeBr₂, FeI₂, etc.), ruthenium halides (for example, RuF₂, RuCl₂, RuBr₂, RuI₂, etc.), osmium halides (for example, OsF₂, OsCl₂, OsBr₂, OsI₂, etc.), cobalt halides (for example, CoF₂, CoCl₂, CoBr₂, CoI₂, etc.), rhodium halides (for example, RhF₂, RhCl₂, RhBr₂, RhI₂, etc.), iridium halides (for example, IrF₂, IrCl₂, IrBr₂, IrI₂, etc.), nickel halides (for example, NiF₂, NiCl₂, NiBr₂, NiI₂, etc.), palladium halides (for example, PdF₂, PdCl₂, PdBr₂, PdI₂, etc.), platinum halides (for example, PtF₂, PtCl₂, PtBr₂, PtI₂, etc.), cuprous halides (for example, CuF, CuCl, CuBr, Cul, etc.), silver halides (for example, AgF, AgCl, AgBr, Agl, etc.), gold halides (for example, AuF, AuCl, AuBr, Aul, etc.), and/or the like.

Non-limiting examples of the post-transition metal halide are zinc halides (for example, ZnF₂, ZnCl₂, ZnBr₂, ZnI₂, etc.), indium halides (for example, InI₃, etc.), tin halides (for example, SnI₂, etc.), and/or the like.

Non-limiting examples of the lanthanide metal halide are YbF, YbF₂, YbF₃, SmF₃, YbCl, YbCl₂, YbCl₃, SmCl₃, YbBr, YbBr₂, YbBr₃, SmBr₃, YbI, YbI₂, YbI₃, SmI₃, and/or the like.

Non-limiting examples of the metalloid halide are antimony halides (for example, SbCl₅, etc.) and/or the like.

Non-limiting examples of the metal telluride are alkali metal tellurides (for example, Li₂Te, Na₂Te, K₂Te, Rb₂Te, Cs₂Te, etc.), alkaline earth metal tellurides (for example, BeTe, MgTe, CaTe, SrTe, BaTe, etc.), transition metal tellurides (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal tellurides (for example, ZnTe, etc.), lanthanide metal tellurides (for example, LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other, to emit white light (e.g., combined white light). In one or more embodiments, the emission layer may include two or more materials selected from a red light-emitting material, a green light-emitting material, and a blue light-emitting material, in which the two or more materials are mixed with each other in a single layer, to emit white light (e.g., combined white light).

In one or more embodiments, the emission layer may include a host and a dopant (or emitter). In some embodiments, the emission layer may further include an auxiliary dopant that promotes energy transfer to the dopant (or emitter), in addition to the host and the dopant (or emitter). When the emission layer includes the dopant (or emitter) and the auxiliary dopant, the dopant (or emitter) and the auxiliary dopant are different from each other.

The organometallic compound represented by Formula 1 in the present disclosure may serve as the dopant (or emitter), or may serve as the auxiliary dopant.

An amount (weight) of the dopant (or emitter) in the emission layer may be in a range of about 0.01 parts by weight to about 15 parts by weight based on 100 parts by weight of the host.

The organometallic compound represented by the Formula 1 may be included in the emission layer. An amount (weight) of the organometallic compound in the emission layer may be about 0.01 parts by weight to about 30 parts by weight, about 0.1 parts by weight to about 20 parts by weight, or about 0.1 parts by weight to about 15 parts by weight, based on 100 parts by weight of the emission layer.

In one or more embodiments, the emission layer may include a quantum dot.

In one or more embodiments, the emission layer may include a delayed fluorescence material. The delayed fluorescence material may act as a host or a dopant in the emission layer 120.

A thickness of the emission layer may be in a range of about 100 Å to about 1,000 Å, for example, about 200 Å to about 600 Å. When the thickness of the emission layer is within these ranges, excellent or suitable luminescence characteristics may be obtained without a substantial increase in driving voltage.

### Host

The host in the emission layer may include the second compound, or the third compound described in the present disclosure, or a combination thereof.

In one or more embodiments, the host may include a compound represented by Formula 301:

**Formula 301** **[Ar₃₀₁]_{xb11}-[(L₃₀₁)_{xb1}-R₃₀₁]_{xb21},**
wherein, in Formula 301,
Ar₃₀₁ and L₃₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be the same as described with respect to Q₁.

For example, in some embodiments, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or any combination thereof:

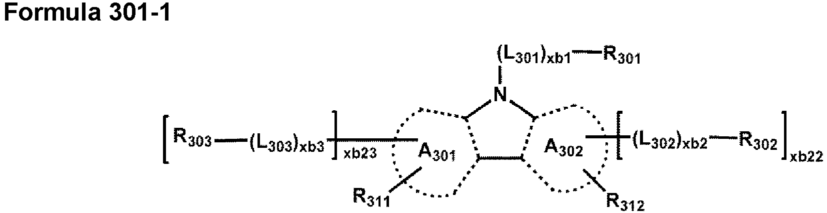

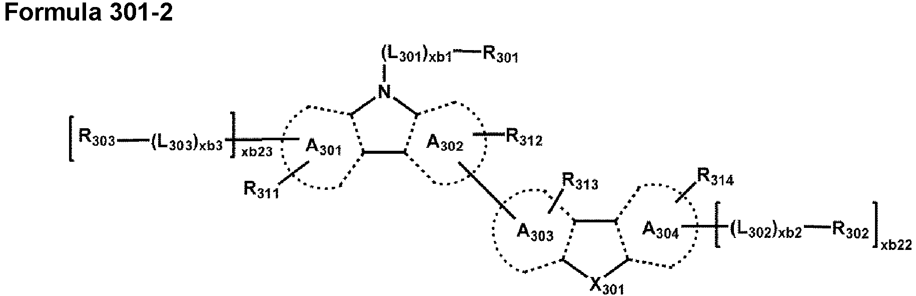

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described with respect to L301,
xb2 to xb4 may each independently be the same as described with respect to xb1, and
R₃₀₂ to R₃₀₅ and R₃₁₁ to R₃₁₄ may each be the same as described with respect to R₃₀₁.

In one or more embodiments, the host may include an alkaline earth metal complex, a post-transition metal complex, or any combination thereof. In some embodiments, the host may include a Be complex (for example, Compound H55), an Mg complex, a Zn complex, or any combination thereof.

In one or more embodiments, the host may include: at least one selected from among Compounds H1 to H128; 9,10-di(2-naphthyl)anthracene (ADN); 2-methyl-9,10-bis(naphthalen-2-yl)anthracene (MADN); 9,10-di(2-naphthyl)-2-t-butyl-anthracene (TBADN); 4,4'-bis(N-carbazolyl)-1,1'-biphenyl (CBP); 1,3-di(9H-carbazol-9-yl)benzene (mCP); 1,3,5-tri(carbazol-9-yl)benzene (TCP); or any combination thereof:

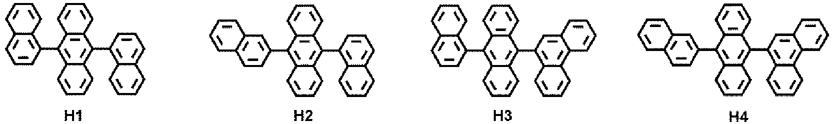

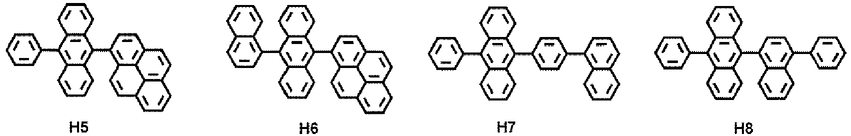

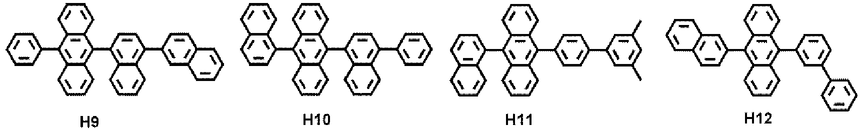

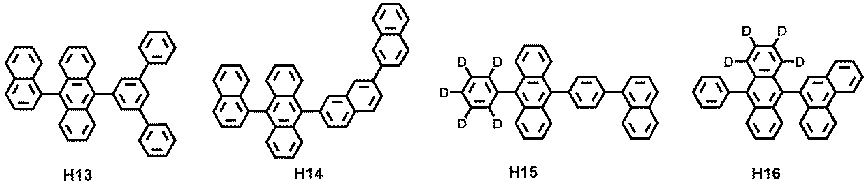

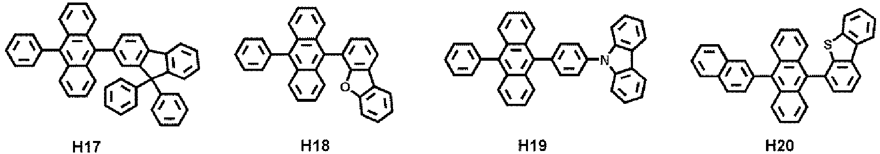

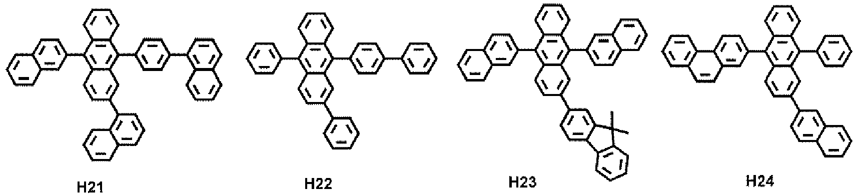

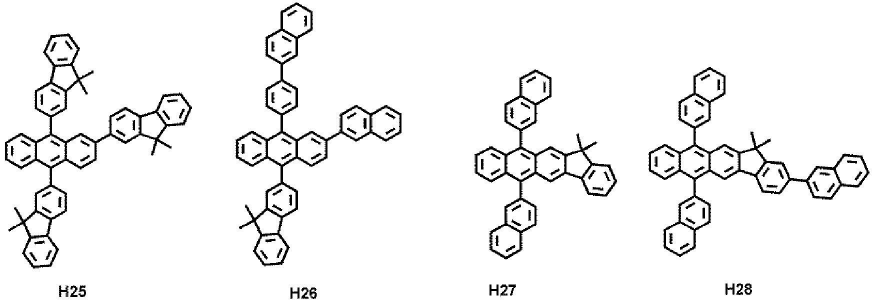

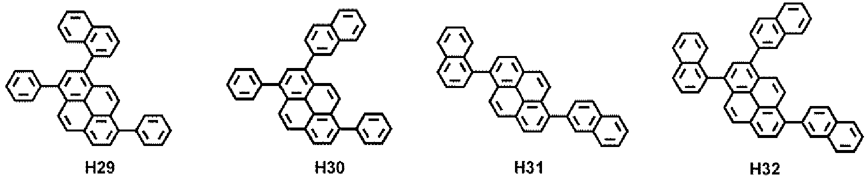

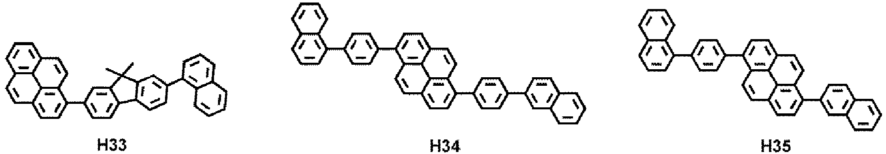

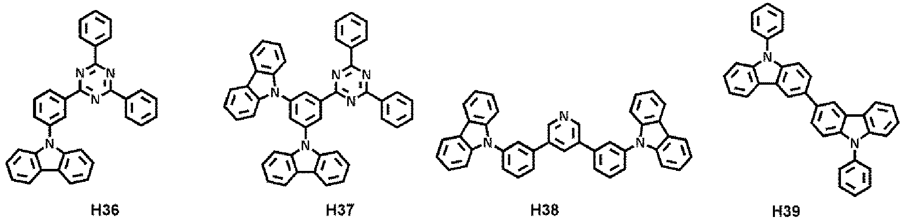

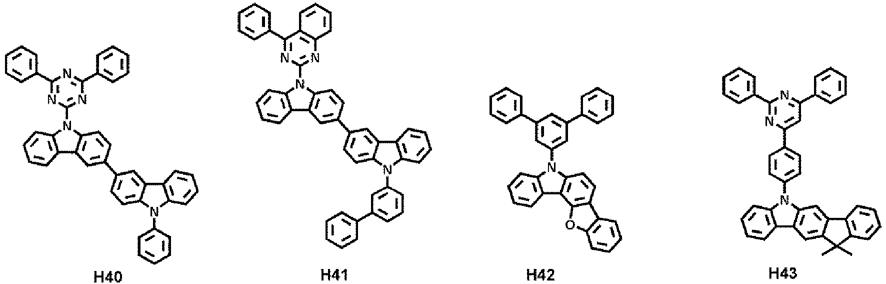

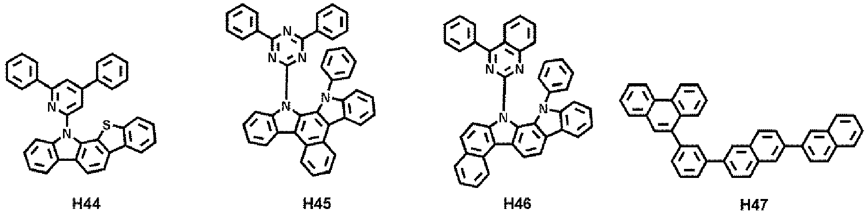

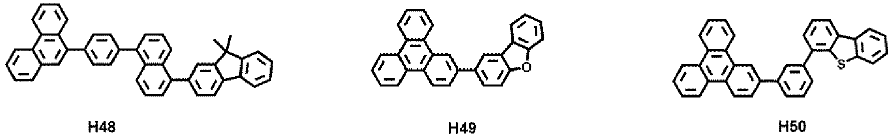

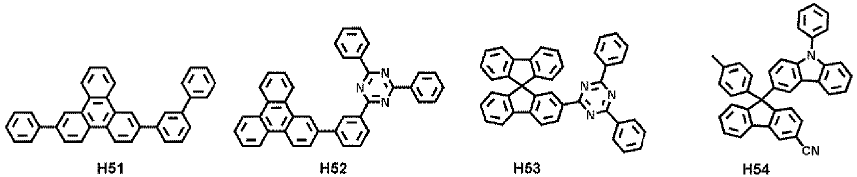

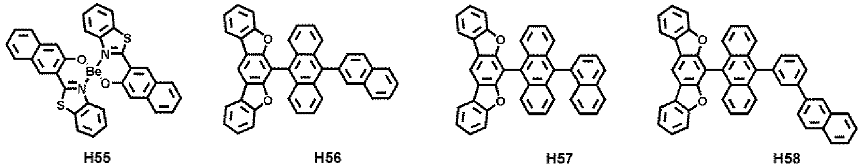

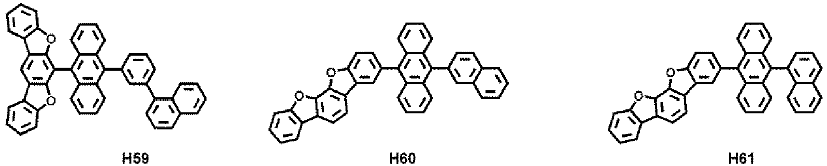

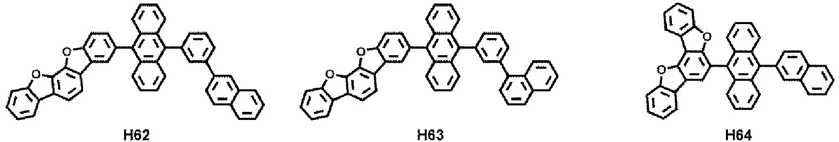

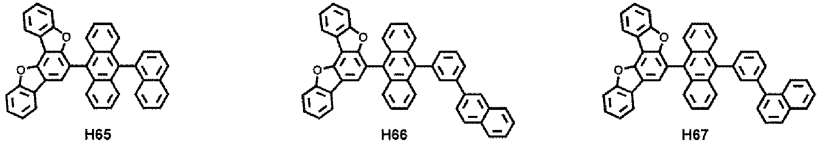

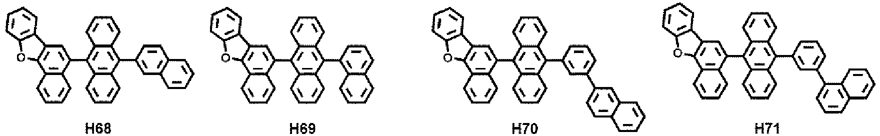

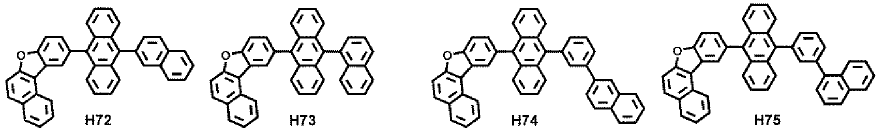

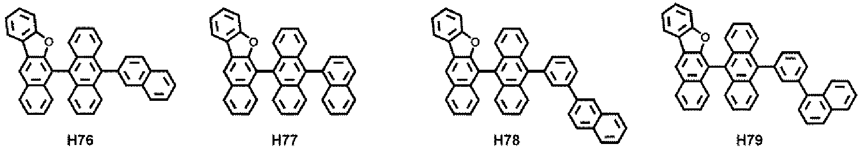

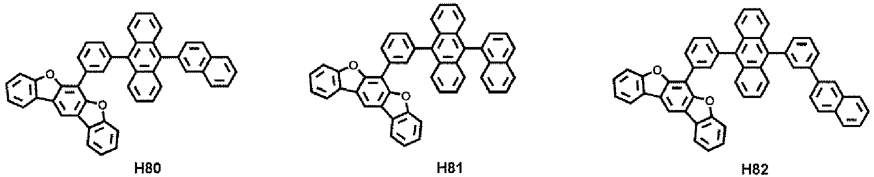

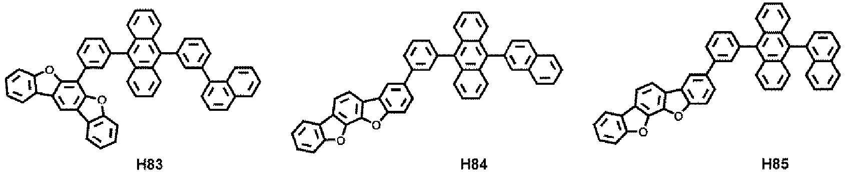

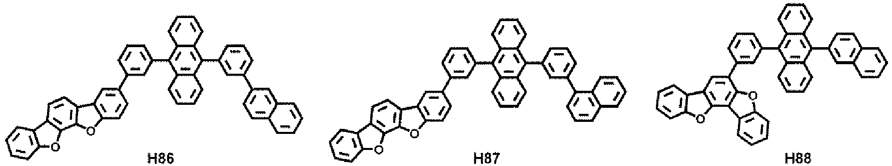

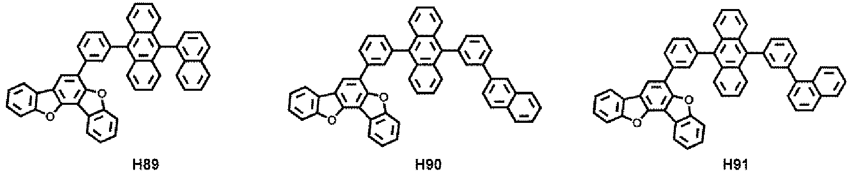

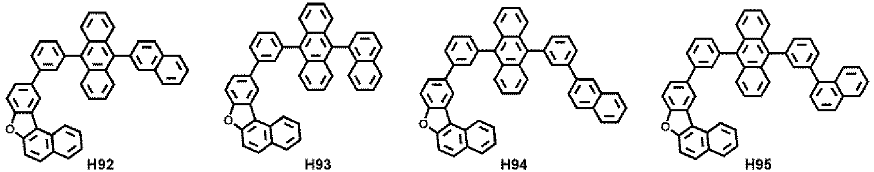

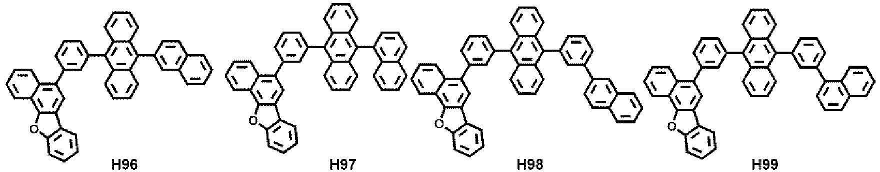

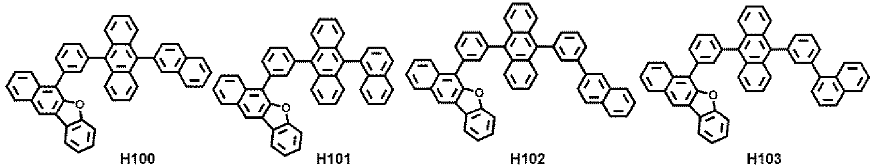

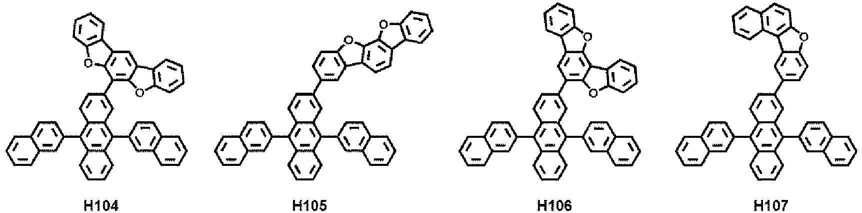

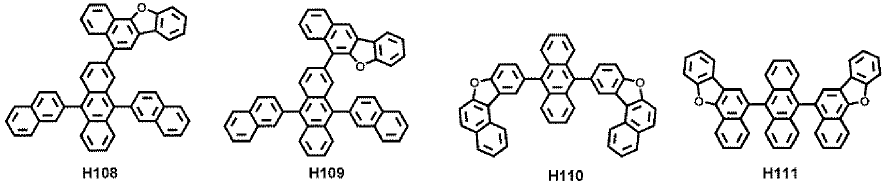

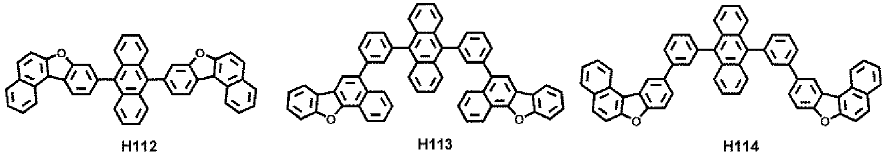

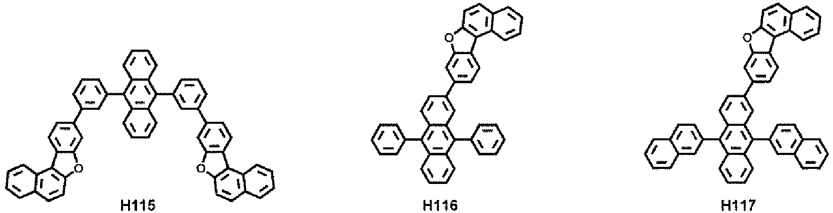

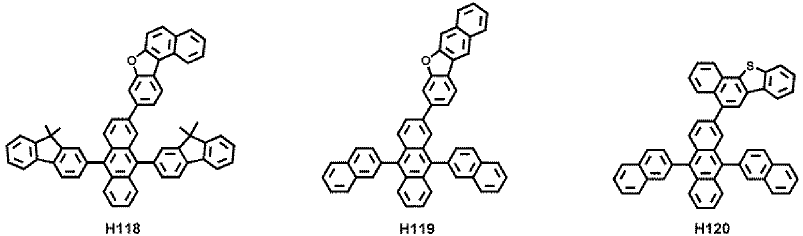

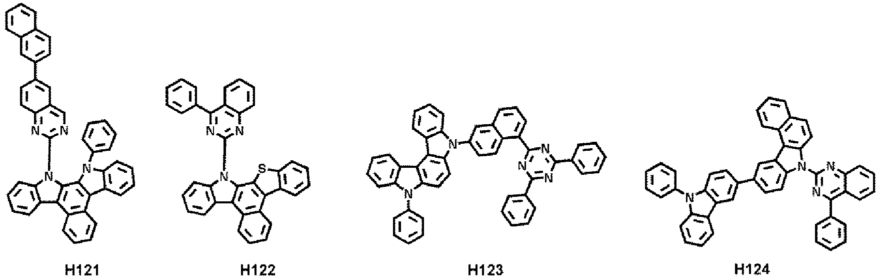

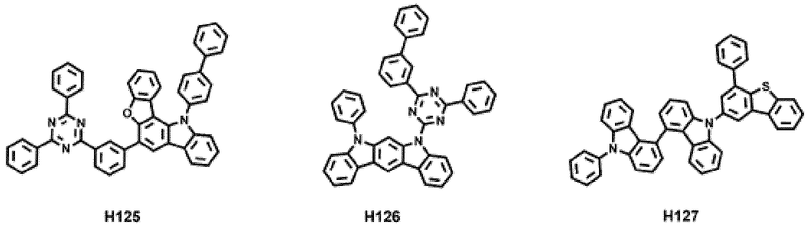

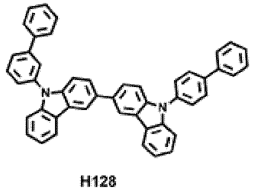

In one or more embodiments, the host may include a silicon-containing compound, a phosphine oxide-containing compound, or any combination thereof.

The host may have one or more suitable modifications. For example, the host may include only one kind of compound, or may include two or more kinds of different compounds.

### Phosphorescent dopant

The emission layer may include, as a phosphorescent dopant, the organometallic compound represented by Formula 1 as described in the present disclosure.

In one or more embodiments, in the case (e.g., embodiments) where the emission layer includes the organometallic compound represented by Formula 1 as described herein and the organometallic compound represented by Formula 1 as described herein acts as an auxiliary dopant, the emission layer may further include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

For example, in some embodiments, the phosphorescent dopant may include an organometallic compound represented by Formula 401:

**Formula 401** **M(L₄₀₁)_{xc1}(L₄₀₂)_{xc2}**

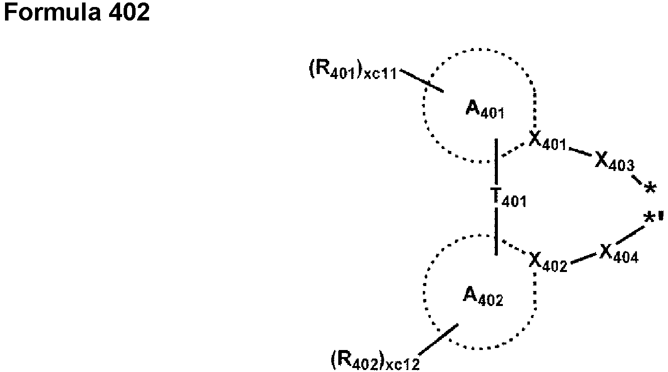

In Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁ (s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)-*',
X₄₀₃ and X₄₀₄ may each independently be a chemical bond (for example, a covalent bond or a coordinate bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ are each the same as described with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ are each the same as described with respect to Q₁,
xc11 and xc12 may each independently be an integer from 0 to 10, and
* and *' in Formula 402 each indicate a binding site to M in Formula 401.

For example, in some embodiments, in Formula 402, i) X₄₀₁ may be nitrogen and X₄₀₂ may be carbon, or ii) each of X₄₀₁ and X₄₀₂ may be nitrogen.

In one or more embodiments, when xc1 in Formula 401 is 2 or more, two ring A₄₀₁(s) among two or more of L₄₀₁(s) may optionally be linked to each other via T₄₀₂, which is a linking group, and/or two ring A₄₀₂(s) among two or more of L₄₀₁ (s) may optionally be linked to each other via T₄₀₃, which is a linking group (see Compounds PD1 to PD4 and PD7). T₄₀₂ and T₄₀₃ may each be the same as described with respect to T₄₀₁.

In Formula 401, L₄₀₂ may be an organic ligand. For example, L₄₀₂ may include a halogen, a diketone group (for example, an acetylacetonate group), a carboxylic acid group (for example, a picolinate group), -C(=O), an isonitrile group, a -CN group, a phosphorus-containing group (for example, a phosphine group, a phosphite group, etc.), or any combination thereof.

In one or more embodiments, the phosphorescent dopant may include, for example, one selected from among Compounds PD1 to PD39, or any combination thereof:

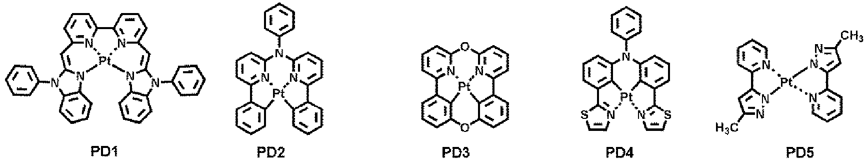

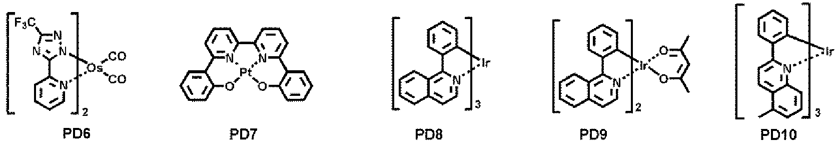

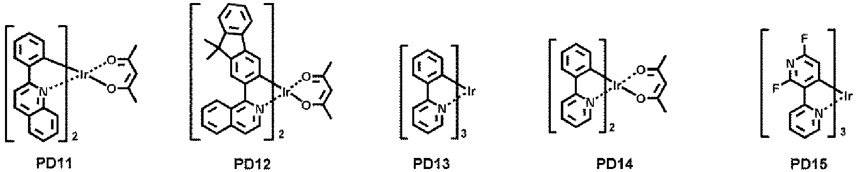

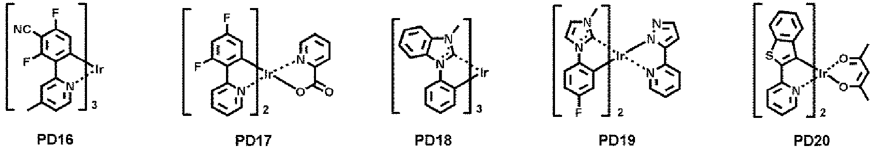

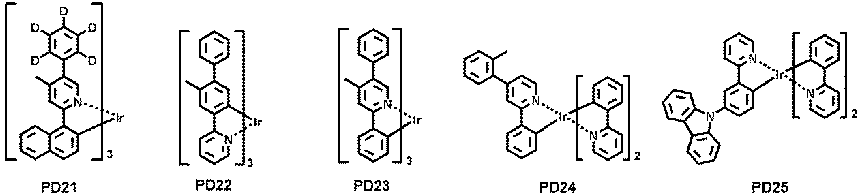

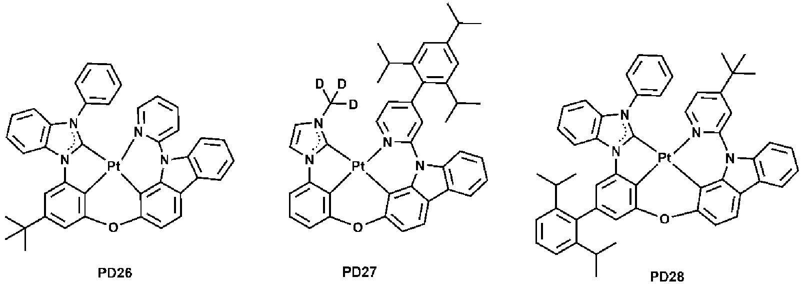

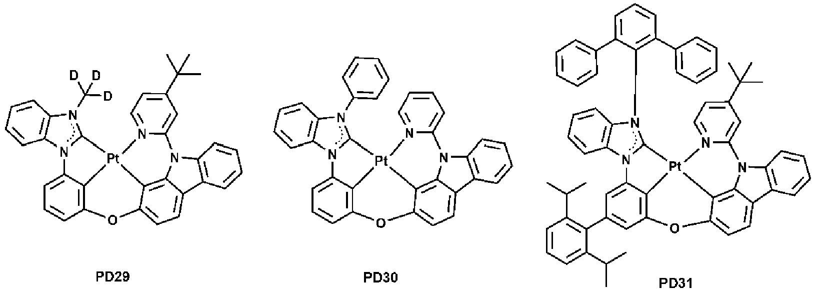

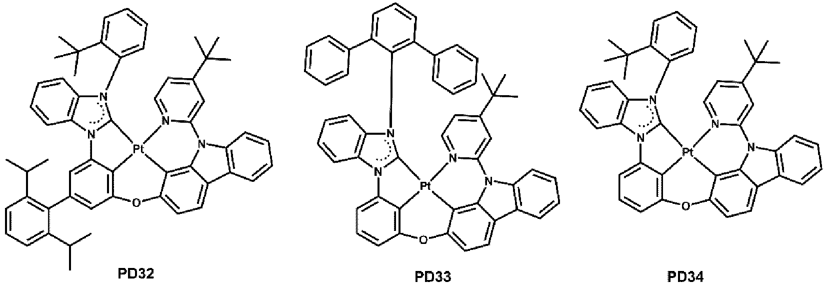

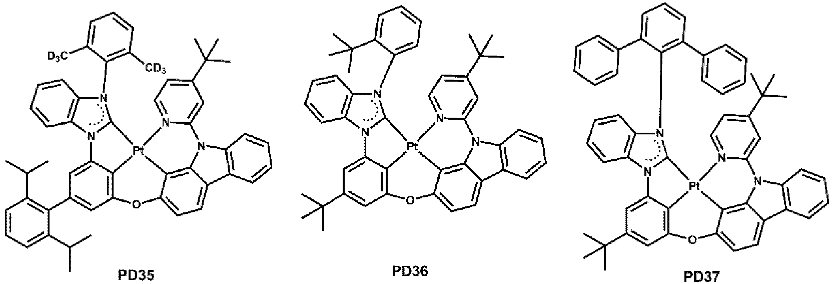

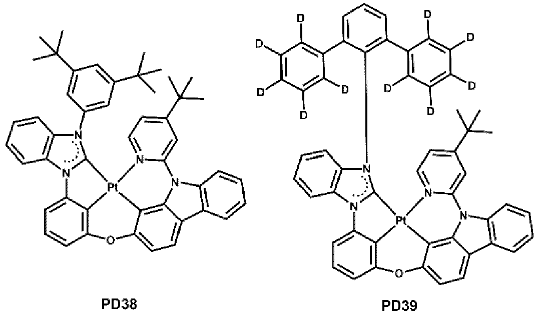

### Fluorescent dopant

In the case (e.g., embodiments) where the emission layer includes the organometallic compound represented by Formula 1 as described herein and the organometallic compound represented by Formula 1 as described herein acts as an auxiliary dopant, the emission layer may further include a fluorescent dopant.

In one or more embodiments, in the case (e.g., embodiments) where the emission layer includes the organometallic compound represented by Formula 1 as described herein and the organometallic compound represented by Formula 1 as described herein acts as a phosphorescent dopant, the emission layer may further include an auxiliary dopant.

The fluorescent dopant and the auxiliary dopant may each independently include an arylamine compound, a styrylamine compound, a boron-containing compound, or any combination thereof.

In one or more embodiments, the fluorescent dopant and the auxiliary dopant may each independently include a compound represented by Formula 501:

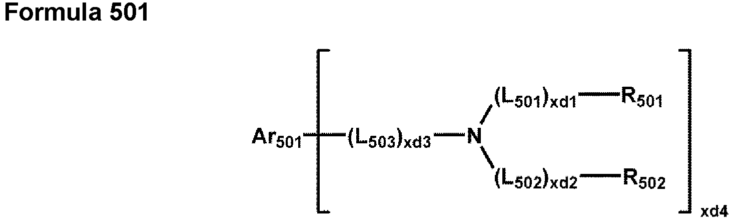

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (for example, an anthracene group, a chrysene group, a pyrene group, etc.) in which three or more monocyclic groups are condensed together.

In one or more embodiments, xd4 in Formula 501 may be 2.

For example, in one or more embodiments, the fluorescent dopant and the auxiliary dopant may each include at least one selected from among Compounds FD1 to FD37; 4,4'-bis(2,2-diphenylvinyl)-1,1'-biphenyl (DPVBi); 4,4'-bis[4-(N,N-diphenylamino)styryl]biphenyl (DPAVBi); or any combination thereof:

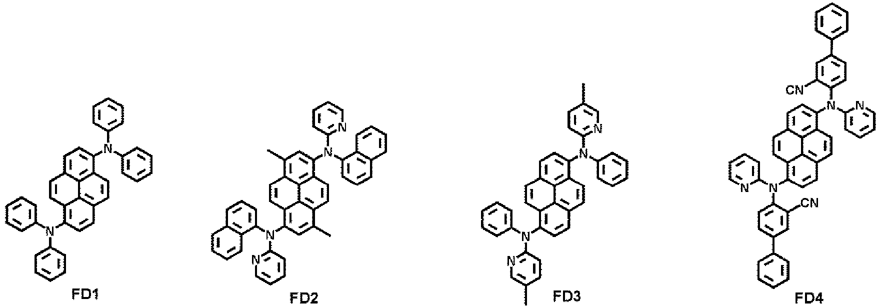

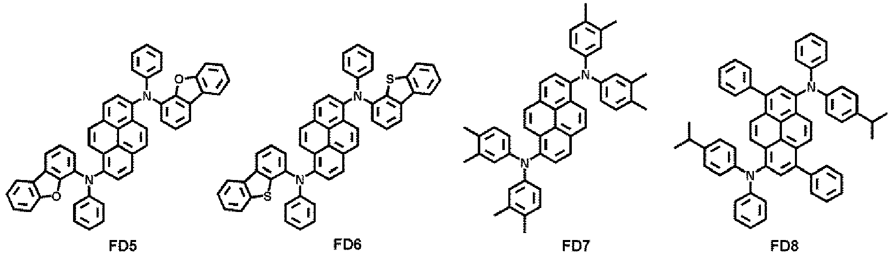

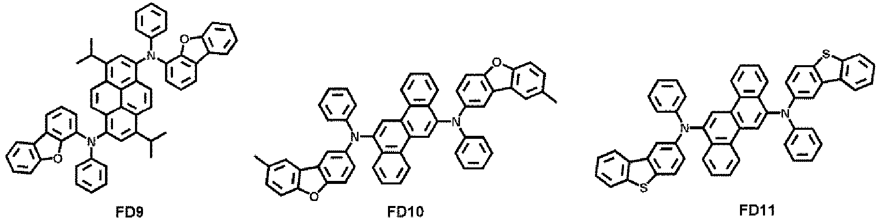

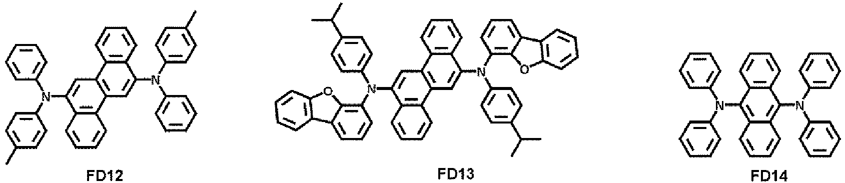

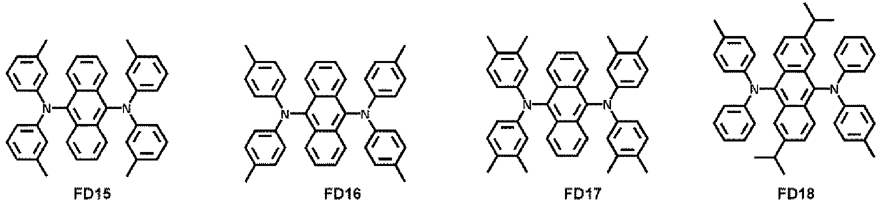

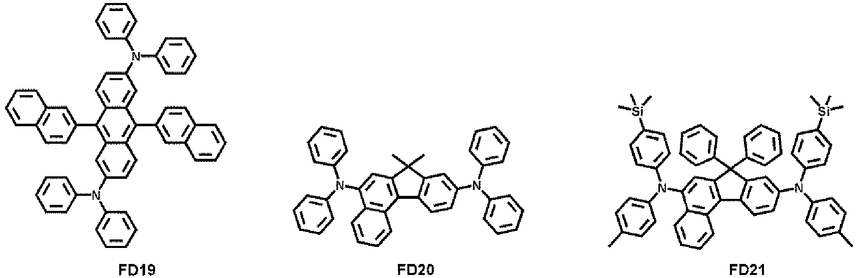

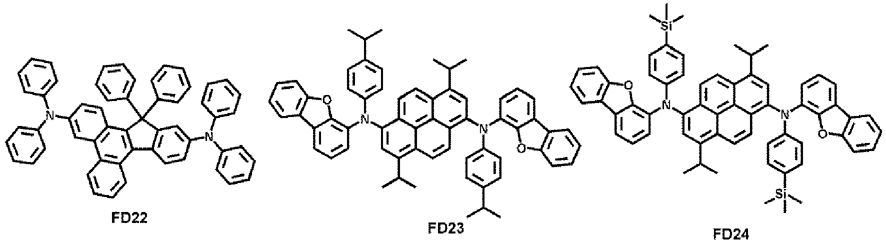

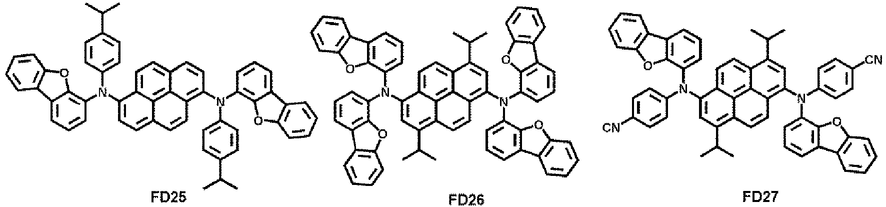

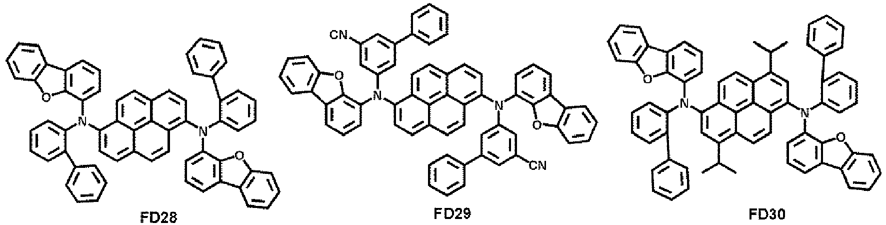

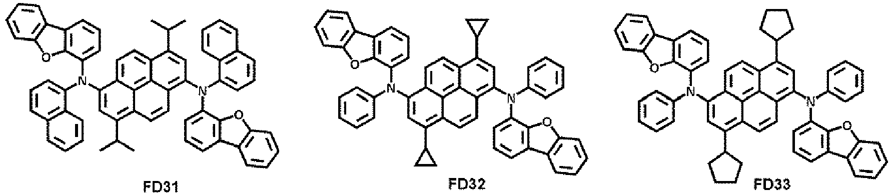

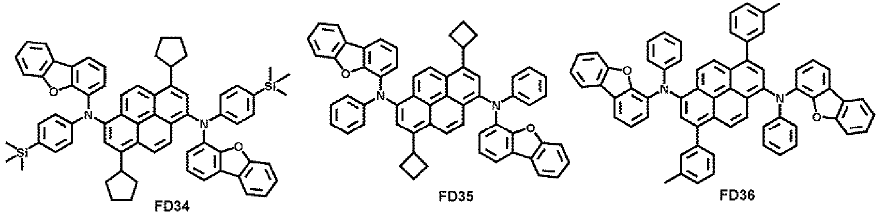

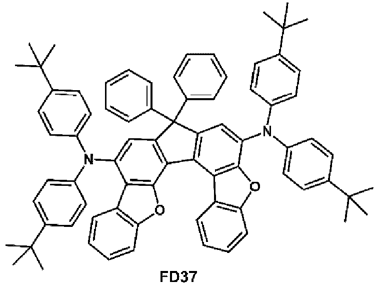

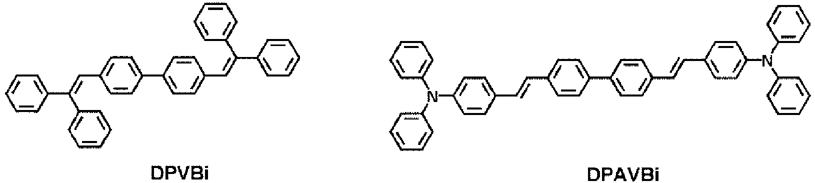

### Delayed fluorescence material

In one or more embodiments, the emission layer may include a delayed fluorescence material.

In the present disclosure, the delayed fluorescence material may be selected from compounds capable of emitting delayed fluorescence based on a delayed fluorescence emission mechanism.

The delayed fluorescence material may include, for example, the fourth compound described in the present disclosure.

The delayed fluorescence material included in the emission layer may act as a host or a dopant depending on the type or kind of other materials included in the emission layer.

In one or more embodiments, a difference between a triplet energy level (eV) of the delayed fluorescence material and a singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, in one or more embodiments, the delayed fluorescence material may include: i) a material including at least one electron donor (for example, a π electron-rich C₃-C₆₀ cyclic group and/or the like, such as a carbazole group) and at least one electron acceptor (for example, a sulfoxide group, a cyano group, a π electron-deficient nitrogen-containing C₁-C₆₀ heterocyclic group, and/or the like), ii) a material including a C₈-C₆₀ polycyclic group including at least two cyclic groups condensed to each other while sharing boron (B), and/or the like.

Non-limiting examples of the delayed fluorescence material may include at least one selected from among Compounds DF1 to DF14:

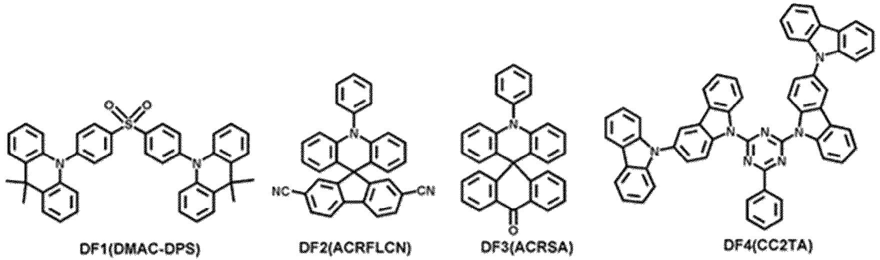

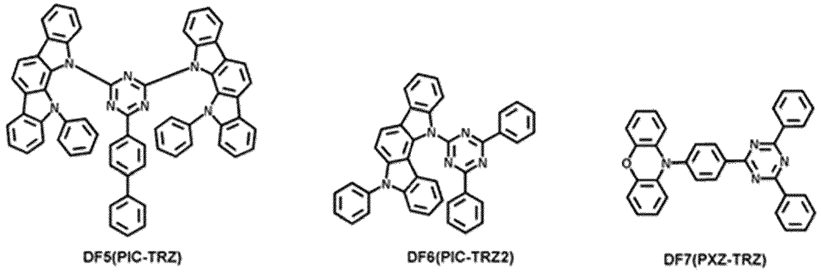

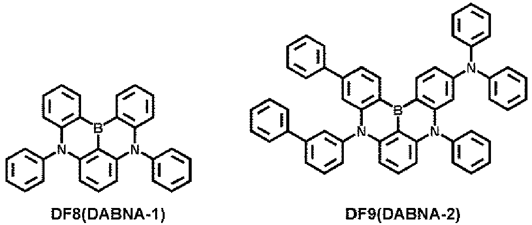

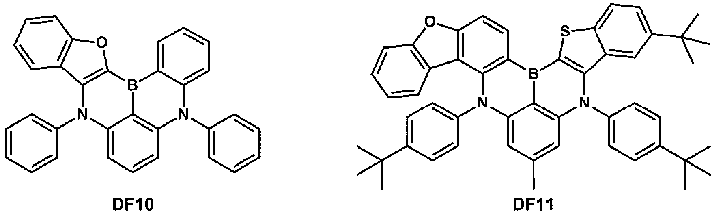

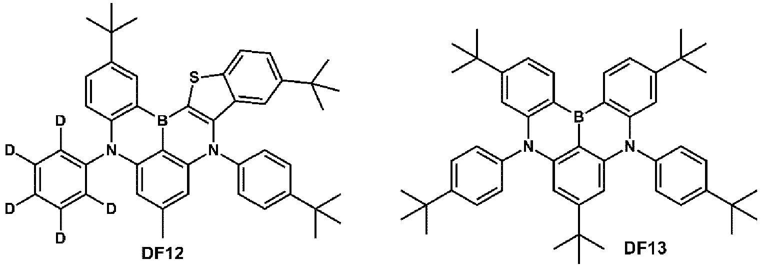

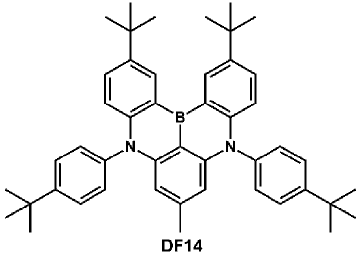

### Quantum dot

In one or more embodiments, the emission layer may include a quantum dot.

The term "quantum dot" as utilized herein refers to a crystal of a semiconductor compound, and may include any material capable of emitting light of one or more suitable emission wavelengths according to the size of the crystal.

A diameter of the quantum dot may be, for example, in a range of about 1 nm to about 10 nm. In the present disclosure, when dot, dots, or dot particles are spherical, "diameter" indicates a particle diameter or an average particle diameter, and when the particles are non-spherical, the "diameter" indicates a major axis length or an average major axis length. The diameter of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter is referred to as D50. D50 refers to the average diameter of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The quantum dot may be synthesized by a wet chemical process, a metal organic chemical vapor deposition process, a molecular beam epitaxy process, or any process similar thereto.

The wet chemical process is a method including mixing a precursor material of a quantum dot with an organic solvent and then growing quantum dot particle crystals. When the crystal grows, the organic solvent naturally acts as a dispersant coordinated on the surface of the quantum dot crystal and controls the growth of the crystal so that the growth of quantum dot particles may be controlled or selected through a process which costs lower, and is easier than vapor deposition methods, such as metal organic chemical vapor deposition (MOCVD) or molecular beam epitaxy (MBE).

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Non-limiting examples of the Group II-VI semiconductor compound are: a binary compound, such as CdS, CdSe, CdTe, ZnS, ZnSe, ZnTe, ZnO, HgS, HgSe, HgTe, MgSe, MgS, and/or the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or one or more combinations thereof.

Non-limiting examples of the Group III-V semiconductor compound are: a binary compound, such as GaN, GaP, GaAs, GaSb, AlN, AlP, AlAs, AlSb, InN, InP, InAs, InSb, and/or the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and/or the like; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and/or the like; or one or more combinations thereof. In one or more embodiments, the Group III-V semiconductor compound may further include a Group II element. Non-limiting examples of the Group III-V semiconductor compound further including the Group II element are InZnP, InGaZnP, InAlZnP, and/or the like.

Non-limiting examples of the Group III-VI semiconductor compound are: a binary compound, such as GaS, GaSe, Ga₂Se₃, GaTe, InS, InSe, In₂S₃, In₂Se₃, InTe, and/or the like; a ternary compound, such as InGaS₃, InGaSe₃, and/or the like; or one or more combinations thereof.

Non-limiting examples of the Group I-III-VI semiconductor compound are: a ternary compound, such as AgInS, AgInS₂, CuInS, CuInS₂, CuGaO₂, AgGaO₂, AgAlO₂, and/or the like; or one or more combinations thereof.

Non-limiting examples of the Group IV-VI semiconductor compound are: a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or one or more combinations thereof.

Non-limiting examples of the Group IV element or compound are: a single element compound, such as Si, Ge, and/or the like; a binary compound, such as SiC, SiGe, and/or the like; or one or more combinations thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or may have a core-shell dual structure. For example, a material included in the core and a material included in the shell may be different from each other.

The shell of the quantum dot may act as a protective layer which prevents chemical denaturation of the core to maintain semiconductor characteristics, and/or as a charging layer which impart electrophoretic characteristics to the quantum dot. The shell may be single-layered or multi-layered. The interface between the core and the shell may have a concentration gradient in which the concentration of an element existing in the shell decreases toward the center of the core.

Examples of the shell of the quantum dot are an oxide of metal, metalloid, or non-metal, a semiconductor compound, or any combination thereof. Non-limiting examples of the oxide of metal, metalloid, or non-metal are: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; a ternary compound, such as MgAl₂O₄, CoFe₂O₄, NiFe₂O₄, CoMn₂O₄, and/or the like; or one or more combinations thereof. Examples of the semiconductor compound are: as described herein, a Group II-VI semiconductor compound; a Group III-V semiconductor compound; a Group III-VI semiconductor compound; a Group I-III-VI semiconductor compound; a Group IV-VI semiconductor compound; or one or more combinations thereof. Non-limiting examples of the semiconductor compound suitable as a shell are CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width of half maximum (FWHM) of the emission spectrum of less than or equal to about 45 nm, less than or equal to about 40 nm, or for example, less than or equal to about 30 nm. When the FWHM of the quantum dot is within these ranges, the quantum dot may have improved color purity or improved color reproducibility. In some embodiments, because light emitted through the quantum dot is emitted in all directions, the wide viewing angle may be improved.

In one or more embodiments, the quantum dot may be in the form of spherical nanoparticles, pyramidal nanoparticles, multi-arm nanoparticles, or cubic nanoparticles, nanotubes, nanowires, nanofibers, or nanoplates.

Because the energy band gap of the quantum dot may be adjusted by controlling the size of the quantum dot, light having one or more suitable wavelength bands may be obtained from a quantum dot emission layer. Accordingly, by utilizing quantum dots of different sizes, a light-emitting device that emits light of one or more suitable wavelengths may be implemented. In one or more embodiments, the size of the quantum dots may be selected to enable the quantum dots to emit red light, green light, and/or blue light. In some embodiments, the quantum dots with suitable sizes may be configured to emit white light by combination of light of one or more suitable colors.

### Electron transport region in interlayer 130

The electron transport region 140 may have: i) a single-layer structure including (e.g., consisting of) a single layer including (e.g., consisting of) a single material, ii) a single-layer structure including (e.g., consisting of) a single layer consisting of multiple materials that are different from each other, or iii) a multi-layer structure including multiple layers including multiple materials that are different from each other.

The electron transport region may include a buffer layer, a hole-blocking layer, an electron control layer, an electron transport layer, an electron injection layer, or any combination thereof.

For example, in one or more embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in the stated order.

In one or more embodiments, the electron transport region (for example, a buffer layer, a hole-blocking layer, an electron control layer, or an electron transport layer in the electron transport region) may include a metal-free compound including at least one π electron-deficient nitrogen-containing C₁-C₆₀ heterocyclic group.

For example, in some embodiments, the electron transport region may include a compound represented by Formula 601:

**Formula 601** **[Ar₆₀₁]ₓₑ₁₁-[(L₆₀₁)ₓₑ₁-R₆₀₁]ₓₑ₂₁,**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described with respect to Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ heterocyclic group that is unsubstituted or substituted with at least one R₁₀ₐ.

In one or more embodiments, when xe11 in Formula 601 is 2 or more, two or more of Ar₆₀₁ (s) may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 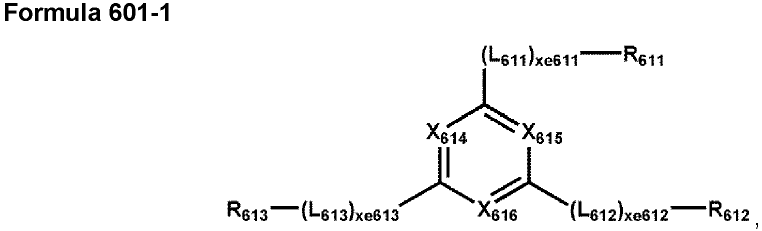 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be the same as described with respect to L₆₀₁,
xe611 to xe613 may each be the same as described with respect to xe1,
R₆₁₁ to R₆₁₃ may each be the same as described with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, in some embodiments, xe1 and xe611 to xe613 in Formulae 601 and 601-1 may each independently be 0, 1, or 2.

In one or more embodiments, the electron transport region may include: at least one selected from among Compounds ET1 to ET45; 2,9-dimethyl-4,7-diphenyl-1,10-phenanthroline (BCP); 4,7-diphenyl-1,10-phenanthroline (Bphen); tris(8-hydroxyquinolinato)aluminum (Alq₃); bis(2-methyl-8-quinolinolato-N1,O8)-(1,1'-biphenyl-4-olato)aluminum (BAlq); 3-(4-biphenyl)-4-phenyl-5-tert-butylphenyl-1,2,4-triazole (TAZ); 4-(naphthalen-1-yl)-3,5-diphenyl-4H-1,2,4-triazole (NTAZ); or any combination thereof:

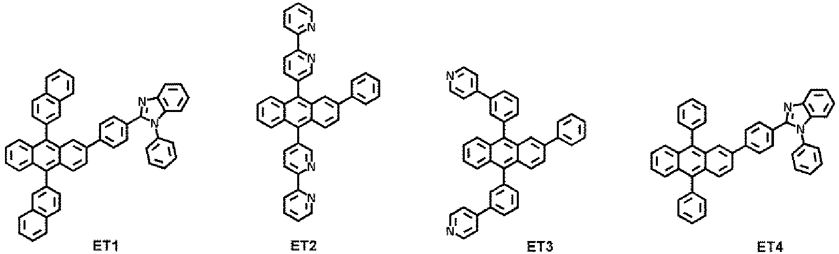

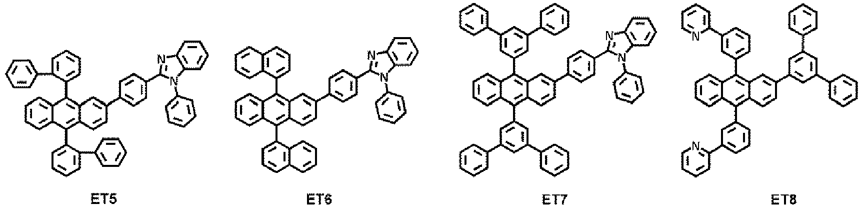

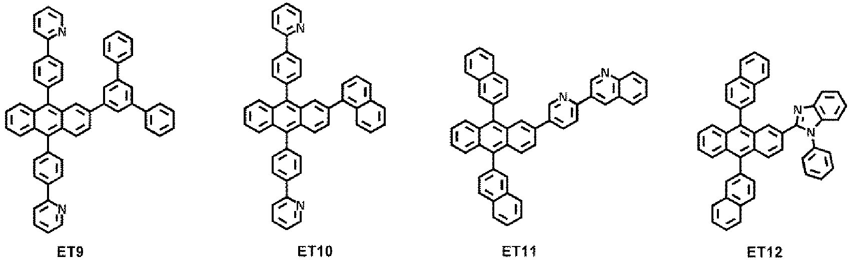

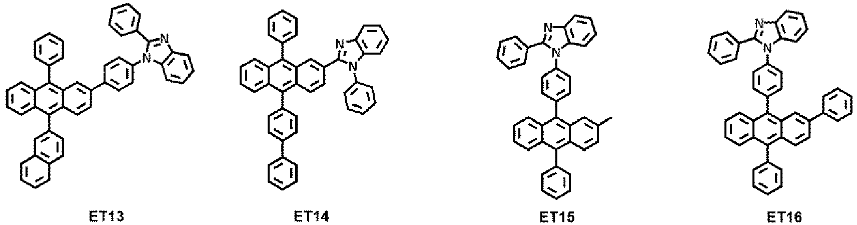

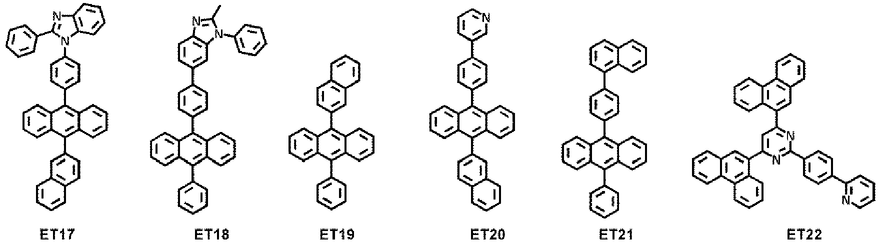

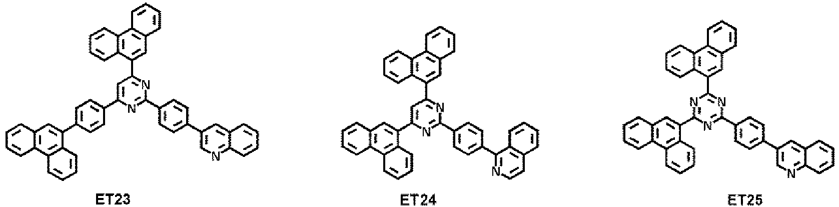

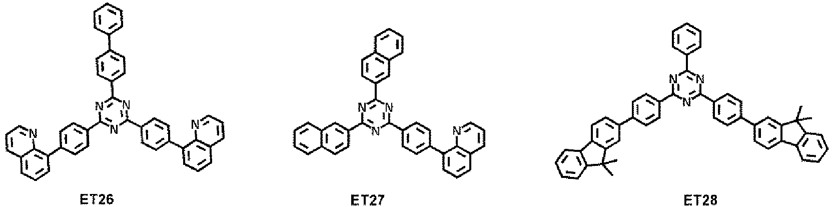

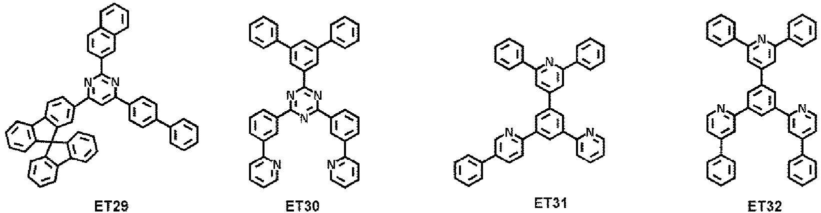

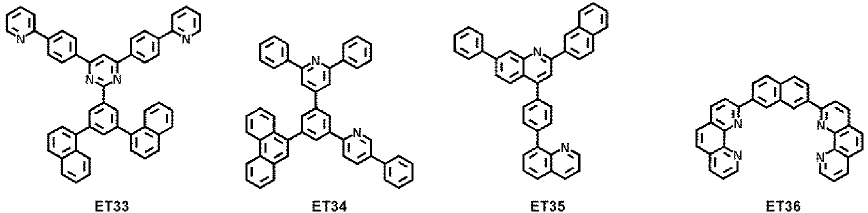

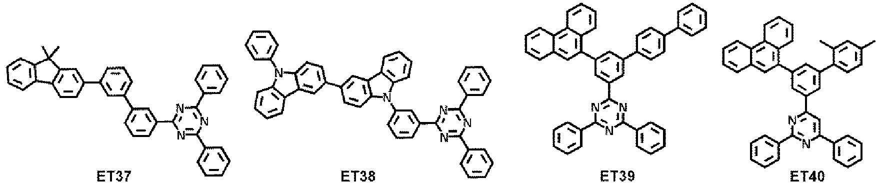

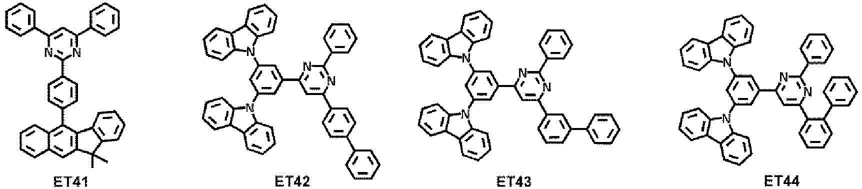

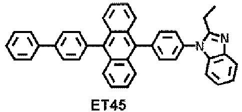

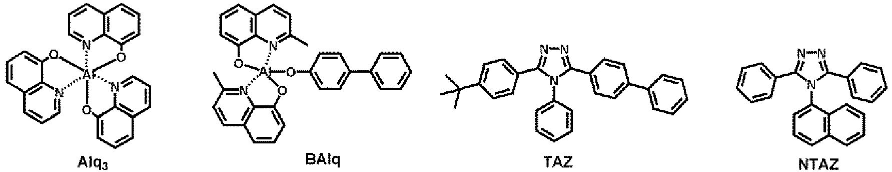

A thickness of the electron transport region may be in a range of about 100 Å to about 5,000 Å, for example, about 160 Å to about 4,000 Å. When the electron transport region includes a buffer layer, a hole-blocking layer, an electron control layer, an electron transport layer, or any combination thereof, a thickness of the buffer layer, the hole-blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport region are within these ranges, satisfactory electron transporting characteristics may be obtained without a substantial increase in driving voltage.

In one or more embodiments, the electron transport region (for example, the electron transport layer in the electron transport region) may further include, in addition to one or more of the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the metal ion of the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, in some embodiments, the metal-containing material may include a Li complex. The Li complex may include, for example, Compound ET-D1 (LiQ) or ET-D2:

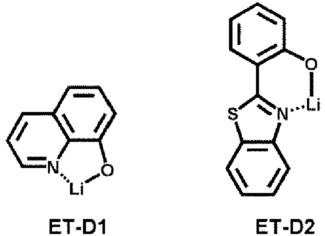

In one or more embodiments, the electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) multiple materials that are different from each other, or iii) a multi-layered structure including multiple layers including multiple materials that are different from each other.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, iodides, etc.), or tellurides of the alkali metal, the alkaline earth metal, and the rare earth metal, respectively, or any combination thereof.

The alkali metal-containing compound may include: an alkali metal oxide, such as Li₂O, Cs₂O, K₂O, etc.; an alkali metal halide, such as LiF, NaF, CsF, KF, Lil, Nal, Csl, KI, etc.; or any combination thereof. The alkaline earth metal-containing compound may include an alkaline earth metal oxide, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include a lanthanide metal telluride. Non-limiting examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one of metal ions of the alkali metal, one of metal ions of the alkaline earth metal, and one of metal ions of the rare earth metal, respectively, and ii) a ligand bonded to the metal ion (e.g., the respective metal ion), for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

In one or more embodiments, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further include an organic material (for example, a compound represented by Formula 601).

In one or more embodiments, the electron injection layer may include (e.g., consist of) i) an alkali metal-containing compound (for example, alkali metal halide), or ii) a) an alkali metal-containing compound (for example, alkali metal halide); and b) an alkali metal, an alkaline earth metal, a rare earth metal, or any combination thereof. For example, in some embodiments, the electron injection layer may be a KI:Yb co-deposited layer, an Rbl:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be substantially uniformly or non-uniformly dispersed in a matrix including the organic material.

A thickness of the electron injection layer may be in a range of about 1 Å to about 100 Å, or, for example, about 3 Å to about 90 Å. When the thickness of the electron injection layer is within these ranges, satisfactory electron injection characteristics may be obtained without a substantial increase in driving voltage.

### Second electrode 150

The second electrode 150 may be arranged on the interlayer 130 having the aforementioned structure. The second electrode 150 may be a cathode, which is an electron injection electrode, and as a material for forming the second electrode 150, a metal, an alloy, an electrically conductive compound, or any combination thereof, each having a low-work function, may be utilized.

The second electrode 150 may include Li, Ag, Mg, Al, Al-Li, Ca, Mg-In, Mg-Ag, Yb, Ag-Yb, ITO, IZO, or any combination thereof. The second electrode 150 may be a transmissive electrode, a semi-transmissive electrode, or a reflective electrode.

The second electrode 150 may have a single-layer structure or a multi-layer structure including multiple layers.

### Capping layer

A first capping layer may be arranged outside (e.g., on) the first electrode 110, and/or a second capping layer may be arranged outside (e.g., on) the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, light generated in the emission layer of the interlayer 130 of the light-emitting device 10 may be extracted toward the outside through the first electrode 110 which is a semi-transmissive electrode or a transmissive electrode, and the first capping layer. In some embodiments, light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of greater than or equal to 1.6 (e.g., at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may (e.g., the first capping layer and the second capping layer may each independently) include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may each optionally be substituted with a substituent including O, N, S, Se, Si, F, Cl, Br, I, or any combination thereof. In one or more embodiments, at least one of the first capping layer or the second capping layer may (e.g., the first capping layer and the second capping layer may each independently) include an amine group-containing compound.

In one or more embodiments, at least one of the first capping layer or the second capping layer may (e.g., the first capping layer and the second capping layer may each independently) include a compound represented by Formula 201, a compound represented by Formula 202, or any combination thereof.

In one or more embodiments, at least one of the first capping layer or the second capping layer may (e.g., the first capping layer and the second capping layer may each independently) include at least one selected from among Compounds HT28 to HT33, at least one selected from among Compounds CP1 to CP6, β-NPB, or any combination thereof:

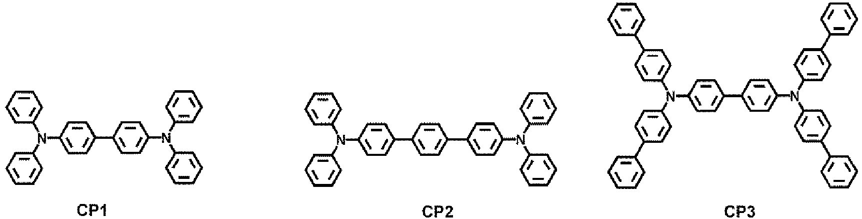

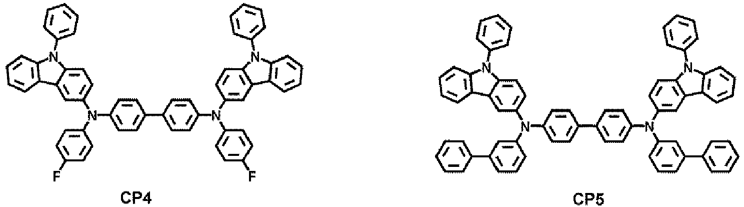

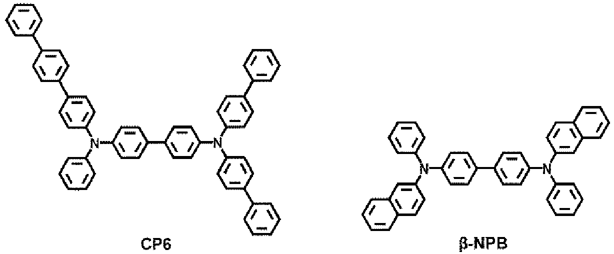

### Film

The organometallic compound represented by Formula 1 may be included in one or more suitable films. Accordingly, one or more aspects of embodiments of the present disclosure are directed toward a film including the organometallic compound represented by Formula 1. The film may be, for example, an optical member (or a light control element) (for example, a color filter, a color conversion member, a capping layer, a light extraction efficiency enhancement layer, a selective light absorbing layer, a polarizing layer, a quantum dot-containing layer, or like), a light-blocking member (for example, a light reflective layer, a light absorbing layer, and/or the like), and/or a protective member (for example, an insulating layer, a dielectric layer, and/or the like).

### Electronic apparatus

The light-emitting device may be included in one or more suitable electronic apparatuses. For example, in one or more embodiments, the electronic apparatus including the light-emitting device may be a light-emitting apparatus, an authentication apparatus, and/or the like.

In one or more embodiments, the electronic apparatus (for example, a light-emitting apparatus) may further include, in addition to the light-emitting device, i) a color filter, ii) a color conversion layer, or iii) a color filter and a color conversion layer. The color filter and/or the color conversion layer may be arranged in at least one travel direction of light emitted from the light-emitting device. For example, in some embodiments, light emitted from the light-emitting device may be blue light, green light, or white light (e.g., combined white light). Details on the light-emitting device may be referred to the descriptions provided herein. In some embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area configured to emit first color light, a second area configured to emit second color light, and/or a third area configured to emit third color light, wherein the first color light, the second color light, and/or the third color light may have different maximum emission wavelengths from one another. For example, in one or more embodiments, the first color light may be red light, the second color light may be green light, and the third color light may be blue light. For example, in one or more embodiments, the plurality of color filter areas (or the plurality of color conversion areas) may include quantum dots. In some embodiments, the first area may include a red quantum dot to emit red light, the second area may include a green quantum dot to emit green light, and the third area may not include(e.g., may exclude) any quantum dot. Details on the quantum dot may be referred to the descriptions provided herein. The first area, the second area, and/or the third area may each further include a scatter.

For example, in one or more embodiments, the light-emitting device may be to emit first light, the first area may be to absorb the first light to emit first-first color light, the second area may be to absorb the first light to emit second-first color light, and the third area may be to absorb the first light to emit third-first color light. Here, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic apparatus may further include a thin-film transistor, in addition to the light-emitting device as described above. The thin-film transistor may include a source electrode, a drain electrode, and an activation layer, wherein one selected from the source electrode and the drain electrode may be electrically connected to the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

In one or more embodiments, the electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally arranged on the sealing portion, in addition to the color filter and/or the color conversion layer, according to the utilization of the electronic apparatus. Non-limiting examples of the functional layers may include a touch screen layer, a polarizing layer, and/or the like. The touch screen layer may be a pressure-sensitive touch screen layer, a capacitive touch screen layer, or an infrared touch screen layer.

The authentication apparatus may be, for example, a biometric authentication apparatus that authenticates an individual by utilizing biometric information of a living body (for example, fingertips, pupils, etc.). The authentication apparatus may further include, in addition to the light-emitting device as described above, a biometric information collector.

The electronic apparatus may be applied to one or more of displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

### Electronic equipment

The light-emitting device may be included in one or more suitable electronic equipment.

For example, the electronic equipment including the light-emitting device may be at least one of a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, or a signboard.

Because the light-emitting device has excellent or suitable effects in terms of luminescence efficiency and long lifespan, the electronic equipment including the light-emitting device may have characteristics with high luminance, high resolution, and low power consumption.

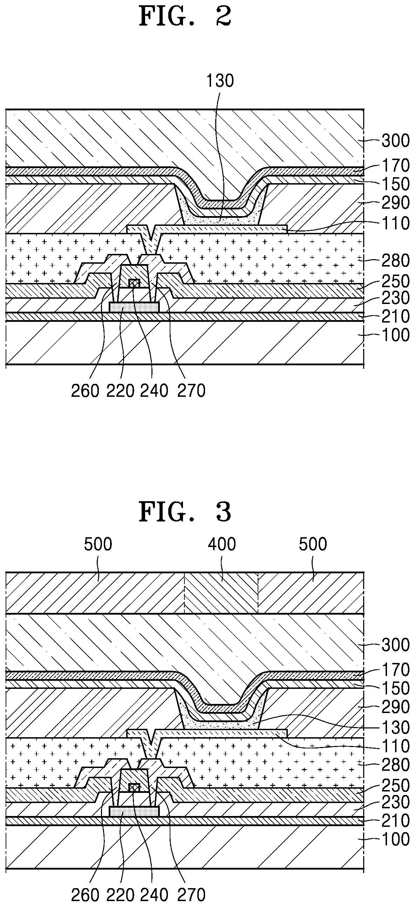

### Description of FIG. 2 and FIG. 3

FIG. 2 is a cross-sectional view showing a light-emitting apparatus as an example of the electronic apparatus according to one or more embodiments of the present disclosure.

The light-emitting apparatus of FIG. 2 may include a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220, respectively.

The TFT may be electrically connected to the light-emitting device to drive the light-emitting device, and may be covered and protected by a passivation layer 280. The passivation layer 280 may include an inorganic insulating film, an organic insulating film, or a combination thereof. The light-emitting device may be provided on the passivation layer 280. The light-emitting device may include a first electrode 110, an interlayer 130, and a second electrode 150.

The first electrode 110 may be on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be on the first electrode 110. The pixel defining layer 290 may expose a certain region of the first electrode 110, and the interlayer 130 may be formed in the exposed region of the first electrode 110. The pixel defining layer 290 may be a polyimide-based organic film or a polyacrylic-based organic film. In some embodiments, at least some layers of the interlayer 130 may extend beyond the upper portion of the pixel defining layer 290 to be arranged in the form of a common layer.

The second electrode 150 may be on the interlayer 130, and a second capping layer 170 may be additionally formed on the second electrode 150. The second capping layer 170 may be formed to cover the second electrode 150.

The encapsulation portion 300 may be on the second capping layer 170. The encapsulation portion 300 may be arranged on the light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, and/or the like), an epoxy-based resin (for example, aliphatic glycidyl ether (AGE), and/or the like), or any combination thereof; or any combination of the inorganic films and the organic films.

FIG. 3 is a cross-sectional view of a light-emitting apparatus as an example of the electronic apparatus according to one or more embodiments of the present disclosure.

The light-emitting apparatus of FIG. 3 is substantially the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

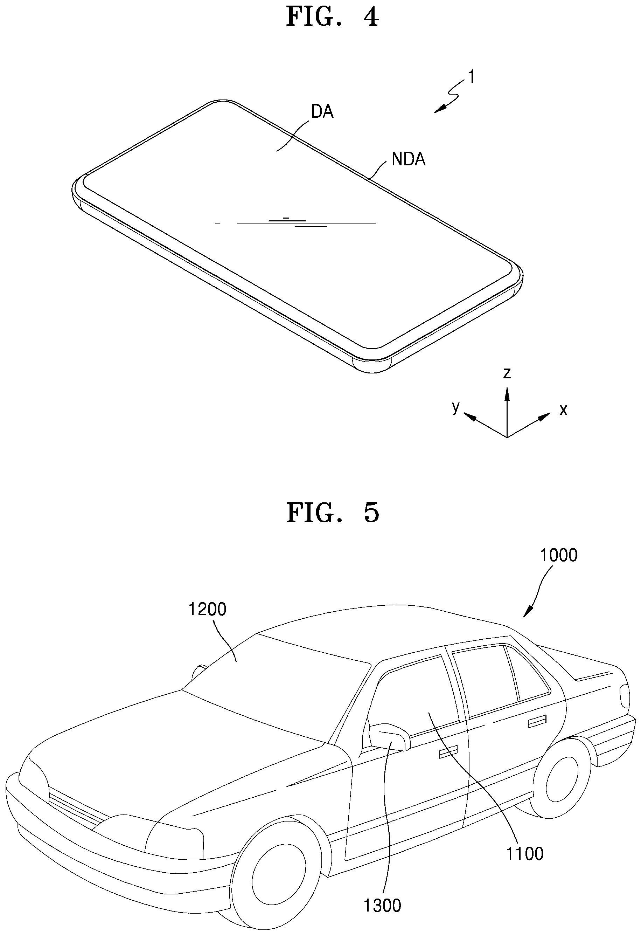

### Description of FIG. 4

FIG. 4 is a schematic perspective view of electronic equipment 1 including a light-emitting device according to one or more embodiments of the present disclosure. The electronic equipment 1 may be, as a device apparatus that displays a moving image or still image, a portable electronic equipment, such as a mobile phone, a smart phone, a tablet personal computer (PC), a mobile communication terminal, an electronic notebook, an electronic book, a portable multimedia player (PMP), a navigation, or a ultra-mobile PC (UMPC), as well as one or more suitable products, such as a television, a laptop, a monitor, a billboard, or an Internet of things (IOT). The electronic equipment 1 may be such a product above or a part thereof. In some embodiments, the electronic equipment 1 may be a wearable device, such as a smart watch, a watch phone, a glasses-type or kind display, or a head mounted display (HMD), or a part of the wearable device. However, embodiments of the present disclosure are not limited thereto. For example, the electron equipment 1 may include a dashboard of a vehicle, a center fascia of a vehicle, a center information display arranged on a dashboard of a vehicle, a room mirror display replacing a side mirror of a vehicle, an entertainment display for the rear seat of a vehicle or a display arranged on the back of the front seat thereof, or a head up display (HUD) installed in the front of a vehicle or projected on a front window glass, and/or a computer generated hologram augmented reality head up display (CGH AR HUD). FIG. 4 illustrates an embodiment in which the electronic equipment 1 is a smart phone for convenience of explanation.

The electronic equipment 1 may include a display area DA and a non-display area NDA outside the display area DA. A display device of the electronic equipment 1 may implement an image through an array of a plurality of pixels that are two-dimensionally arranged in the display area DA.

The non-display area NDA is an area that does not display an image, and may be around (e.g., may entirely surround) the display area DA. On the non-display area NDA, a driver for providing electrical signals or power to display devices arranged on the display area DA may be arranged. On the non-display area NDA, a pad, which is an area to which an electronic element or a printing circuit board may be electrically connected, may be arranged.

In the electronic equipment 1, a length in the x-axis direction and a length (e.g., a width) in the y-axis direction may be different from each other. In some embodiments, as shown in FIG. 4, the length in the x-axis direction may be shorter than the length (e.g., the width) in the y-axis direction. In some embodiments, the length in the x-axis direction may be substantially the same as the length (e.g., the width) in the y-axis direction. In some embodiments, the length in the x-axis direction may be longer than the length (the width) in the y-axis direction.

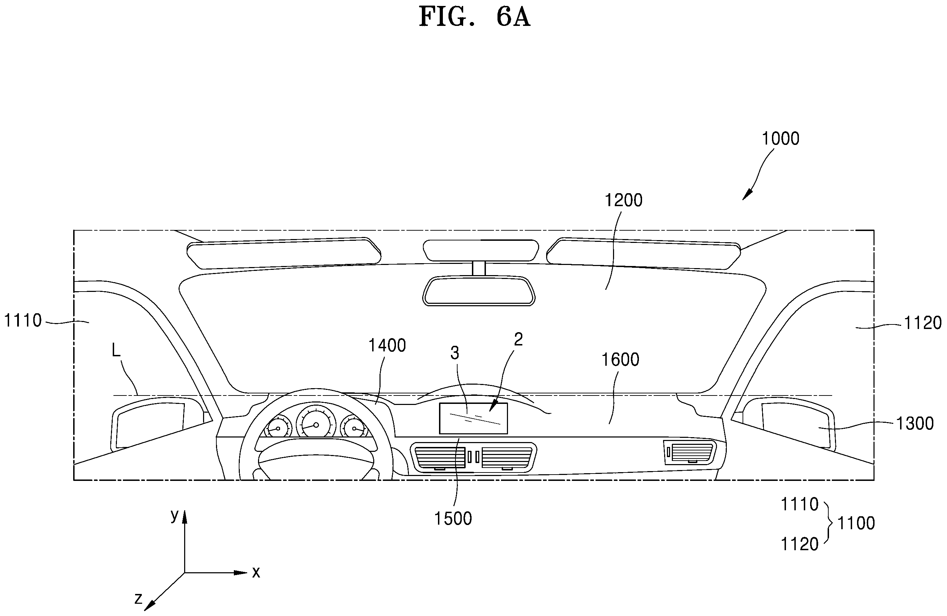

### Descriptions of FIGs. 5 and 6A to 6C

FIG. 5 is a schematic view of an exterior of a vehicle 1000 as an electronic apparatus including a light-emitting device according to one or more embodiments. FIGs. 6A to 6C are each a schematic view of an interior of the vehicle 1000 according to one or more embodiments.

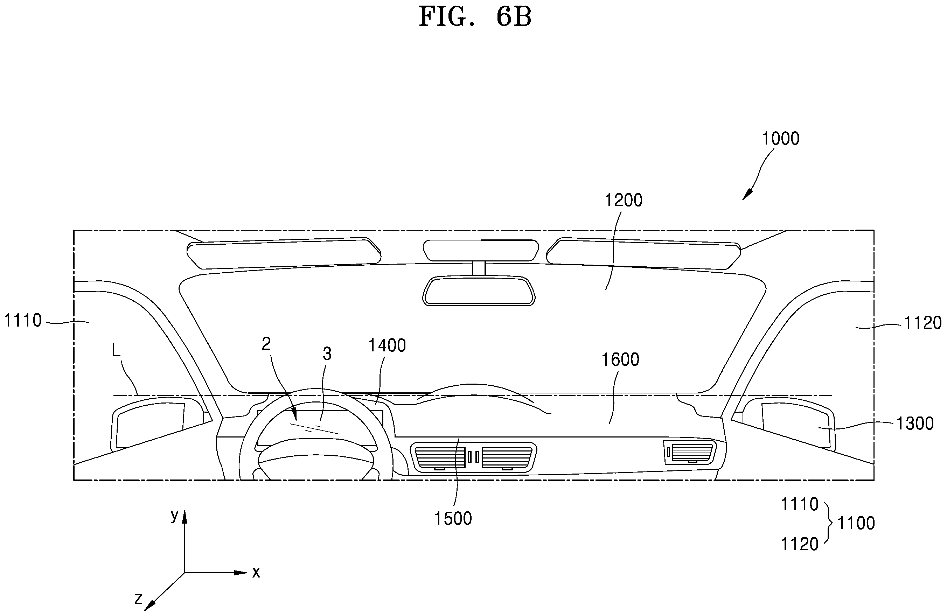

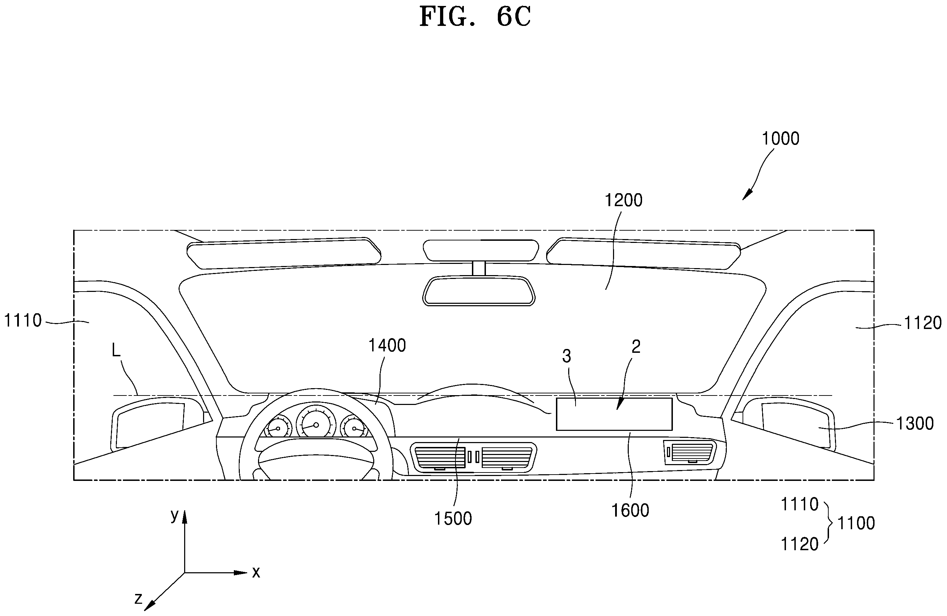

Referring to FIGs. 5, 6A, 6B, and 6C, the vehicle 1000 may refer to one or more suitable apparatuses for moving an object to be transported, such as a human, an object, or an animal, from a departure point to a destination point. The vehicle 1000 may include a vehicle traveling on a road or a track, a vessel moving over the sea or a river, an airplane flying in the sky utilizing the action of air, and/or the like.

In one or more embodiments, the vehicle 1000 may travel on a road or a track. The vehicle 1000 may move in a set or predetermined direction according to rotation of at least one wheel thereof. For example, the vehicle 1000 may include a three-wheeled or four-wheeled vehicle, a construction machine, a two-wheeled vehicle, a prime mover device, a bicycle, or a train running on a track.

The vehicle 1000 may include a body having an interior and an exterior, and a chassis in which mechanical apparatuses necessary for driving are installed as other parts except for the body. The exterior of the body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on a side of the vehicle 1000. In some embodiments, the side window glass 1100 may be installed on a door of the vehicle 1000. A plurality of side window glasses 1100 may be provided and may face each other. In some embodiments, the side window glass 1100 may include a first side window glass 1110 and a second side window glass 1120. In some embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in the x-direction or the -x-direction (the direction opposite the x-direction). For example, in some embodiments, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In some embodiments, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning light, a seat belt warning light, an odometer, a hodometer, an automatic shift selector indicator, a door open warning light, an engine oil warning light, and /or a low fuel warning light.

The center fascia 1500 may include a control panel on which a plurality of buttons for adjusting an audio device, an air conditioning device, and/or a heater of a seat are disposed. The center fascia 1500 may be arranged on one side of the cluster 1400.

The passenger seat dashboard 1600 may be spaced apart from the cluster 1400 with the center fascia 1500 arranged therebetween. In some embodiments, the cluster 1400 may be arranged to correspond to a driver seat, and the passenger seat dashboard 1600 may be disposed to correspond to a passenger seat. In some embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In some embodiments, the display device 2 may be arranged between the side window glasses 1100 facing each other. The display device 2 may be arranged on at least one of the cluster 1400, the center fascia 1500, or the passenger seat dashboard 1600.

The display device 2 may include an organic light-emitting display device, an inorganic EL display device, a quantum dot display device, and/or the like. Hereinafter, as the display device 2 according to one or more embodiments of the disclosure, an organic light-emitting display device including the light-emitting device according to the disclosure will be described as an example, but one or more suitable types (kinds) of display devices as described above may be utilized in embodiments of the disclosure.

Referring to FIG. 6A, in one or more embodiments, the display device 2 may be arranged on the center fascia 1500. In some embodiments, the display device 2 may display navigation information. In some embodiments, the display device 2 may display audio, video, or information regarding vehicle settings.

Referring to FIG. 6B, in one or more embodiments, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

Referring to FIG. 6C, in one or more embodiments, the display device 2 may be arranged on the passenger seat dashboard 1600. The display device 2 may be embedded in the passenger seat dashboard 1600 or arranged on the passenger seat dashboard 1600. In some embodiments, the display device 2 arranged on the passenger seat dashboard 1600 seat may display an image related to information displayed on the cluster 1400 and/or information displayed on the center fascia 1500. In some embodiments, the display device 2 arranged on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may each be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are each formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed and the structure of a layer to be formed.

### Definition of Terms

The term "C₃-C₆₀ carbocyclic group" as utilized herein refers to a cyclic group including (e.g., consisting of) carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group including (e.g., consisting of) one (e.g., exactly one) ring or a polycyclic group in which two or more rings are condensed with each other. For example, the number of ring-forming atoms of the C₁-C₆₀ heterocyclic group may be from 3 to 61.

The term "cyclic group" as utilized herein may include both the C₃-C₆₀ carbocyclic group and the C₁-C₆₀ heterocyclic group.

The term "π electron-rich C₃-C₆₀ cyclic group" as utilized herein refers to a cyclic group that has 3 to 60 carbon atoms and does not include *-N=*' as a ring-forming moiety, and the term "π electron-deficient nitrogen-containing C₁-C₆₀ heterocyclic group" as utilized herein refers to a heterocyclic group that has 1 to 60 carbon atoms and includes *-N=*' as a ring-forming moiety.

For example,
the C₃-C₆₀ carbocyclic group may be i) Group T1 (e.g., one or more of the groups in Group T1) or ii) a condensed cyclic group in which two or more of Group T1 (e.g., two or more of the groups in Group T1) are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 (e.g., at least one of the groups in Group T2) and at least one Group T1 (e.g., at least one of the groups in Group T1) are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ heterocyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group," "C₃-C₆₀ carbocyclic group," "C₁-C₆₀ heterocyclic group," "π electron-rich C₃-C₆₀ cyclic group," or "π electron-deficient nitrogen-containing C₁-C₆₀ heterocyclic group" as utilized herein may refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Non-limiting examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Non-limiting examples of the divalent C₃-C₆₀ carbocyclic group and the divalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and non-limiting examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having substantially the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of a C₂-C₆₀ alkyl group, and non-limiting examples thereof are an ethenyl group, a propenyl group, a butenyl group, and/or the like. The term "C₂-C₆₀ alkenylene group" as utilized herein refers to a divalent group having substantially the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of a C₂-C₆₀ alkyl group, and non-limiting examples thereof are an ethynyl group, a propynyl group, and/or the like. The term "C₂-C₆₀ alkynylene group" as utilized herein refers to a divalent group having substantially the same structure as the C₂-C₆₀ alkynyl group.

The term "C₁-C₆₀ alkoxy group" as utilized herein refers to a monovalent group represented by -OA₁₀₁ (wherein A₁₀₁ is a C₁-C₆₀ alkyl group), and non-limiting examples thereof are a methoxy group, an ethoxy group, an isopropyloxy group, and/or the like.

The term "C₃-C₁₀ cycloalkyl group" as utilized herein refers to a monovalent saturated hydrocarbon cyclic group having 3 to 10 carbon atoms, and non-limiting examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptanyl group), a bicyclo[1.1.1]pentyl group, a bicyclo[2.1.1]hexyl group, a bicyclo[2.2.2]octyl group, and/or the like. The term "C₃-C₁₀ cycloalkylene group" as utilized herein refers to a divalent group having substantially the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and non-limiting examples thereof are a 1,2,3,4-oxatriazolidinyl group, a tetrahydrofuranyl group, a tetrahydrothiophenyl group, and/or the like. The term "C₁-C₁₀ heterocycloalkylene group" as utilized herein refers to a divalent group having substantially the same structure as the C₁-C₁₀ heterocycloalkyl group.

The term "C₃-C₁₀ cycloalkenyl group" as utilized herein refers to a monovalent cyclic group that has three to ten carbon atoms and at least one carbon-carbon double bond in the ring thereof and no aromaticity, and non-limiting examples thereof are a cyclopentenyl group, a cyclohexenyl group, a cycloheptenyl group, and/or the like. The term "C₃-C₁₀ cycloalkenylene group" as utilized herein refers to a divalent group having substantially the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one double bond in the cyclic structure thereof. Non-limiting examples of the C₁-C₁₀ heterocycloalkenyl group are a 4,5-dihydro-1,2,3,4-oxatriazolyl group, a 2,3-dihydrofuranyl group, a 2,3-dihydrothiophenyl group, and/or the like. The term "C₁-C₁₀ heterocycloalkenylene group" as utilized herein refers to a divalent group having substantially the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Non-limiting examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Non-limiting examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure as a whole. Non-limiting examples of the monovalent non-aromatic condensed polycyclic group are an indenyl group, a fluorenyl group, a spiro-bifluorenyl group, a benzofluorenyl group, an indenophenanthrenyl group, an indeno anthracenyl group, and/or the like. The term "divalent non-aromatic condensed polycyclic group" as utilized herein refers to a divalent group having substantially the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure as a whole. Non-limiting examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having substantially the same structure as the monovalent non-aromatic condensed heteropolycyclic group described above.

The term "C₆-C₆₀ aryloxy group" as utilized herein indicates -OA₁₀₂ (wherein A₁₀₂ is a C₆-C₆₀ aryl group), and the term "C₆-C₆₀ arylthio group" as utilized herein indicates -SA₁₀₃ (wherein A₁₀₃ is a C₆-C₆₀ aryl group).

The term "C₇-C₆₀ arylalkyl group" as utilized herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as utilized herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q₃, Q₁₁ to Q₁₃, Q₂₁ to Q₂₃, and Q₃₁ to Q₃₃ utilized herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ aryl alkyl group; or a C₂-C₆₀ heteroaryl alkyl group.

The term "heteroatom" as utilized herein refers to any atom other than a carbon atom. Non-limiting examples of the heteroatom are O, S, N, P, Si, B, Ge, Se, and any combination thereof.

The term "third-row transition metal" as utilized herein includes Hf, Ta, W, Re, Os, Ir, Pt, Au, and/or the like.

"Ph" as utilized herein refers to a phenyl group, "Me" as utilized herein refers to a methyl group, "Et" as utilized herein refers to an ethyl group, "tert-Bu" or "Bu*" as utilized herein refers to a tert-butyl group, and "OMe" as utilized herein refers to a methoxy group.

The term "biphenyl group" as utilized herein refers to "a phenyl group substituted with a phenyl group." In some embodiments, the "biphenyl group" may be a substituted phenyl group having a C₆-C₆₀ aryl group as a substituent.

The term "terphenyl group" as utilized herein refers to "a phenyl group substituted with a biphenyl group." In some embodiments, the "terphenyl group" may be a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

In the present disclosure, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Hereinafter, compounds according to one or more embodiments and light-emitting devices according to one or more embodiments will be described in more detail with reference to the following Synthesis Examples and Examples. The wording "B was utilized instead of A" utilized in describing Synthesis Examples refers to that an identical molar equivalent of B was utilized in place of A.

### Examples

### Synthesis Example 1: Synthesis of Compound 10

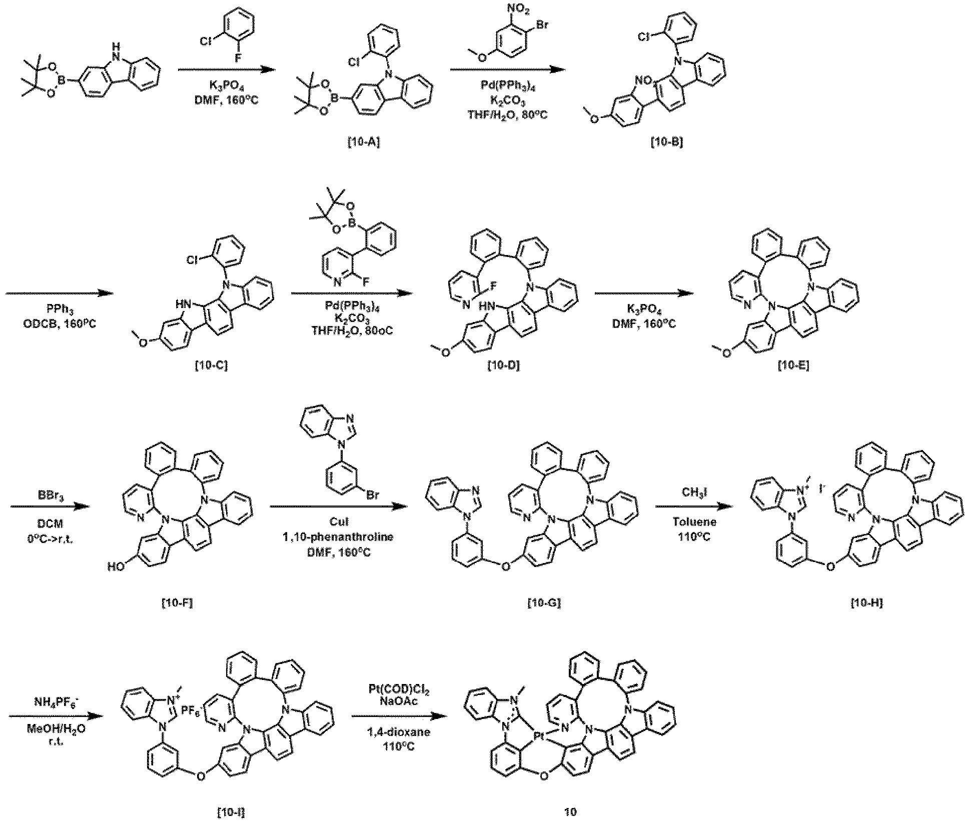

### 1) Synthesis of Intermediate [10-A]

2-(4,4,5,5-tetramethyl-1,3,2-dioxaborolan-2-yl)-9H-carbazole (7.0 mmol, 2.1 g), 1-chloro-2-fluorobenzene (10.5 mmol, 1.4 g), and potassium phosphate tribasic (21.0 mmol, 4.5 g) were placed in a reaction vessel and suspended in 70 mL of dimethylformamide (DMF). The reaction mixture was heated at 160 °C and stirred for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 2.3 g (5.7 mmol) of a target compound.

### 2) Synthesis of Intermediate [10-B]

Intermediate [10-A] (5.7 mmol, 2.3 g), 1-bromo-4-methoxy-2-nitrobenzene (6.8 mmol, 1.6 g), tetrakis(triphenylphosphine)palladium (0.3 mmol, 0.3 g), and potassium carbonate (11.4 mmol, 1.6 g) were placed in a reaction vessel and suspended in 60 mL of a mixture including tetrahydrofuran and water in a volume ratio of 3:1. The reaction mixture was heated and stirred under reflux for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 2.0 g (4.6 mmol) of a target compound.

### 3) Synthesis of Intermediate [10-C]

Intermediate [10-B] (4.6 mmol, 2.0 g) and triphenylphosphine (9.2 mmol, 2.4 g) were placed in a reaction vessel and suspended in 45 mL of 1,2-dichlorobenzene (o-DCB). The reaction mixture was heated at 160 °C and stirred for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 1.1 g (2.8 mmol) of a target compound.

### 4) Synthesis of Intermediate [10-D]

Intermediate [10-C] (2.8 mmol, 1.1 g), 2-fluoro-3-(2-(4,4,5,5-tetramethyl-1,3,2-dioxaborolan-2-yl)phenyl)pyridine (3.4 mmol, 1.0 g), tetrakis(triphenylphosphine)palladium (0.14 mmol, 160 mg), potassium carbonate (5.6 mmol, 770 mg) were added to a reaction vessel and suspended in 30 mL of a mixture including tetrahydrofuran and water in a volume ratio of 3:1. The reaction mixture was heated and stirred under reflux for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 1.1 g (2.0 mmol) of a target compound.

### 5) Synthesis of Intermediate [10-E]

Intermediate [10-D] (2.0 mol, 1.1 g) and potassium phosphate (6.0 mol, 1.3 g) were added to a reaction vessel and suspended in 20 mL of DMF. The reaction mixture was heated to 160 °C and stirred for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 820 mg (1.6 mmol) of a target compound.

### 6) Synthesis of Intermediate [10-F]

Intermediate [10-E] (1.6 mmol, 820 mg) was suspended in 15 mL of dichloromethane, and the reaction temperature was lowered to 0 °C. 1.9 mL of boron tribromide 1.0 M dichloromethane was slowly added dropwise, and the reaction temperature was raised to room temperature and stirred for 24 hours. After completion of the reaction, the reaction mixture was neutralized and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 550 mg (1.1 mmol) of a target compound.

### 7) Synthesis of Intermediate [10-G]

Intermediate [10-F] (1.1 mmol, 550 mg), 1-(3-bromophenyl)-1H-benzo[d]imidazole (1.3 mmol, 360 mg), potassium phosphate (2.2 mmol, 470 mg), iodo copper(I) (0.11 mmol, 20 mg), and 1,10-phenanthroline (0.11 mmol, 20 mg) were placed in a reaction vessel and suspended in 10 mL of dimethyl sulfoxide. The reaction mixture was heated to a temperature of 160 °C and stirred for 12 hours. After completion of the reaction, the reaction result was cooled at room temperature, 20 mL of distilled water was added thereto, and an extraction process was performed thereon by utilizing ethyl acetate. The extracted organic layer was washed with a saturated aqueous sodium chloride solution and dried by utilizing sodium sulfate. A residue obtained by removing a solvent therefrom was separated by column chromatography to obtain 550 mg (0.8 mmol) of a target compound.

### 8) Synthesis of Intermediate [10-H]

Intermediate [10-G] (0.8 mmol, 550 mg) and methane iodide (1.6 mmol, 230 mg) were added to a reaction vessel and suspended in 10 mL of toluene. The reaction mixture was heated to a temperature of 110 °C and stirred for 3 hours. After completion of the reaction, the reaction mixture was cooled to room temperature, a portion of the solvent was removed, distilled water was added thereto, and the resulting solid was obtained by filtering. The filtered solid was purified utilizing a recrystallization method to obtain 470 mg (0.56 mmol) of the target compound.

### 9) Synthesis of Intermediate [10-I]

Intermediate [10-H] (0.56 mmol, 470 mg) and ammonium hexafluorophosphate (1.1 mmol, 180 mg) were added to a reaction vessel and suspended in a solution including methanol and water in the ratio of 2:1. The reaction mixture was stirred at room temperature for 12 hours. The resulting solid was obtained by filtering and purified utilizing a recrystallization method to obtain 450 mg (0.53 mmol) of a target compound.

### 10) Synthesis of Compound 10

Intermediate [10-I] (0.53 mmol, 450 mg), dichloro(1,5-cyclooctadiene)platinum (0.58 mmol, 220 mg), and sodium acetate (1.6 mmol, 130 mg) were suspended in 20 mL of dioxane. The reaction mixture was heated and stirred at 110 °C for 24 hours. After completion of the reaction, the reaction result was cooled at room temperature, 20 mL of distilled water was added thereto, and an extraction process was performed thereon by utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 100 mg (0.11 mmol) of a target compound.

### Synthesis Example 2: Synthesis of Compound 21

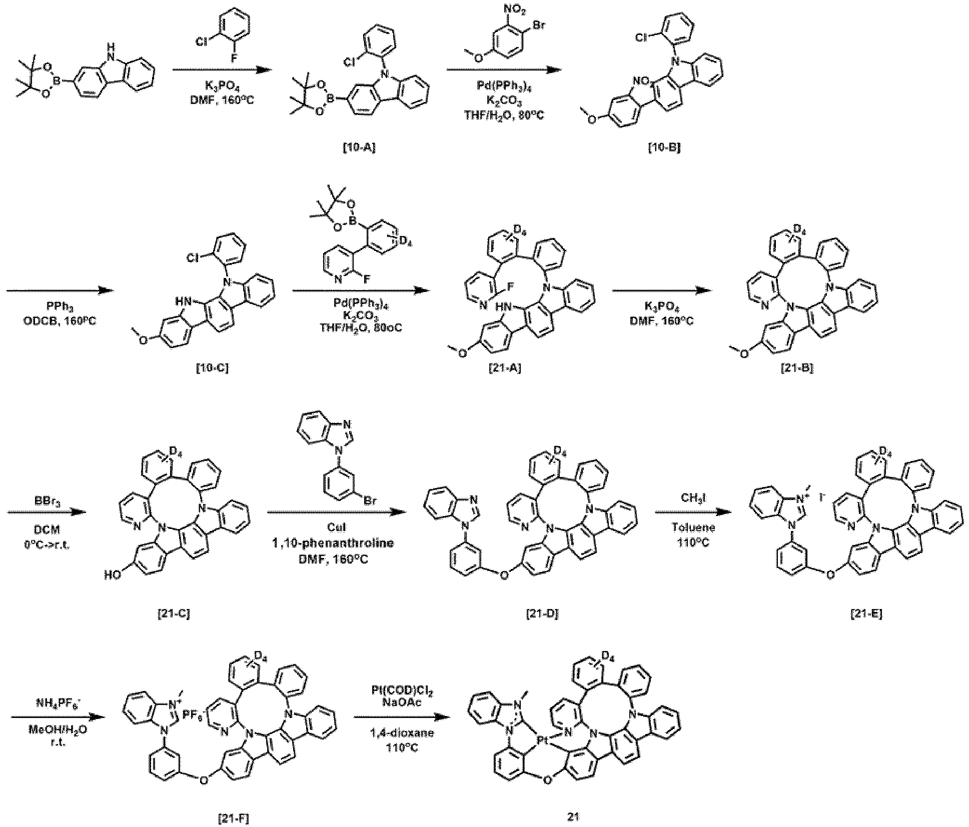

100 mg (0.11 mmol) of Compound 21 was obtained in substantially the same manner as in Synthesis Example 1, except that 2-fluoro-3-(2-(4,4,5,5-tetramethyl-1,3,2-dioxaborolan-2-yl)phenyl-3,4,5,6-d4)pyridine was utilized instead of 2-fluoro-3-(2-(4,4,5,5-tetramethyl-1,3,2-dioxaborolan-2-yl)phenyl)pyridine.

### Synthesis Example 3: Synthesis of Compound 36

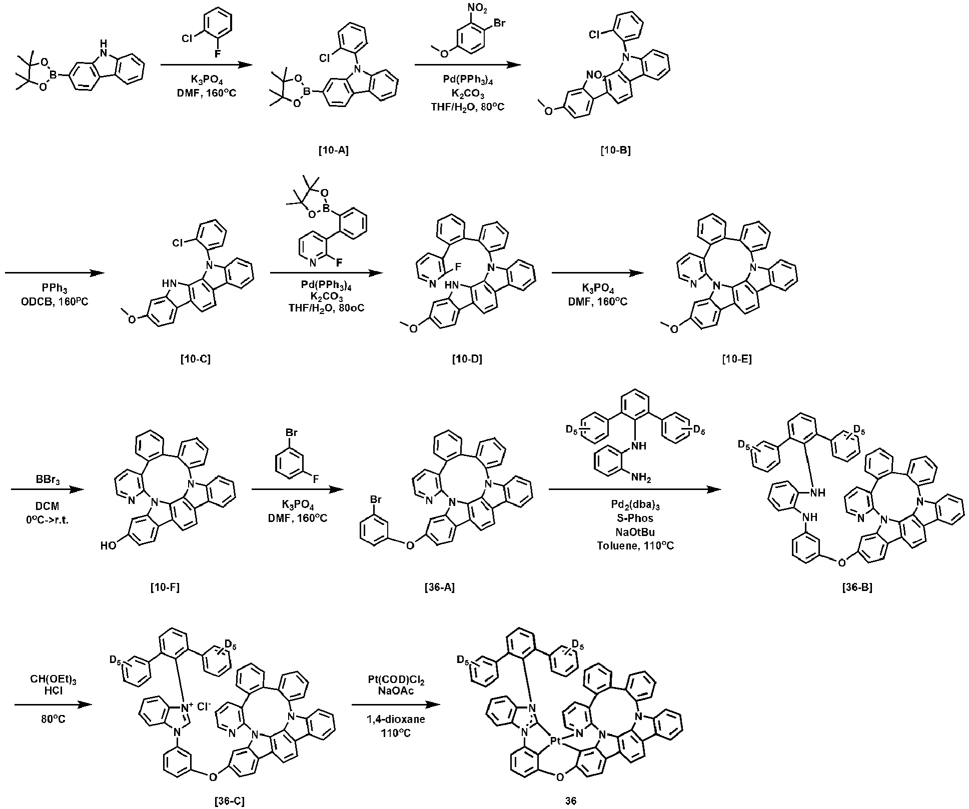

### 1) Synthesis of Intermediate [36-A]

Intermediate [10-F] (1.6 mmol, 800 mg), 1-bromo-3-fluorobenzene (3.2 mmol, 560 mg), and potassium phosphate (4.8 mmol, 1.0 g) were added to a reaction vessel and suspended in 20 mL of DMF. The reaction mixture was heated to 160 °C and stirred for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 720 mg (1.1 mmol) of a target compound.

### 2) Synthesis of Intermediate [36-B]

Intermediate [36-A] (1.1 mmol, 720 mg), N1-([1,1':3',1"-terphenyl]-2'-yl-2,2",3,3",4,4",5,5",6,6"-d10)benzene-1,2-diamine (1.3 mmol, 450 mg), tris(dibenzylideneacetone)dipalladium (0. 06 mmol, 55 mg), 2-dicyclohexylphosphino-2',6'-dimethoxybiphenyl (SPhos) (0.11 mmol, 45 mg), sodium tert-butoxide (3.3 mmol, 320 mg) were suspended in 10 mL of toluene in a reaction vessel. The reaction temperature was raised to 110 °C, and the reaction mixture was stirred for 3 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 820 mg (0.85 mmol) of a target compound.

### 3) Synthesis of Intermediate [36-C]

Intermediate [36-B] (0.85 mmol, 820 mg), triethyl orthoformate (46.8 mmol, 6.9 g) and a 35 wt% solution of HCl (4.7 mmol, 0.39 mL) were added to a reaction vessel, heated and stirred at 80 °C for 12 hours. After completion of the reaction, the reaction mixture was cooled to room temperature, and a residue obtained by removing a solvent therefrom was separated by column chromatography to obtain 640 mg (0.64 mmol) of a target compound.

### 4) Synthesis of Compound 36

Intermediate [36-C] (0.64 mmol, 640 mg), dichloro(1,5-cyclooctadiene)platinum (0.70 mmol, 260 mg), and sodium acetate (1.9 mmol, 160 mg) were suspended in 25 mL of dioxane. The reaction mixture was heated and stirred at 110 °C for 24 hours. After completion of the reaction, the reaction mixture was cooled to room temperature, and was subjected to an extraction process utilizing ethyl acetate. An organic layer extracted therefrom was washed with a saturated aqueous sodium chloride solution, and dried by utilizing sodium sulfate. A residue obtained by removing a solvent therefrom was separated by column chromatography to obtain 120 mg (0.11 mmol) of a target compound.

### Synthesis Example 4: Synthesis of Compound 48

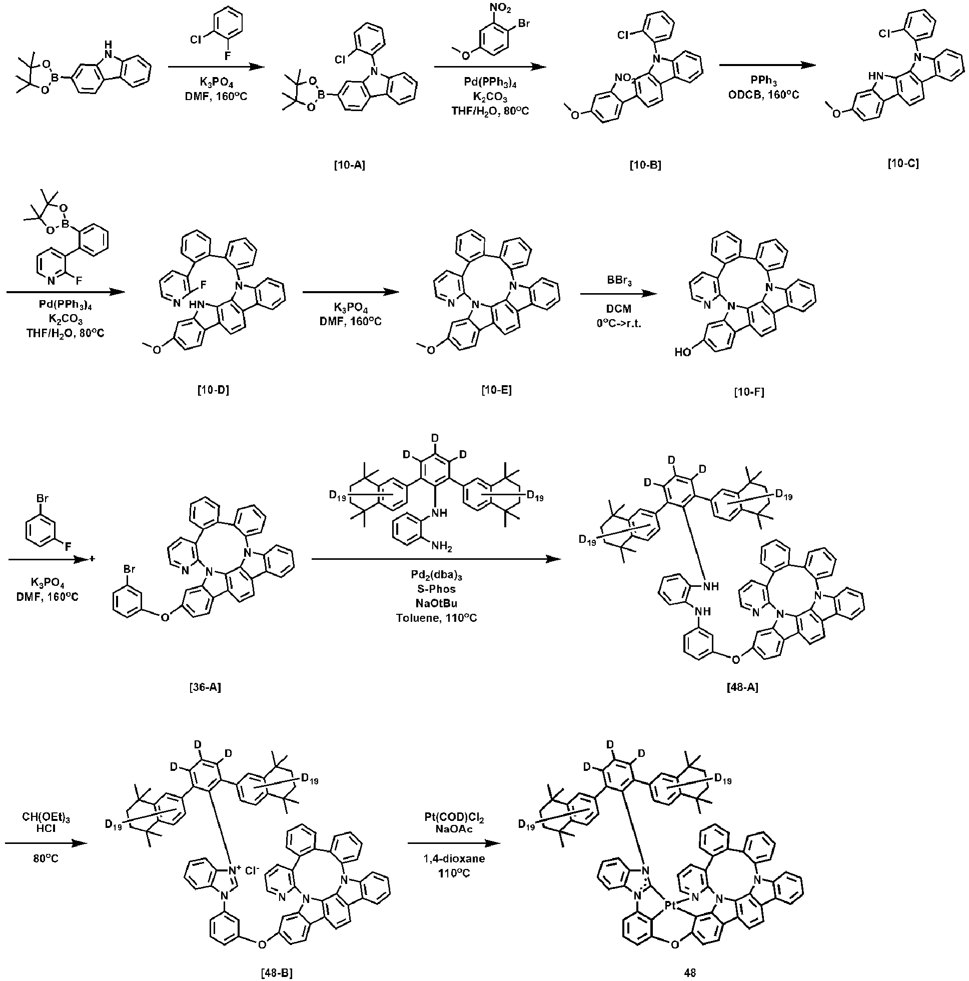

160 mg (0.11 mmol) of Compound 48 was obtained in substantially the same manner as in Synthesis Example 3, except that N1-(2-(5,5,8,8-tetrakis(methyl-d3)-5,6,7,8-tetrahydronaphthalen-2-yl-1,3,4,6,6,7,7-d7)-6-(5,5,8,8-tetrakis(methyl-d3)-5,6,7,8-tetrahydronaphthalen-2-yl-1,3,4,6,6,7,7-d7)phenyl-3,4,5-d3)benzene-1,2-diamine was utilized instead of N1-([1,1':3',1"-terphenyl]-2'-yl-2,2",3,3",4,4",5,5",6,6"-d10)benzene-1,2-diamine.

¹H nuclear magnetic resonance spectroscopy (NMR) and mass spectroscopy/fast atom bombardment (MS/FAB) of the compounds synthesized according to Synthesis Examples are shown in Table 1. Synthesis methods of compounds other than the compounds synthesized in Synthesis Examples above may be easily recognized by those skilled in the art by referring to the synthesis paths and source materials.

**Table 1**

| Compo und No. | ¹H NMR (CDCl₃, 400 MHz) | MS/FAB | |
|---|---|---|---|
| | | found | calc. |
| 10 | 8.96 (m, 1H), 8.59 (m, 1H), 8.40-8.38 (m, 2H), 8.14 (m, 1H), 8.01 (m, 1H), 7.66-7.64 (m, 2H), 7.60-7.56 (m, 2H), 7.51-7.47 (m, 3H), 7.44-7.41 (m, 5H), 7.32 (m, 1H), 7.13-7.11 (m, 3H), 6.88 (m, 1H), 7.70-7.65 (m, 3H), 3.35 (s, 3H) | 898.2015 | 898.2020 |
| 21 | 8.98 (m, 1H), 8.61 (m, 1H), 8.41-8.38 (m, 2H), 8.15 (m, 1H), 7.99 (m, 1H), 7.65-7.63 (m, 2H), 7.59-7.57 (m, 2H), 7.53-7.49 (m, 2H), 7.45-7.40 (m, 2H), 7.33 (m, 1H), 7.15-7.10 (m, 3H), 6.90 (m, 1H), 7.69-7.65 (m, 3H), 3.33 (s, 3H) | 902.2264 | 902.2271 |
| 36 | 8.89 (m, 1H), 8.54 (m, 1H), 8.41 (m, 1H), 8.25-8.23 (m, 3H), 8.11 (m, 1H), 7.96 (m, 1H), 7.62-7.51 (m, 7H), 7.45-7.37 (m, 5H), 7.16-7.13 (m, 4H), 6.96-6.93 (m, 3H), 6.68-6.65 (m, 2H) | 1122.343 5 | 1122.343 0 |
| 48 | 8.85 (m, 1H), 8.53 (m, 1H), 8.41 (m, 1H), 8.15-8.12 (m, 2H), 7.95 (m, 1H), 7.63-7.45 (m, 9H), 7.38-7.35 (m, 2H), 7.17-7.15 (m, 4H), 7.01-6.97 (m, 3H), 6.66-6.65 (m, 2H) | 1373.756 1 | 1373.756 7 |

### Evaluation Example 1

The HOMO and LUMO energy levels of each of Compounds 10, 21, 36, 48, and CE were evaluated according to the method shown in Table 2, and results thereof are shown in Table 3.

**Table 2**

| | |
|---|---|
| HOMO energy level evaluation method | By utilizing cyclic voltammetry (CV) (electrolyte: 0.1 M Bu₄NPF₆ / solvent: dimethylformamide (DMF) / electrode: 3-electrode system (working electrode: glassy carbon (GC), reference electrode: Ag/AgCI, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M Bu₄NPF₆ / solvent: dimethylformamide (DMF) / electrode: 3-electrode system (working electrode: GC, reference electrode: Ag/AgCI, and auxiliary electrode: Pt)), the potential (V)-current (A) graph of each compound was obtained, and then, from the reduction onset of the graph, the LUMO energy level of each compound was calculated. |

**Table 3**

| Compound No. | HOMO (eV) | LUMO (eV) |
|---|---|---|
| 10 | -5.25 | -1.95 |
| 21 | -5.26 | -1.97 |
| 36 | -5.31 | -2.05 |
| 48 | -5.32 | -2.06 |
| CE | -5.33 | -1.99 |

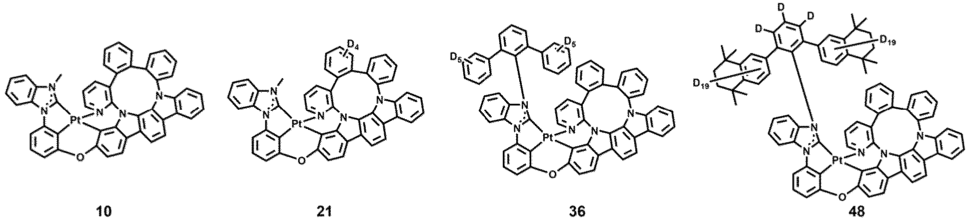

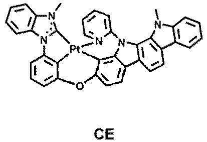

### Evaluation Example 2

Polymethyl methacrylate (PMMA) in CH₂Cl₂ solution and Compound 10 (4 wt% relative to PMMA) were mixed each other, and then, the resulting product was applied to a quartz substrate by utilizing a spin coater. Heat treatment was then performed thereon in an oven at 80 °C, followed by cooling at room temperature, so as to prepare Film 1 having a thickness of 40 nm. Subsequently, Films 2 to 5 were each manufactured in substantially the same manner as utilized to manufacture Film 1, except that Compounds 21, 36, 48, and CE were respectively utilized instead of Compound 10.

For each of Films 1 to 5, an emission spectrum was measured by utilizing Quantaurus-QY Absolute PL quantum yield spectrometer manufactured by Hamamatsu Company (utilizing a xenon light source and equipped with a monochromator, a photonic multichannel analyzer, and integrating spheres, and utilizing PLQY measurement software (Hamamatsu Photonics, Ltd., Shizuoka, Japan)). During the measurement, an excitation wavelength was scanned from 320 nm to 380 nm at intervals of 10 nm, and a spectrum measured at the excitation wavelength of 340 nm was taken to obtain a maximum emission wavelength (emission peak wavelength) and FWHM of an organometallic compound included in each film, which are shown in Table 4.

The luminescence quantum efficiency of each of Films 1 to 5 was measured by scanning the excitation wavelength from 300 nm to 380 nm at intervals of 10 nm utilizing a Quantaurus-QY Absolute PL quantum yield spectrometer of Hamamatsu, and the luminescence quantum efficiency (PLQY) measured at an excitation wavelength of 330 nm was obtained, from which the luminescence quantum efficiency of the organometallic compound included in each film was obtained and is summarized in Table 4.

**Table 4**

| Film No. | Film composition (4 wt% in PMMA) | Maximum emission wavelength (nm) | FWHM (nm) | PLQY (%) |
|---|---|---|---|---|
| 1 | 10 | 470 | 98 | 69 |
| 2 | 21 | 471 | 97 | 70 |
| 3 | 36 | 475 | 51 | 81 |
| 4 | 48 | 473 | 48 | 84 |
| 5 | CE | 462 | 121 | 57 |

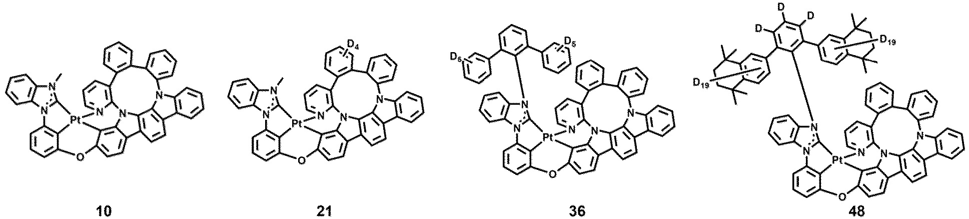

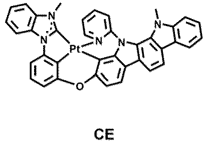

From Table 4, it can be seen that Compounds 10, 21, 36, and 48 emit blue light having excellent or suitable PLQY and narrow FWHM compared to Compound CE.

### Example 1

As an anode, a Corning 15 Ω/cm² (1,200 Å) ITO glass substrate was cut to a size of 50 mm x 50 mm x 0.7 mm, sonicated with isopropyl alcohol and (then with) pure water each for 5 minutes, and then cleaned by exposure to ultraviolet rays and ozone for 30 minutes. The ITO glass substrate was provided to a vacuum deposition apparatus.

2-TNATA was vacuum-deposited on the ITO substrate to form a hole injection layer having a thickness of 600 Å, and then 4,4'-bis[N-(1-naphthyl)-N-phenylamino] biphenyl (hereinafter, NPB) as a hole transport compound was vacuum-deposited thereon to form a hole transport layer having a thickness of 300 Å.

Compound 10 in a blue fluorescent emission layer was concurrently (e.g., simultaneously) deposited on the hole transport layer at a ratio of 13 wt% together with an ETH2:HTH29 mixed host (weight ratio 3.5:6.5) to form an emission layer having a thickness of 350 Å.

Then, Compound HBL-1 was vacuum-deposited on the emission layer to form a hole blocking layer having a thickness of 50 Å. Then, a CNNPTRZ:LiQ mixed layer with a weight ratio of 4.0:6.0 was deposited on the hole blocking layer to form an electron transport layer having a thickness of 310 Å, and Yb was deposited on the electron transport layer to form an electron injection layer having a thickness of 15 Å, and Mg was vacuum deposited to form an electrode (cathode) having a thickness of 800 Å to complete manufacture of an organic light-emitting device.

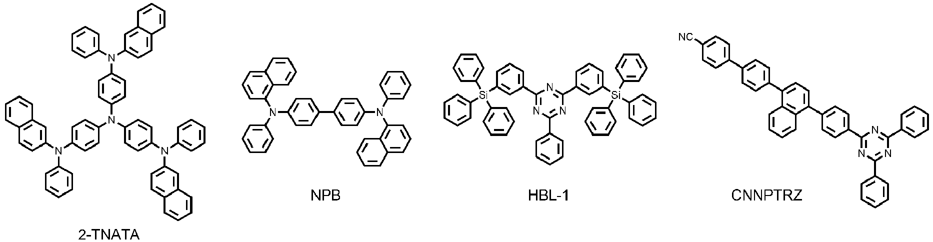

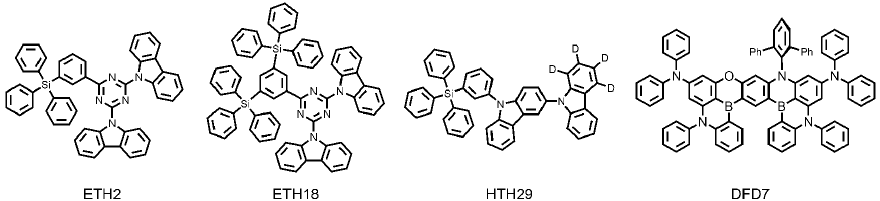

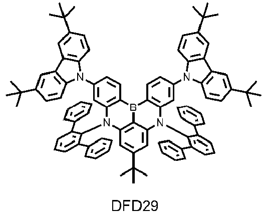

### Examples 2 to 6, and Comparative Example A

An organic-light emitting device was manufactured in substantially the same manner as in Example 1, except that when forming the emission layer, the compounds were changed as shown in Table 5.

**Table 5**

| No. | Organometa llic compound represented by Formula 1 | Second compound | Third compound | Fourth compound | Weight ratio of second compound to third compound |
|---|---|---|---|---|---|
| Example 1 | 10 (13 wt%) | ETH2 | HTH29 | - | 3.5 : 6.5 |
| Example 2 | 21 (13 wt%) | ETH2 | HTH29 | - | 3.5:6.5 |
| Example 3 | 36 (13 wt%) | ETH2 | HTH29 | - | 3.5:6.5 |
| Example 4 | 48 (13 wt%) | ETH2 | HTH29 | - | 3.5:6.5 |
| Example 5 | 36 (13 wt%) | ETH2 | HTH29 | DFD7 (0.4 wt%) | 3.5:6.5 |
| Example 6 | 36 (13 wt%) | ETH2 | HTH29 | DFD29 (1.2 wt%) | 3.5:6.5 |
| Comparati ve Example A | CE (13 wt%) | ETH2 | HTH29 | - | 3.5:6.5 |

### Evaluation Example 1

The driving voltage (V) at 1,000 cd/m², color purity (CIEx,y), luminescence efficiency (cd/A), color conversion efficiency (cd/A/y), maximum emission wavelength (nm), and lifespan (T₉₅) of each of the light-emitting devices manufactured according to Examples 1 to 6 and Comparative Example A were each measured by utilizing a Keithley MU 236 and a luminance meter PR650, and results thereof are shown in Table 6. In this regard, the lifespan (T₉₅) is a measure of the time (Hr) taken until the luminance declines to 95 % of the initial luminance. In Table 6, the color conversion efficiency ratio indicates the ratio (%) of the color conversion efficiency of each example when the color conversion efficiency of Comparative Example A is set to 100, and the lifespan ratio indicates the ratio (%) of the lifespan (T₉₅) of each example when the lifespan of Comparative Example A is set to 100.

**Table 6**

| No. | Organometallic compound represented by Formula 1 | Driving voltage (V) | Color conversion efficiency ratio | Lifespan ratio |
|---|---|---|---|---|
| Example 1 | 10 | 4.1 | 110 | 130 |
| Example 2 | 21 | 4.1 | 109 | 146 |
| Example 3 | 36 | 3.9 | 122 | 161 |
| Example 4 | 48 | 3.8 | 125 | 169 |
| Example 5 | 36 | 3.5 | 137 | 189 |
| Example 6 | 36 | 3.6 | 141 | 192 |
| Comparative Example A | CE | 4.3 | 100 | 100 |

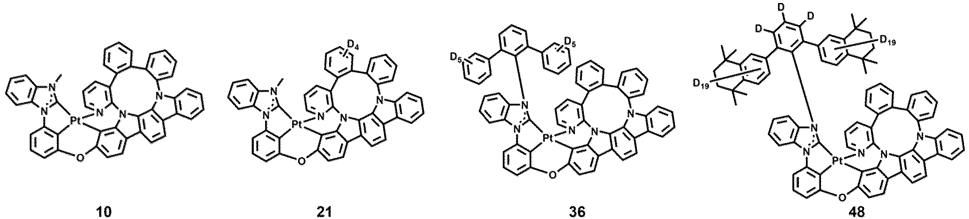

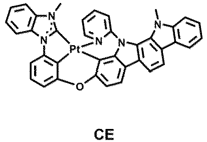

From the Table 6, it can be confirmed that the organic light-emitting devices according to Examples 1 to 6 each have smaller driving voltage, higher color conversion efficiency, and longer device lifespan, compared to the organic light-emitting device according to Comparative Example A.

By utilizing the organometallic compounds of the present disclosure, light-emitting devices and high-quality electronic apparatuses including the light-emitting devise, having reduced driving voltage, improved color purity and/or efficiency, and/or increased lifespan, may be manufactured.

In the present disclosure, it will be understood that the term "comprise(s)," "include(s)," or "have/has" specifies the presence of stated features, integers, steps, operations, elements, and/or components, but do not preclude the presence or addition of one or more other features, integers, steps, operations, elements, components, and/or groups thereof.

Throughout the present disclosure, when a component such as a layer, a film, a region, or a plate is mentioned to be placed "on" another component, it will be understood that it may be directly on another component or that another component may be interposed therebetween. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, although the terms "first," "second," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

The light-emitting device, the light-emitting apparatus, the display device, the electronic apparatus, the electronic device, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A light-emitting device (10) comprising:
a first electrode (110);
a second electrode (150) facing the first electrode (110); and
an interlayer (130) between the first electrode (110) and the second electrode (150) and
comprising an emission layer; and
an organometallic compound represented by Formula 1: 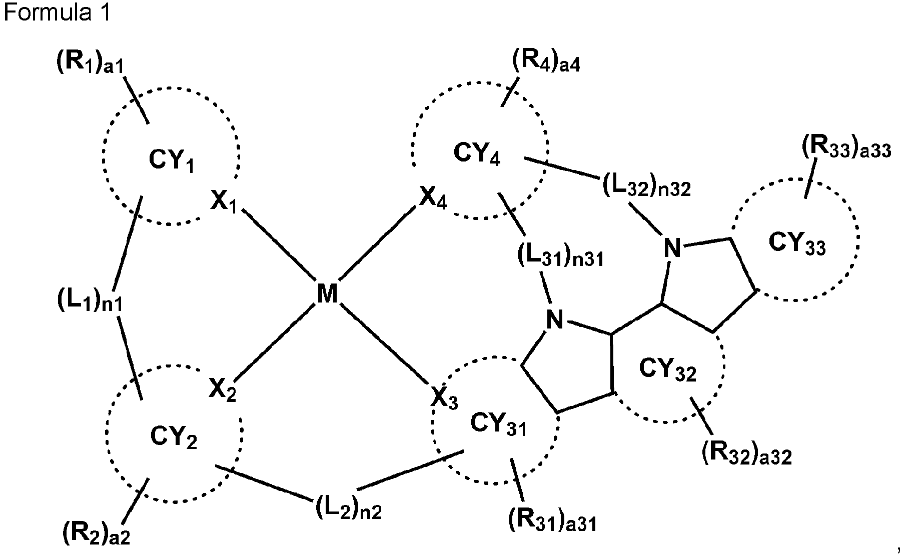 wherein, in Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁ to X₄ are each independently C or N,
ring CY₁, ring CY₂, ring CY₃₁ to ring CY₃₃, and ring CY₄ are each independently a C₅-C₃₀ carbocyclic group or a C₁-C₃₀ heterocyclic group,
L₁, L₂, L₃₁, and L₃₂ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C=C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', *-Ge(R₁ₐ)(R_{1b})-*', a C₅-C₃₀ carbocyclic group unsubstituted or substituted with at least one R₁₀ₐ, or a C₁-C₃₀ heterocyclic group unsubstituted or substituted with at least one R₁₀ₐ, * and *' each indicating a binding site to a neighboring atom,
n1, n2, n31, and n32 are each independently an integer from 1 to 10, R₁, R₂, R₃₁ to R₃₃, R₄, R₁ₐ, and R_{1b} are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1, a2, a31 to a33, and a4 are each independently an integer from 1 to 20,
two or more adjacent groups selected from among a1 R₁(s), a2 R₂(s), a31 R₃₁(s), a32 R₃₂(s), a33 R₃₃(s), a4 R₄(s), R₁ₐ, and R_{1b} are optionally combined with each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
hydrogen, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently:
hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

2. The light-emitting device (10) of claim 1, wherein
the emission layer comprises a host and a dopant, and
the dopant comprises the organometallic compound represented by Formula 1.

3. The light-emitting device (10) of claim 1 or 2, further comprising
a second compound comprising at least one π electron-deficient nitrogen-containing C₁-C₆₀ heterocyclic group, a third compound comprising a group represented by Formula 3, a fourth compound capable of emitting delayed fluorescence, or any combination thereof,
wherein the organometallic compound, the second compound, the third compound, and the fourth compound are different from each other: 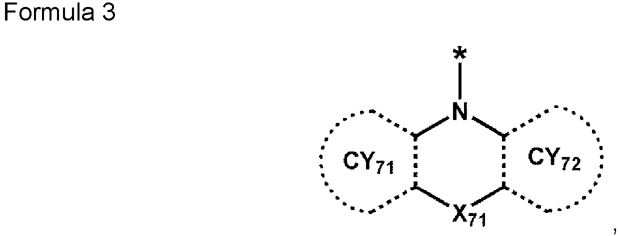 and wherein, in Formula 3,
ring CY₇₁ and ring CY₇₂ are each independently a π electron-rich C₃-C₆₀ cyclic group or a pyridine group,
X₇₁ is a single bond, or a linking group comprising O, S, N, B, C, Si, or any combination thereof, and
* indicates a binding site to any atom comprised in a remaining part other than the group represented by Formula 3 in the third compound.

4. The light-emitting device (10) of any one of claims 1 to 3, wherein
the second compound comprises a pyridine group, a pyrimidine group, a pyrazine group, a pyridazine group, a triazine group, or any combination thereof, and
the fourth compound is a compound comprising at least one cyclic group comprising each of boron (B) and nitrogen (N) as a ring-forming atom.

5. The light-emitting device of any one of claims 1 to 4, wherein
the emission layer comprises:
i) the organometallic compound; and
ii) the second compound, the third compound, the fourth compound, or any combination thereof, and
the emission layer is configured to emit blue light.

6. An electronic apparatus or an electronic equipment comprising the light-emitting device (10) of claim 1.

7. The electronic apparatus of claim 6, further comprising
a thin-film transistor, wherein
the thin-film transistor comprises a source electrode and a drain electrode, and
the first electrode of the light-emitting device is electrically connected to the source electrode or the drain electrode.

8. The electronic apparatus of claim 6, further comprising
a color filter, a color conversion layer, a touch screen layer, a polarizing layer, or any combination thereof.

9. An electronic equipment comprising the light-emitting device of claim 1.

10. The electronic equipment of claim 9, wherein
the electronic equipment is at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, or a signboard.

11. An organometallic compound represented by Formula 1: 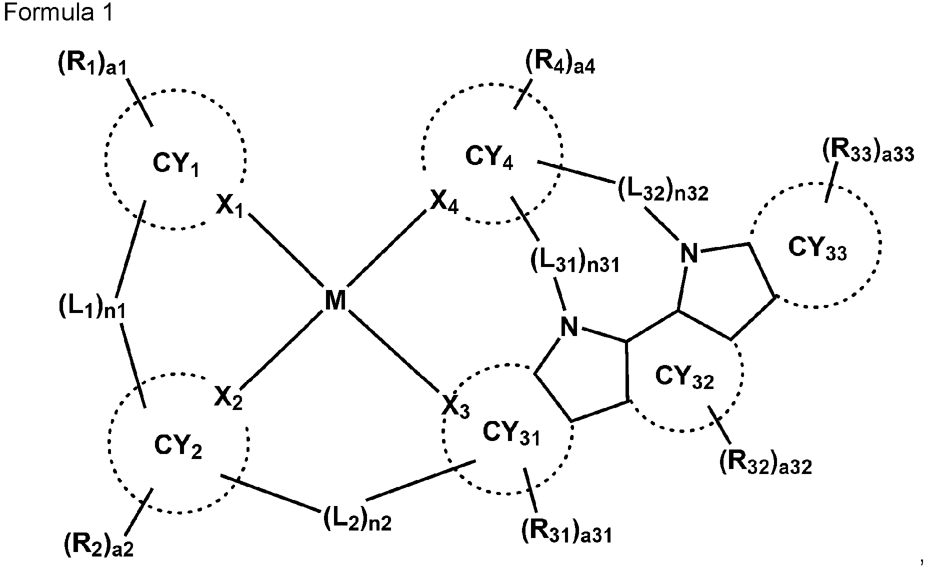 wherein, in Formula 1,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁ to X₄ are each independently C or N,
ring CY₁, ring CY₂, ring CY₃₁ to ring CY₃₃, and ring CY₄ are each independently a C₅-C₃₀ carbocyclic group or a C₁-C₃₀ heterocyclic group,
L₁, L₂, L₃₁, and L₃₂ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C=C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', *-Ge(R₁ₐ)(R_{1b})-*', a C₅-C₃₀ carbocyclic group unsubstituted or substituted with at least one R₁₀ₐ or a C₁-C₃₀ heterocyclic group unsubstituted or substituted with at least one R₁₀ₐ, * and *' each indicating a binding site to a neighboring atom,
n1, n2, n31, and n32 are each independently an integer from 1 to 10, R₁, R₂, R₃₁ to R₃₃, R₄, R₁ₐ, and R_{1b} are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1, a2, a31 to a33, and a4 are each independently an integer from 1 to 20,
two or more adjacent groups selected from among a1 R₁(s), a2 R₂(s), a31 R₃₁(s), a32 R₃₂(s), a33 R₃₃(s), a4 R₄(s), R₁ₐ, and R_{1b} are optionally combined with each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
hydrogen, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

12. The organometallic compound of claim 11, wherein
X₁, X₂, and X₃ are each C, and X₄ is N,
a bond between X₁ and M and a bond between X₄ and M are each a coordinate bond, and
a bond between X₂ and M and a bond between X₃ and M are each a covalent bond.

13. The organometallic compound of claim 11 or 12, wherein
ring CY₁, ring CY₂, ring CY₃₁ to ring CY₃₃, and ring CY₄ are each independently a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodisiline group, a dibenzodihydrosiline group, a dibenzodioxin group, a dibenzoxathiin group, a dibenzoxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group.

14. The organometallic compound of any one of claims 11 to 13, wherein
*-(L₃₂)ₙ₃₂-*', *-(L₃₁)ₙ₃₁-*', ring CY₄, ring CY₃₂, and two nitrogen atoms in Formula 1 forms a ring having 8 or more ring-forming atoms.

15. The organometallic compound of any one of claims 11 to 14, wherein
L₁ and L₃₁ are each a single bond,
L₂ is *-O-*' or *-S-*', and n2 is 1,
L₃₂ is a single bond, *-C(R₁ₐ)(R_{1b})-*', *-C(R₁ₐ)=C(R_{1b})-*', or *-Si(R₁ₐ)(R_{1b})-*'; or a phenylene group or a naphthylene group, each unsubstituted or substituted with at least one selected from among deuterium, a C₁-C₂₀ alkyl group, a C₁-C₂₀ alkoxy group, a phenyl group, and a naphthyl group,
R₁ₐ and R_{1b} are each the same as defined in Formula 1, and
R₁ₐ and R_{1b} are optionally be bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

16. The organometallic compound of any one of claims 11 to 15, wherein
R₁, R₂, R₃₁ to R₃₃, and R₄ are each independently:
hydrogen, deuterium, -F, a C₁-C₂₀ alkyl group, or a C₁-C₂₀ alkoxy group;
a C₁-C₂₀ alkyl group or a C₁-C₂₀ alkoxy group, each substituted with deuterium, -F, - CD₃, -CD₂H, -CDH₂, -CF₃, -CF₂H, -CFH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a phenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, each unsubstituted or substituted with deuterium, -F, -CD₃, - CD₂H, -CDH₂, -CF₃, -CF₂H, -CFH₂, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, -O(Q₃₁), -S(Q₃₁), -Si(Q₃₁)(Q₃₂)(Q₃₃), -N(Q₃₁)(Q₃₂), or any combination thereof; or
-C(Q₁)(Q₂)(Q₃), -Si(Q₁)(Q₂)(Q₃), -N(Q₁)(Q₂), and
wherein Q₁ to Q₃ and Q₃₁ to Q₃₃ are each independently: hydrogen; deuterium; -F; a C₁-C₆₀ alkyl group; a C₂-C₆₀ alkenyl group; a C₂-C₆₀ alkynyl group; a C₁-C₆₀ alkoxy group;
or a C₃-C₆₀ carbocyclic group or a C₁-C₆₀ heterocyclic group, each unsubstituted or substituted with deuterium, -F, a C₁-C₆₀ alkyl group, a C₁-C₆₀ alkoxy group, a phenyl group, a biphenyl group, or any combination thereof.

17. The organometallic compound of claim 11, wherein
a group represented by 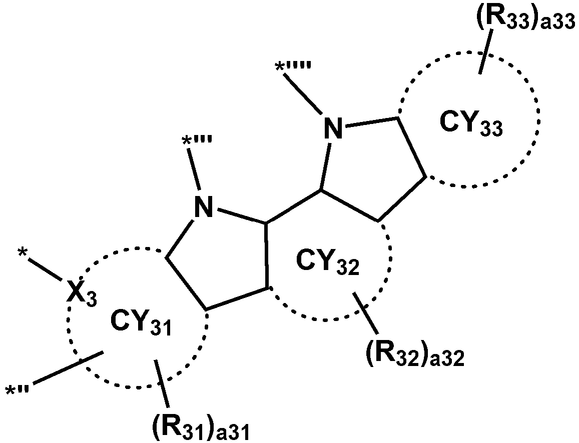 in Formula 1 is a group represented by one selected from among Formulae CY3(1) to CY3(16): 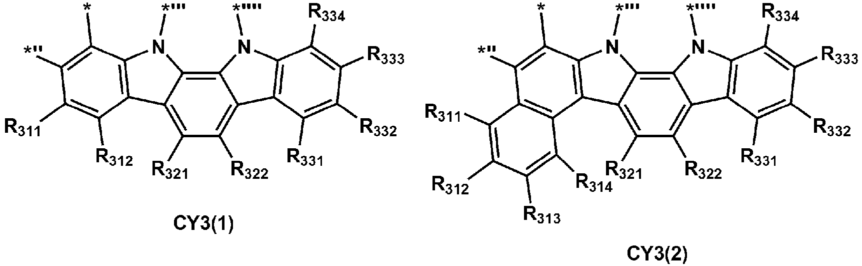 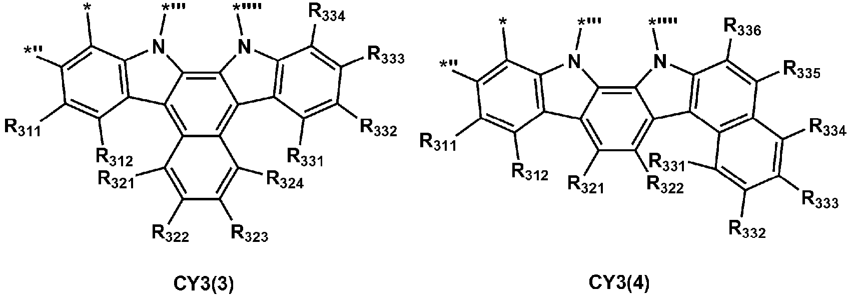 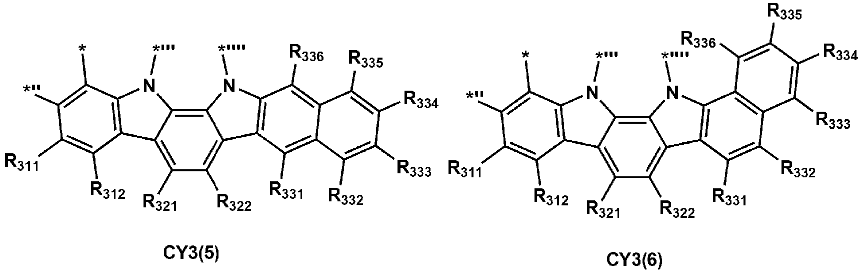 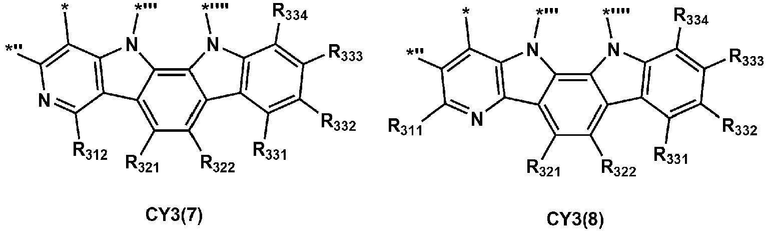 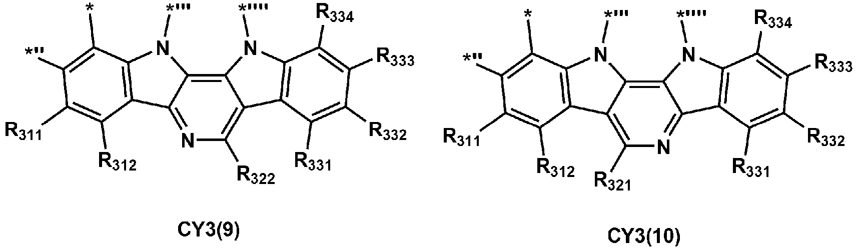 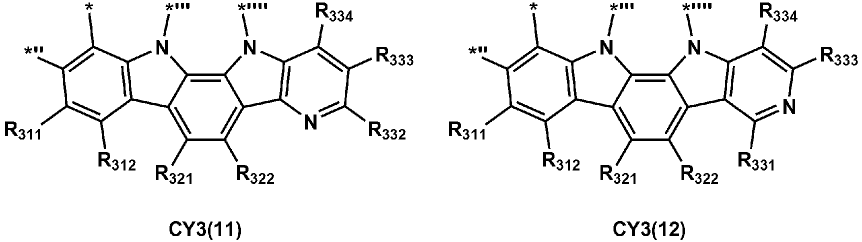 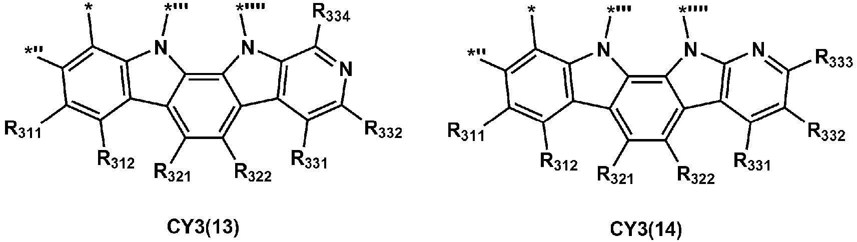 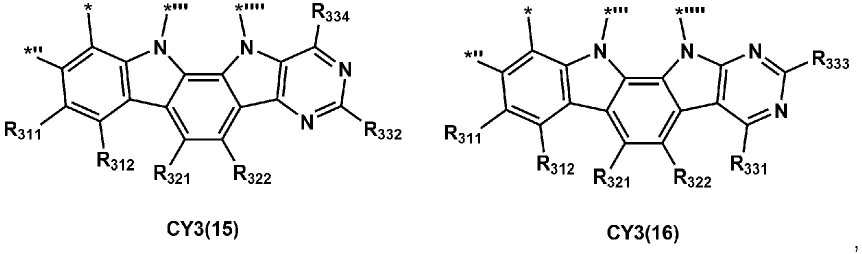 and
wherein, in Formulae CY3(1) to CY3(16),
R₃₁₁ to R₃₁₄ are each the same as defined with respect to R₃₁ in Formula 1,
R₃₂₁ to R₃₂₄ are each the same as defined with respect to R₃₂ in Formula 1,
R₃₃₁ to R₃₃₆ are each the same as defined with respect to R₃₃ in Formula 1,
* indicates a binding site to M in Formula 1,
*" indicates a binding site to L₂ in Formula 1,
*'" indicates a binding site to L₃₁ in Formula 1, and
*"" indicates a binding site to L₃₂ in Formula 1.

18. The organometallic compound of claim 11, wherein wherein, in Formula 1,
a group represented by 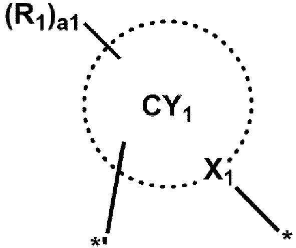 is a group represented by one selected from among Formulae CY1(1) to CY1(11),
a group represented by 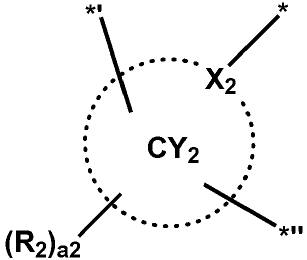 is a group represented by one selected from among Formulae CY2(1) to CY2(13), and
a group represented by 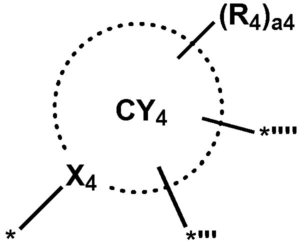 is a group represented by one selected from among Formulae CY4(1) to CY4(18): 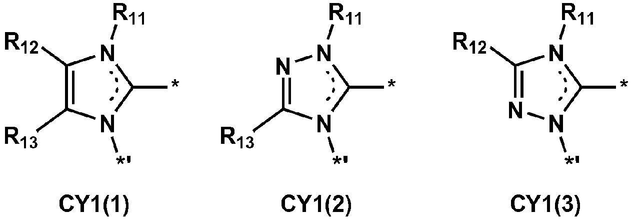 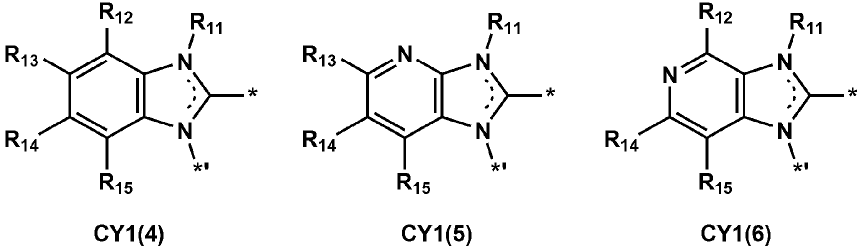 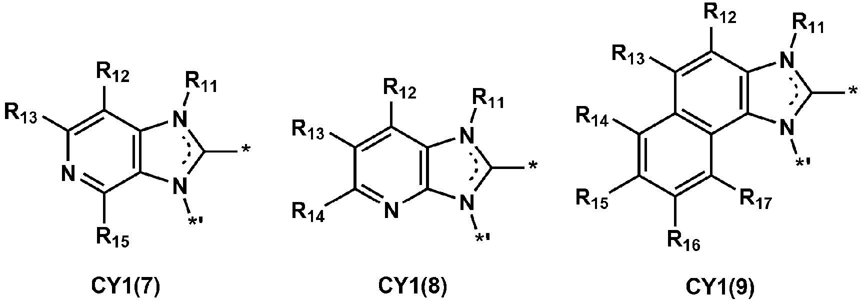 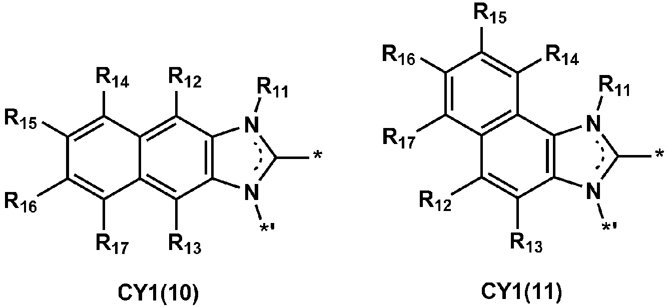 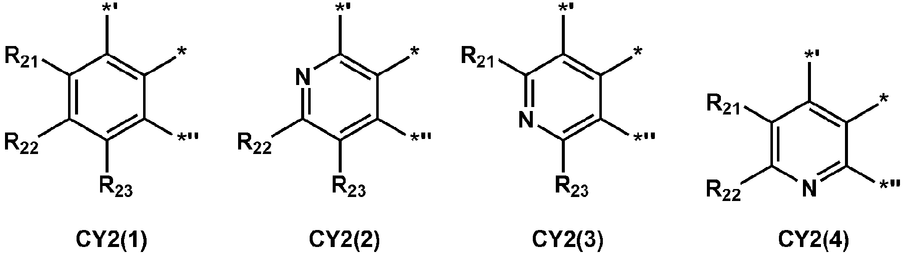 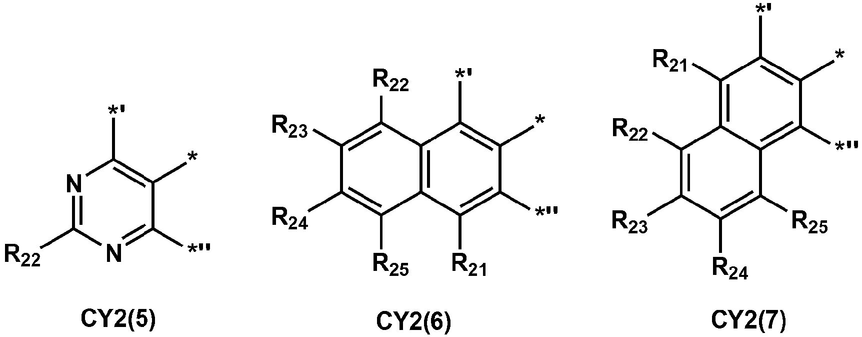 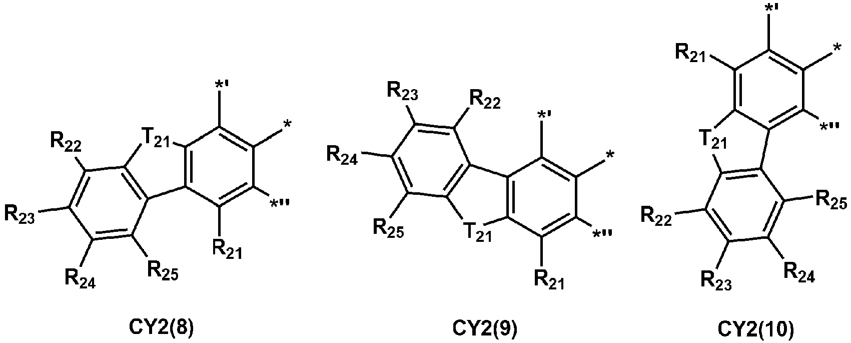 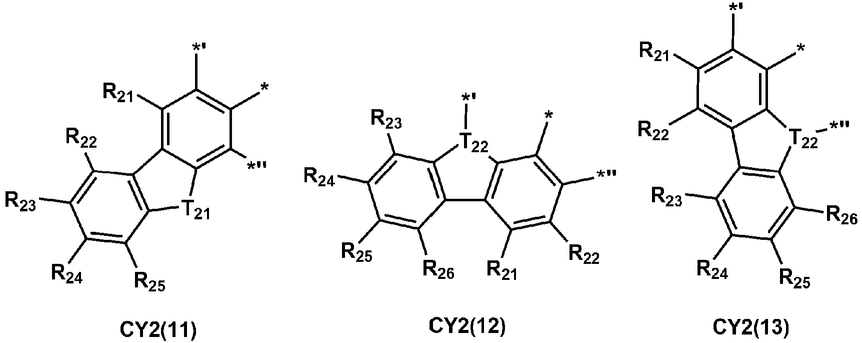 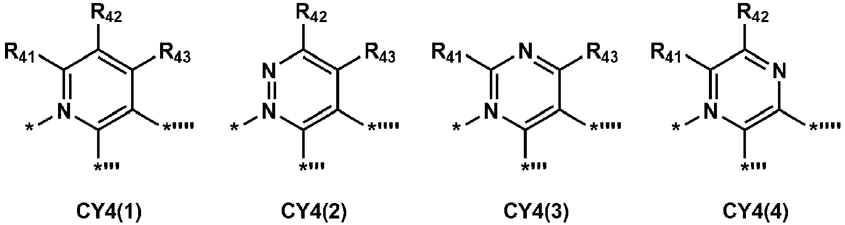 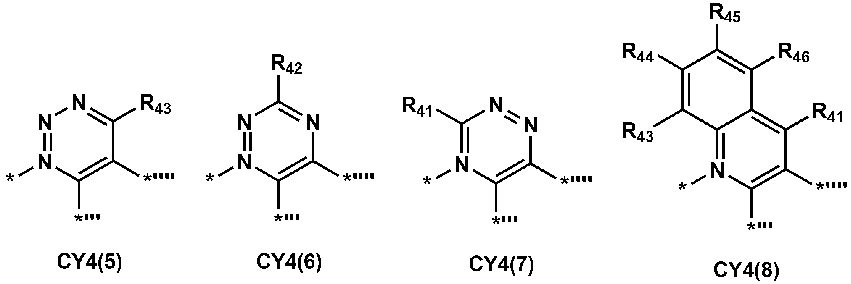 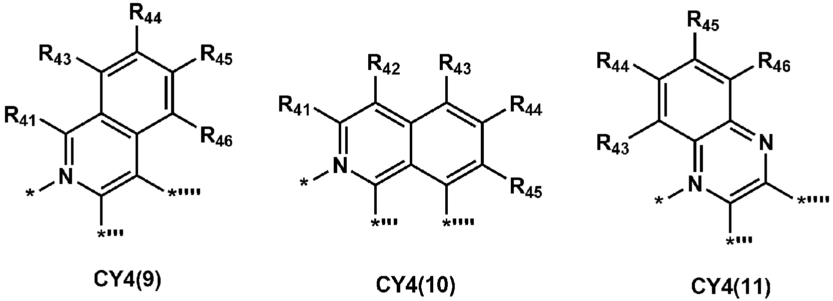 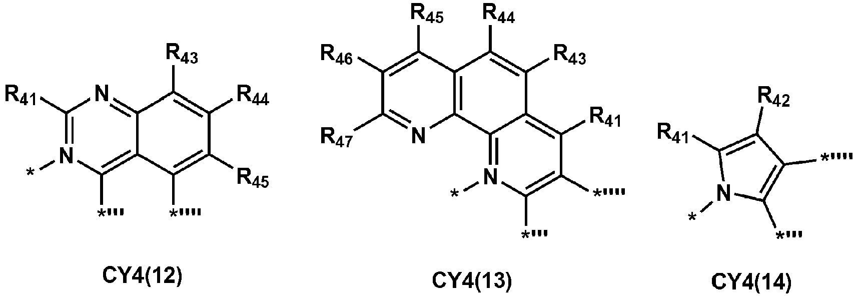 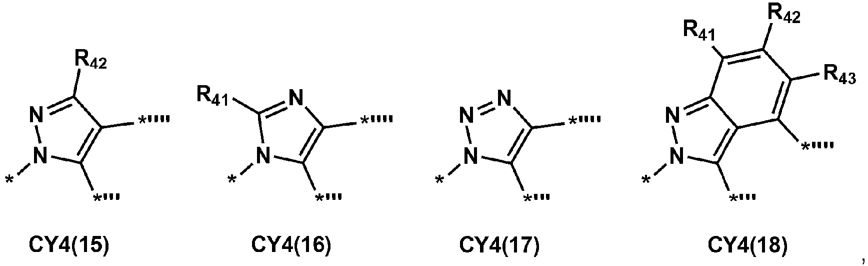 and
wherein, in Formulae CY1(1) to CY1(11), CY2(1) to CY2(13), and CY4(1) to CY4(18), T₂₁ is B(Y₂₁), C(Y₂₁)(Y₂₂), N(Y₂₁), O, S, or Si(Y₂₁)(Y₂₂),
T₂₂ is C(Y₂₁), N, or Si(Y₂₁),
R₁₁ to R₁₇ are each the same as defined with respect to R₁ in Formula 1,
R₂₁ to R₂₆, Y₂₁, and Y₂₂ are each the same as defined with respect to R₂ in Formula 1, R₄₁ to R₄₇ are each the same as defined with respect to R₄ in Formula 1,
* indicates a binding site to M in Formula 1,
*' indicates a binding site to L₁ in Formula 1,
*" indicates a binding site to L₂ in Formula 1,
*'" indicates a binding site to L₃₁ in Formula 1, and
*"" indicates a binding site to L₃₂ in Formula 1.

19. The organometallic compound of claim 11, wherein
the organometallic compound represented by Formula 1 is an organometallic compound represented by Formula 1A(1) or Formula 1A(2): 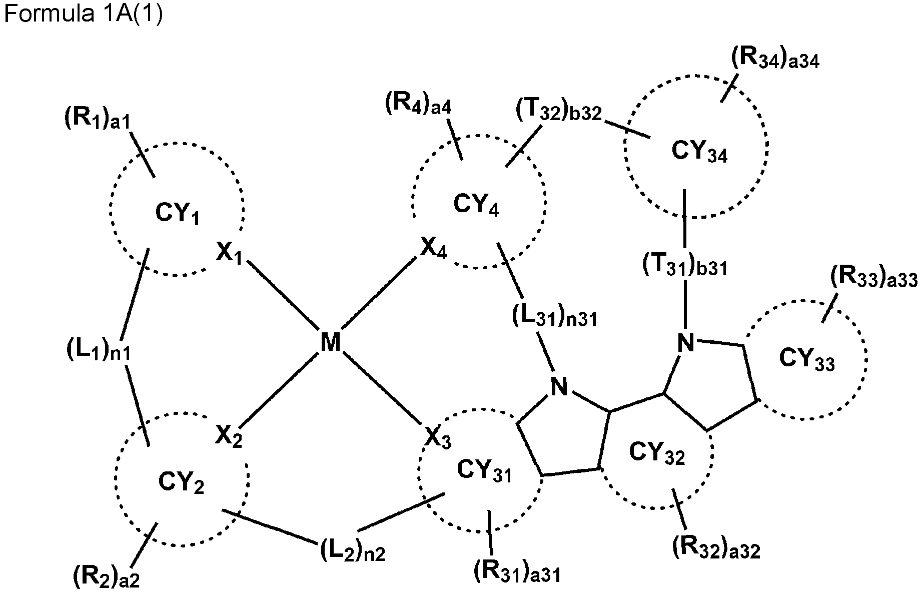 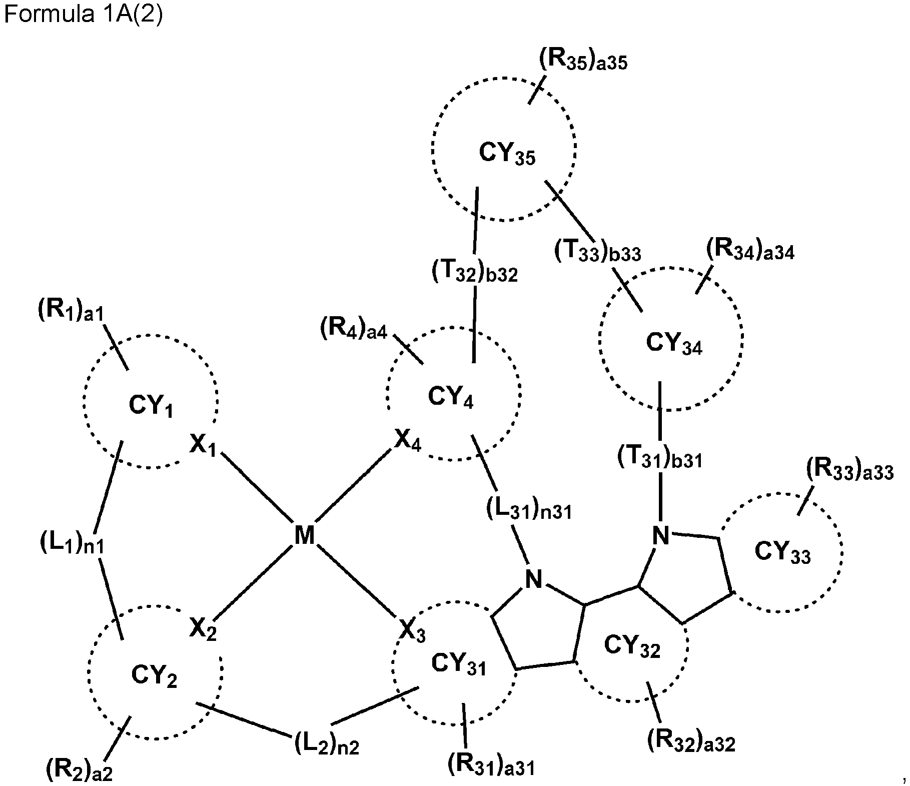 and
wherein, in Formulae 1A(1) and 1A(2),
M, X₁ to X₄, CY₁, CY₂, CY₃₁ to CY₃₃, CY₄, L₁, L₂, L₃₁, n1, n2, n31, R₁, R₂, R₃₁ to R₃₃, R₄, a1, a2, a31 to a33, and a4 are each the same as defined in Formula 1,
T₃₁ to T₃₃ are each the same as defined with respect to L₃₂ in Formula 1,
b31 to b33 are each independently an integer from 0 to 3,
ring CY₃₄ and ring CY₃₅ are each independently a C₅-C₃₀ carbocyclic group or a C₁-C₃₀ heterocyclic group,
R₃₄ and R₃₅ are each the same as defined with R₁₀ₐ in Formula 1, and
a34 and a35 are each independently an integer from 1 to 20.

20. The organometallic compound of claim 11, wherein
the organometallic compound represented by Formula 1 is an organometallic compound represented by Formula 1B(1) or Formula 1B(2): 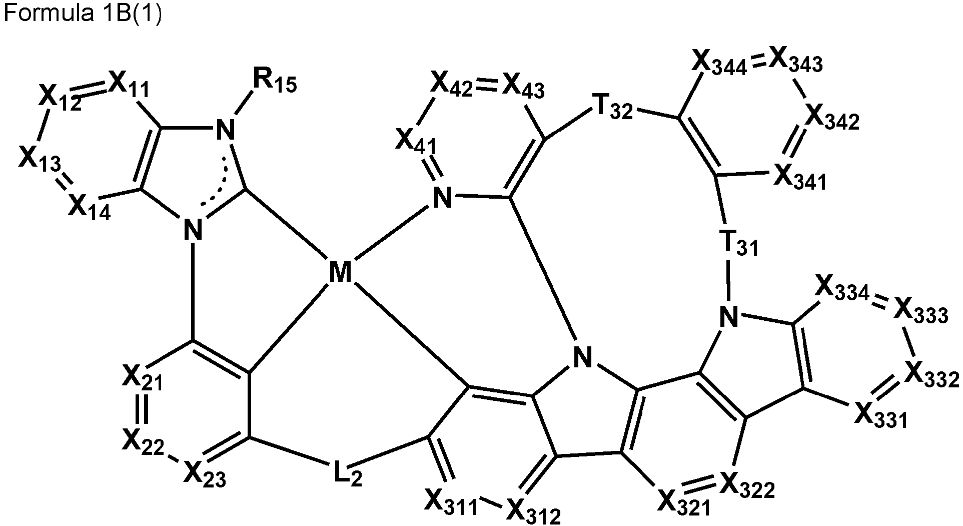 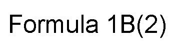 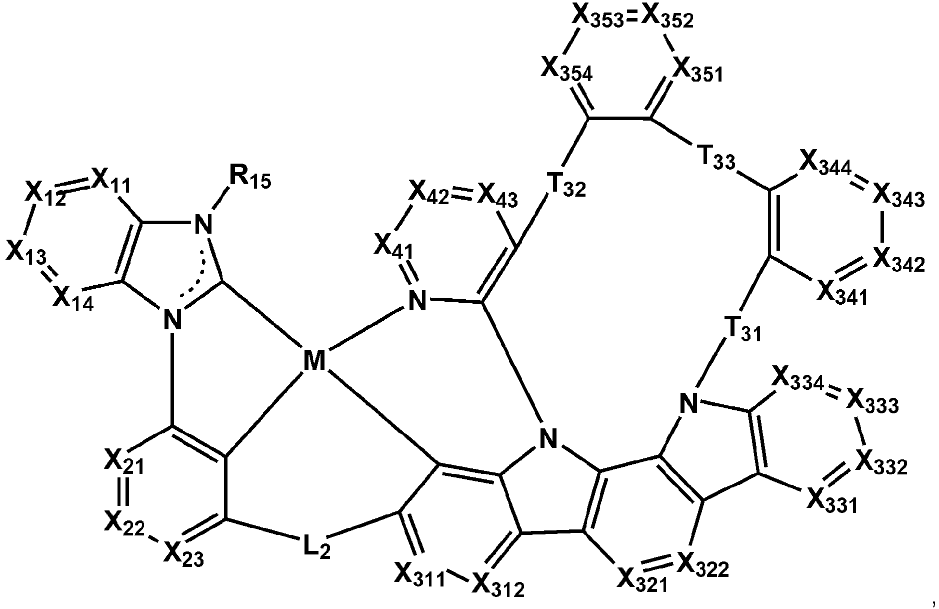 and
wherein, in Formula 1B(1) and Formula 1B(2),
M and L₂ are each the same as defined in Formula 1,
T₃₁ to T₃₃ are each the same as defined with respect to L₃₂ in Formula 1,
X₁₁ is C(R₁₁) or N, X₁₂ is C(R₁₂) or N, X₁₃ is C(R₁₃) or N, and X₁₄ is C(R₁₄) or N,
X21 is C(R₂₁) or N, X₂₂ is C(R₂₂) or N, and X₂₃ is C(R₂₃) or N,
X₃₁₁ is C(R₃₁₁) or N, X₃₁₂ is C(R₃₁₂) or N, X₃₂₁ is C(R₃₂₁) or N, X₃₂₂ is C(R₃₂₂) or N, X₃₃₁ is
C(R₃₃₁) or N, X₃₃₂ is C(R₃₃₂) or N, X₃₃₃ is C(R₃₃₃) or N, X₃₃₄ is C(R₃₃₄) or N, X₃₄₁ is
C(R₃₄₁) or N, X₃₄₂ is C(R₃₄₂) or N, X₃₄₃ is C(R₃₄₃) or N, X₃₄₄ is C(R₃₄₄) or N, X₃₅₁ is
C(R₃₅₁) or N, X₃₅₂ is C(R₃₅₂) or N, X₃₅₃ is C(R₃₅₃) or N, and X₃₅₄ is C(R₃₅₄) or N,
X41 is C(R₄₁) or N, X₄₂ is C(R₄₂) or N, and Xas is C(Ras) or N,
R₁₁ to R₁₅ are each the same as defined with respect to R₁ in Formula 1,
R₂₁ to R₂₃ are each the same as defined with respect to R₂ in Formula 1,
R₃₁₁ and R₃₁₂ are each the same as defined with respect to R₃₁ in Formula 1,
R₃₂₁ and R₃₂₂ are each the same as defined with respect to R₃₂ in Formula 1,
R₃₃₁ to R₃₃₄ are each the same as defined with respect to R₃₃ in Formula 1,
R341 to R₃₄₄, and R₃₅₁ to R₃₅₄ are each the same as defined with respect to R₁₀ₐ in Formula 1,
R₄₁ to R₄₃ are each the same as defined with respect to R₄ in Formula 1, and
two or more adjacent groups selected from among R₁₁ to R₁₅, R₂₁ to R₂₃, R₃₁₁, R₃₁₂, R₃₂₁, R₃₂₂, R₃₃₁ to R₃₃₄, R₃₄₁ to R₃₄₄, R₃₅₁ to R₃₅₄, R₄₁ to R₄₃, R₁ₐ, and R_{1b} are optionally bound to each other to form a C₃-C₆₀ carbocyclic group unsubstituted or substituted with at least one R₁₀ₐ or a C₁-C₆₀ heterocyclic group unsubstituted or substituted with at least one R₁₀ₐ.
